# EUROPEAN PATENT APPLICATION

(11) **EP 1 659 129 A1**
(43) Date of publication of application: **24.05.2006**
(21) Application number: 04772383.8
(22) Date of filing: 23.08.2004
(51) Int. Cl.: C07F 15/00, C07D 213/16, C07D 213/38, C07D 401/10, C07D 401/14, C08F 212/32, C08F 226/06, C08G 61/12, C09K 11/06, H05B 33/14, H05B 33/22

(54) **COORDINATION METAL COMPOUND, MATERIAL FOR ORGANIC ELECTROLUMINESCENCE DEVICE, MATERIAL FOR LUMINESCENT COATING FORMATION AND ORGANIC ELECTROLUMINESCENCE DEVICE**

(30) Priority: 26.08.2003 JP 2003301232; 21.04.2004 JP 2004125898
(71) Applicant: IDEMITSU KOSAN CO., LTD., Tokyo 100-8321 (JP)
(72) Inventor: INOUE, Tetsuya, 2990293 (JP); ITO, Mitsunori, 2990293 (JP); IKEDA, Hidetsugu, 2990293 (JP); IWAKUMA, Toshihiro, 2990293 (JP); HOSOKAWA, Chishio, 2990293 (JP)
(74) Representative: Gille Hrabal Struck Neidlein Prop Roos
(86) International application number: PCT/JP2004/012427
(87) International publication number: WO 2005/033118

(57) **Abstract**

A coordination metal compound comprising cordinating at least one ligand having a spiro bond to at least a metal atom; a material for an organic electroluminescence (EL) device, and an organic EL device comprising at least one organic thin film layer sandwiched between a pair of electrodes consisting of an anode and a cathode, wherein at least one organic thin film layer thereof comprises the coordination metal compound or the material for an organic EL device, and a material for luminescence coating formation comprising an organic solvent solution containing the coordination metal compound or the material for the organic EL device is provided. Further, the organic EL device employing either the material for luminescence coating formation or the material for the organic EL device, which exhibits an enhanced efficiency of light emission and is superior in heat resistance, the coordination metal compound having excellent solubility for an organic solvent which realizes the aforementioned, the material for the organic EL device and the material for luminescence coating formation are provided.

## Description

### TECHNICAL FIELD

The present invention relates to a coordination metal compound, a material for an organic electroluminescence device, a material for luminescent coating formation and an organic electroluminescence device. The present invention relates, in particular, to an organic electroluminescence device having a great efficiency of light emission and significant storage stability at elevated temperature, a coordination metal compound which realizes the aforementioned, has excellent solubility in an organic solvent and can be applied to an organic electroluminescence device by using a simple wet film forming process as well as a vacuum deposition process, a material for an organic electroluminescence device and a material for luminescent coating formation.

### BACKGROUND ART

An organic electroluminescence ("electroluminescence" will be occasionally referred to as "EL", hereinafter) device is a spontaneous light emitting device which utilizes the principle that a fluorescent substance emits light by energy of recombination of holes injected from an anode and electrons injected from a cathode when an electric field is applied. Since an organic EL device of the laminate type driven under a low electric voltage was reported by C. W. Tang et al. of Eastman Kodak Company (C. W. Tang and S. A. Vanslyke, Applied Physics Letters, Volume 51, Pages 913, 1987), many studies have been conducted on organic EL devices using organic materials as the constituting materials. Tang et al. used a laminate structure using tris(8-hydroxyquinolinol aluminum) for the light emitting layer and a triphenyldiamine derivative for the hole transporting layer. Advantages of the laminate structure are that the efficiency of hole injection into the light emitting layer can be increased, that the efficiency of forming excited particles which are formed by blocking and recombining electrons injected from the cathode can be increased, and that excited particles formed among the light emitting layer can be enclosed. As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.

As the light emitting material of the organic EL device, chelate complexes such as tris(8-quinolinolato)aluminum, coumarine derivatives, tetraphenylbutadiene derivatives, bisstyrylarylene derivatives and oxadiazole derivatives are known. It is reported that light in the visible region ranging from blue light to red light can be obtained by using these light emitting materials, and development of a device exhibiting color images is expected (refer to, for example, Japanese Patent Application Laid-Open Nos. Heisei 8(1996)-239655, Heisei 7(1995)-138561 and Heisei 3(1991)-200289).

In addition, it has been recently proposed that an organic phosphorescent material is applied to a light emitting layer besides a light emitting material (refer to, for example, D. F. O'Brien and M. A. Baldo et al "Improved energy transferring electro phosphorescent devices" Applied Physics letters Vol. 74 No.3, pp442-444, January 18, 1999 : M. A. Baldo et al "Very high- efficiency green organic light-emitting devices based on electro phosphorescence" Applied Physics letters Vol.75 No.1, pp4-6, July 5, 1999).

A great efficiency of light emission has been achieved by utilizing a singlet state and a triplet state of the organic phosphorescent materials in a light emitting layer of an organic EL device. Since it has been considered that singlet exciton and triplet exciton are formed at a ratio between the two of 1 to 3 due to difference of spin multiplicity thereof on recombination of electrons and holes in an organic EL device, it should be understood that three to four times higher efficiency of light emission can be achieved by utilizing an phosphorescent light emitting material than by utilizing only a fluorescent light emitting material.

In the above organic EL devices, in order for triplet excited state or excitons in triplet state not to diminish, a construction comprised by laminating sequentially an anode, a hole transporting layer, an organic light emitting layer, an electron transporting layer (a hole blocking layer), an electron injecting layer, a cathode and so forth has been employed and a host compound, and a phosphorescent compound have been employed as an organic light emitting layer (refer to, for examples, U. S. Patent No. 6,097,147 and International PCT Publication NO. WO 01/41512). In the patent literatures, N,N'-dicarbazole-biphenyl has been employed as a host compound. However, it is easily crystallized because of its glass transition temperature of 110°C or less and also because of its excessively good symmetric property. In addition, there is a problem of resulting in short circuit or pixel deficiency thereof on a heat resistant test of a device.

Further, crystal growth occurred at a place where there are foreign materials or a raised portion of a electrode, therefore more deficiencies after the heat resistant test have been found than those before the test. In addition, a carbazole derivative having tri-symmetry has been employed as a host material. However, due to its good symmetric property, crystal growth was occurred at a place where there are foreign materials or a raised portion of a electrode on vapor deposition, therefore, it has not been freed from causing more deficiencies than those existed in the initial stage before the heat resistant test.

An iridium complex has been generally employed as a phosphorescent compound and a light emitting layer has been formed from a mixture comprised a host compound containing a certain part (a few % by mass or less) of an iridium complex. Generally, the higher content of a phosphorescent compound to a host compound tends to the higher luminescence intensity, however, in the case of a few % to several dozen % thereof, the luminescence intensity decreases and also luminance of emitted light of the device decreases due to imbalance between them. It has been known as concentration quenching or concentration deactivation as described in Japanese Unexamined Patent Application Laid-Open No. Heisei 05 (1993)-078655; Japanese Unexamined Patent Application Laid-Open No. Heisei 05 (1993)-320633. The above has been considered to be related to non-irradiative transition caused by multimerization reaction between materials for luminescence center or with a neighboring material thereof. With this view, it has been not possible to use plenty of a phosphorescent compound for promoting the efficiency thereof; therefore, optimization of the concentration has been required.

Recently, the research progress of improvement on phosphorescent compounds has resulted in providing a phosphorescent compound to be employed for a wet film forming process which has been a simple and easy way of fabricating a device (refer to, Shao-An Chen et al, "High-Efficiency Red-Light Emission from Polyfuluorenes Grafted with Cyclometalated Iridium Complexes and Charge Transport Moiety ", J. Am. Chem. Soc., Vol. 125, pp636-637, 2003; and U. S. Laid-Open Patent Publication No. 2003-0091862A1). However, the current materials show low luminance of light emission, and stability of devices employed the materials under elevated temperature is poor; therefore they are of little practical use.

### DISCLOSURE OF THE INVENTION

The present invention has been made to overcome the above problems and has an object of providing an organic EL device having a great luminance of emitted light and great storage stability under high temperature. The present invention also has an objective of providing a coordination metal compound having favorable solubility to organic solvents, a material for the organic EL device and a material for luminescent coating formation for realizing the organic EL device.

As a result of intensive researches and studies to achieve the above objectives by the present inventors, it was found that employing a coordination metal compound containing a spiro bond as an light emitting material enables to provide an organic electroluminescence device having a great luminance of emitted light and great storage stability under elevated temperature because of the controlled association between the molecules. Such being the case, the present invention has been accomplished on the basis of the foregoing findings and information. In addition, the coordination metal complexes show excellent solubility for an organic solvent so that it is possible to apply them to a wet film forming process such as a spin coating process.

Namely, the present invention provides a coordination metal complex comprising a metal atom coordinated with at least a ligand having a spiro bond. Here, "coordination" means to form a coordination bond between a lone pair of a hetero atom of a ligand and a metal atom while forming a carbon atom-a metal atom bond between a ligand and a metal atom.

Further, the present invention provides a material for an organic EL device, which comprises at least one compound selected from the compounds represented by the general formula (1'): 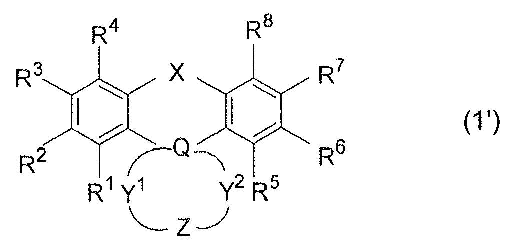 wherein X, Y¹ and Y² each independently represents a single bond, -CR'R"-, -SiR'R"-, -CO- or -NR'-; **Q** represents a carbon atom, a silicon atom or a germanium atom; **Z** represents a divalent group comprising a heavy metal complex; **R'** and **R"** each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms; R¹ to R⁸ each independently represents a hydrogen atom or a group selected from among a substituted or unsubstituted alkyl group having 1 to 50 carbon atoms, a substituted or unsubstituted alkenyl group having 1 to 50 carbon atoms, a substituted or unsubstituted alkynyl group having 1 to 50 carbon atoms, a substituted or unsubstituted alkoxy group having 1 to 50 carbon atoms, a substituted or unsubstituted alkylthio group having 1 to 50 carbon atoms, a substituted or unsubstituted amino group having 1 to 50 carbon atoms, a substituted or unsubstituted alkylamino group having 1 to 50 carbon atoms, a substituted or unsubstituted dialkylamino group having 1 to 50 carbon atoms or a substituted or unsubstituted heterocyclic group having 1 to 50 carbon atoms, and an aryl group having 6 to 50 carbon atoms, an aryloxy group having 6 to 50 carbon atoms, an arylthio group having 6 to 50 carbon atoms, an arylamono group having 6 to 50 carbon atoms, a diarylamino group having 6 to 50 carbon atoms or an alkylarylamino group having 6 to 50 carbon atoms; in addition, two neighboring groups among R¹ to R⁸ may bond each other to form a ring structure; a material for an organic EL device represents by the general formula (4'):

(E₁)-(C¹)ₚ₁-(C²)ₚ₂-(Phos)-(C³)ₚ₃-(C⁴)ₚ₄-(E²) (4')

wherein (Phos) represents a divalent group formed by removing two from among R¹ to R⁸; E¹ to E² each independently represents a hydrogen atom, or a group selected from among a substituted or unsubstituted aromatic group having 6 to 50 ring carbon atoms, a substituted or unsubstituted aromatic heterocyclic group having 5 to 50 ring atom, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group and a hydroxyl group; C¹ to C⁴ each independently represents a group selected from a substituted or unsubstituted alkylene group having 1 to 50 carbon atoms and a substituted or unsubstituted divalent aryl group having 6 to 50 carbon atoms; p1 to p4 each independently represents an integer of from 0 to 20;
a material for an organic EL device which comprises a polymer obtained by polymerization or co-polymerization of a compound represented by the general formula (1'), of which at least one of among R¹ to R⁸ represents a polymerizable group or an aromatic group having 6 to 50 ring carbon atoms posessing a polymerizable group, and
a material for an organic EL device which comprises a polymer or a copolymer comprising a unit structure of a divalent group formed by removing two selected from among R¹ to R⁸ in the general formula (1').

Further, the present invention provides an organic EL device comprising at least one organic thin film layers including a light emitting layer sandwiched between a pair of electrodes consisting of an anode and a cathode, wherein at least one of the organic thin film layers comprises the coordination metal compound or the material for the organic EL device.

Moreover, the present invention provides a material for luminescent coating formation comprising an organic solvent solution containing the coordination metal compound or the material for the organic EL device, and also an organic EL device fabricated by using the material for luminescent coating formation or the material for the organic EL device.

### THE PREFERRED EMBODIMENT TO CARRY OUT THE INVENTION

Firstly, a coordination metal compound of the present invention will be explained below.

The coordination metal compound means a coordination metal compound formed by coordinating at least one ligand having a spiro bond and any one of the compounds represented by the general formula (1) is preferred.

(L₁)x-M-(P-M)y-(L₂)z (1)

In the general formula (1), L₁ represents a ligand coordinating to a metal atom M and having a spiro bond.

Further, it is preferable that L₁ in the general formula (1) is a ligand represented by a following general formula (2):

A-(C)ₚ-(B)_{q}-(C)ₚ-D- (2)

To begin with, A in the general formula (2) will be explained below:

In the general formula (2), A represents a group expressed by following general formulae (3) to (12):

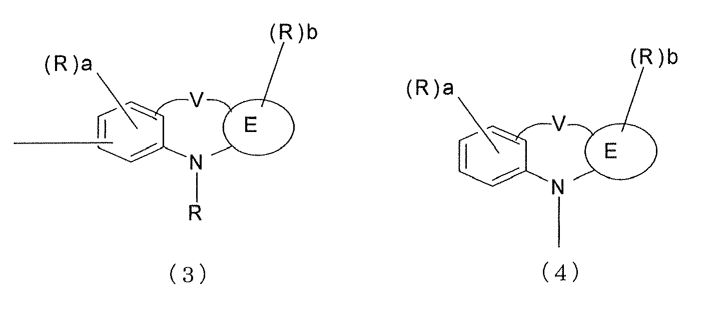

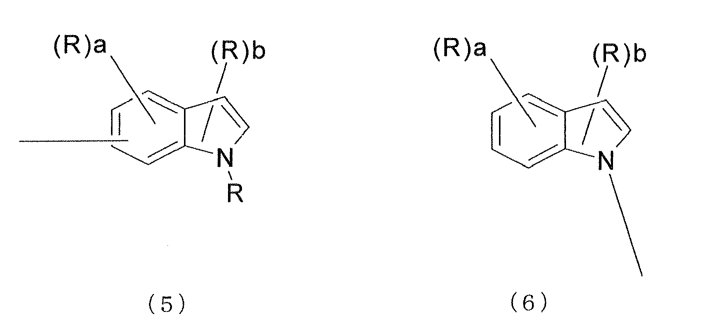

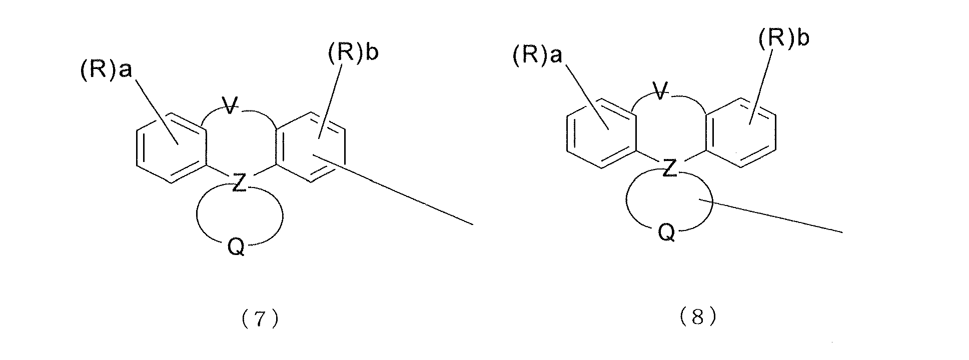

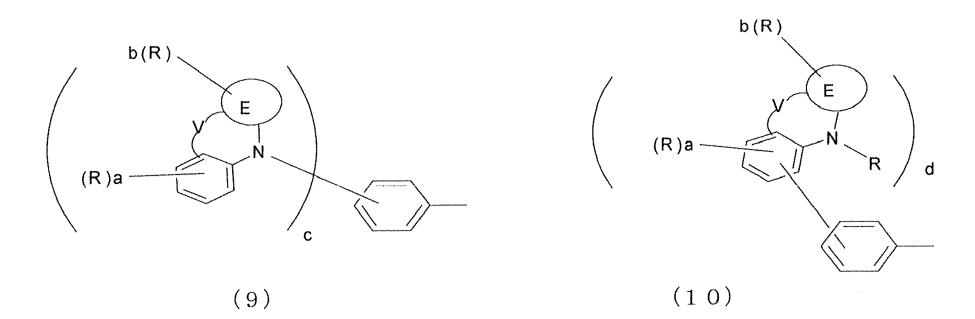

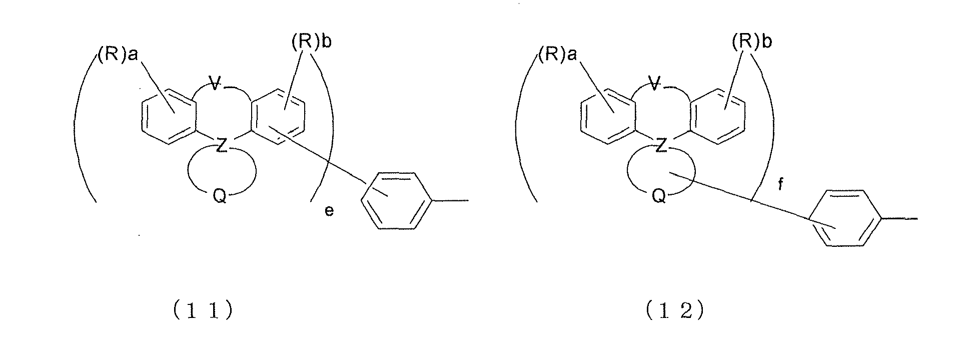

In the general formulae (3) to (12), **R** independently represents a substituted or unsubstituted aromatic group having 6 to 50 ring carbon atoms, a substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group or a hydroxyl group; R may bond each other to form a ring structure.

In the general formulae (3) to (12), **a** and **b** each independently represents an integer of from 0 to 4; **c, d, e** and **f** each independently represents an integer of from 2 to 4.

Examples of the substituted or unsubstituted aromatic group having 6 to 50 ring carbon atoms represented by **R** include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenyl-yl group, 4"-t- butyl-p-terphenyl-4-yl group and the like.

Examples of the substituted or unsubstituted aromatic heterocyclic group having 5 to 50 ring atoms represented by **R** include 1-pyrrolyl group, 2-pyrrolyl group, 3-pyrrolyl group, pyradinyl group, pyrimidyl group, pyridazyl group, 2-pyridinyl group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrohn-2-yl group, 1,8-phenanthrohn-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrohn-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methyl- pyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl- 3-indolyl group and 4-t-butyl-3-indolyl group and the like.

Examples of the substituted or unsubstituted alkyl group having 1 to 50 carbon atoms represented by **R** include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy- isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyano-propyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamanthyl group, 2-adamanthyl group, 1-norbornyl group, 2-norbornyl group and the like.

The substituted or unsubstituted alkoxyl group having 1 to 50 carbon atoms represented by **R** is a group expressed by -OY. Examples of the group represented by **Y** include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy- t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1.,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitro- ethyl group, 1,3-dinitroisopropyl group, 2,3-dinitro-t-butyl group, 1,2,3-trinitropropyl group and the like.

Examples of the substituted or unsubstituted aralkyl group having 7 to 50 carbon atoms represented by **R** include benzyl group, 1-phenylethyl group, 2-phenylethyl group, 1-phenyl-isopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, 1-chloro-2-phenylisopropyl group and the like.

The substituted or unsubstituted aryloxyl group having 5 to 50 ring atoms represented by **R** is a group expressed by -OY'. Examples of the group represented by Y' include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrohn-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methyl- pyrrol-5-yl group, 3-methylpyrrol-1-yl group, 3-methyl- pyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group and the like.

The substituted or unsubstituted arylthio group having 5 to 50 ring atoms represented by R is a group expressed by -SY' and examples of Y' include the same as aforementioned.

The substituted or unsubstituted alkoxycarbonyl group having 1 to 50 ring carbon atoms represented by R is a group expressed by -COOY and examples of Y include the same as aforementioned.

In the general formula (3) to (12), V represents a single bond, -CR₀R₀'-, -SiR₀R₀'-, -O-, -CO- or -NR₀ wherein R₀ and R₀' each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms. Specific examples of the above aromatic hydrocarbon group, the above aromatic heterocyclic group and the above alkyl group include the same as those of aforementioned about **R.**

In the general formula (3) to (12), E represents a ring structure shown by a circle enclosing the symbol **E,** and a substituted or unsubstituted cycloalkane moiety having 3 to 6 ring carbon atoms, whose carbon atom may be substituted by a nitrogen atom, a substituted or unsubstituted aromatic hydrocarbon moiety having 4 to 6 ring carbon atoms, or a substituted or unsubstituted aromatic heterocyclic moiety having 4 to 6 ring atoms.

Specific examples of the aromatic hydrocarbon moiety and the aromatic heterocyclic moiety include a divalent moiety having suitable carbon numbers selected from among the groups of aforementioned about **R.** In addition, examples of the cycloalkane moiety having 3 to 6 ring carbon atoms, whose carbon atom may be substituted by a nitrogen atom include a divalent moiety such as cyclopropane, cyclobutane, cyclopentane, cyclohexane, cycloheptane, pyrrolidine, piperidine, piperazine and so forth.

In the general formula (3) to (12), **Q** represents an atomic group forming a ring structure and examples include an alkylene group such as an ethylene group, a propylene group, n-butylene group, n-pentylene group and n-hexylene, a group forming a heterocyclic ring by substituting a nitrogen atom or an oxygen atom for at least one carbon atom of these alkylene groups and so forth; these groups each may has a substituent, and also a saturated or an unsaturated ring may be formed by bonding the groups each other.

In the general formulae (3) to (12), Z represents -CR₀R₀'-, -SiR₀R₀'-, or -GeR₀R₀'-; Ge means a germanium atom, and R₀ and R₀' represent the same as aforementioned.

It is preferable that the general formula (3) is any one group expressed by following general formulae (22) to (25).

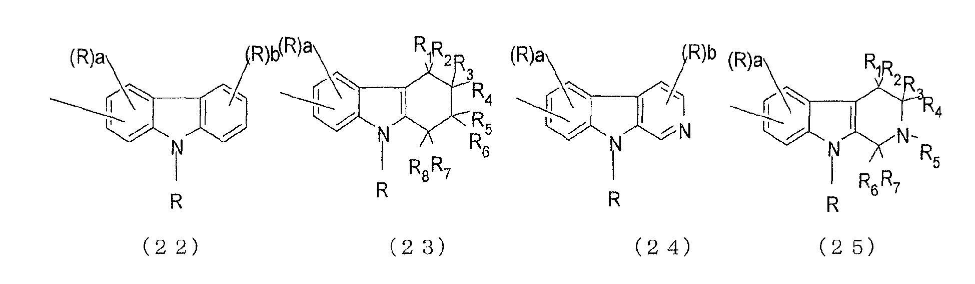

In the general formulae (22) to (25), **R, a** and **b** each independently represents the same as aforementioned, and R₁ to R₈ each independently represents the same as aforementioned about **R.**

Further, examples of the group expressed by the general formulae (22) to (25) are shown as follows, but not limited thereto.

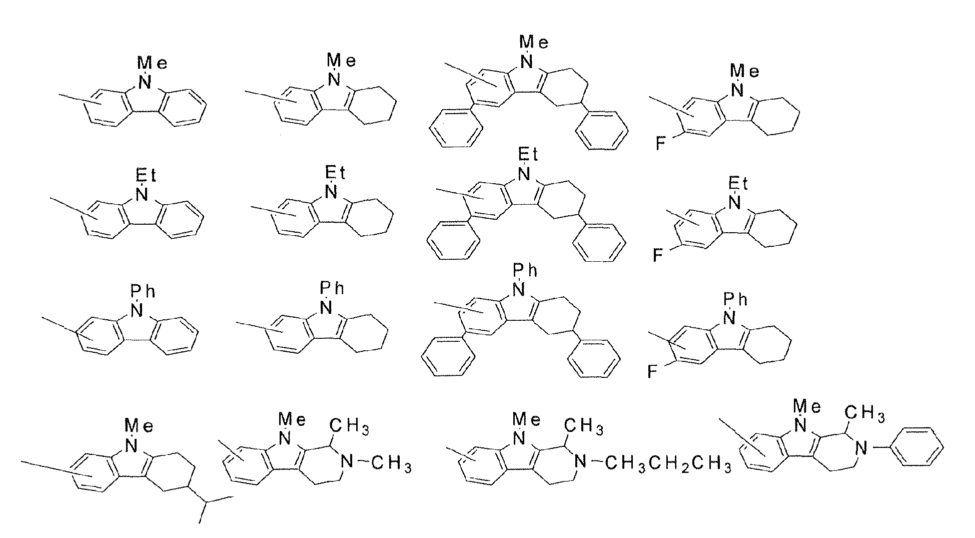

It is preferable that the general formula (4) is any one group expressed by following general formulae (26) to (29).

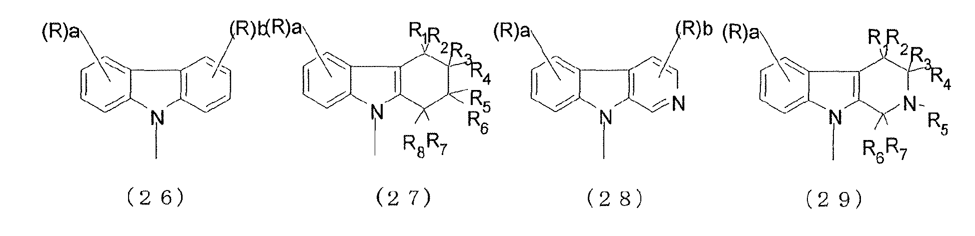

In the general formulae (26) to (29), **R, a** and **b** each independently represents the same as aforementioned, and R₁ to R₈ each independently represents the same as aforementioned about **R.**

Further, examples of the group expressed by the general formulae (26) to (29) are shown as follows, but not limited thereto.

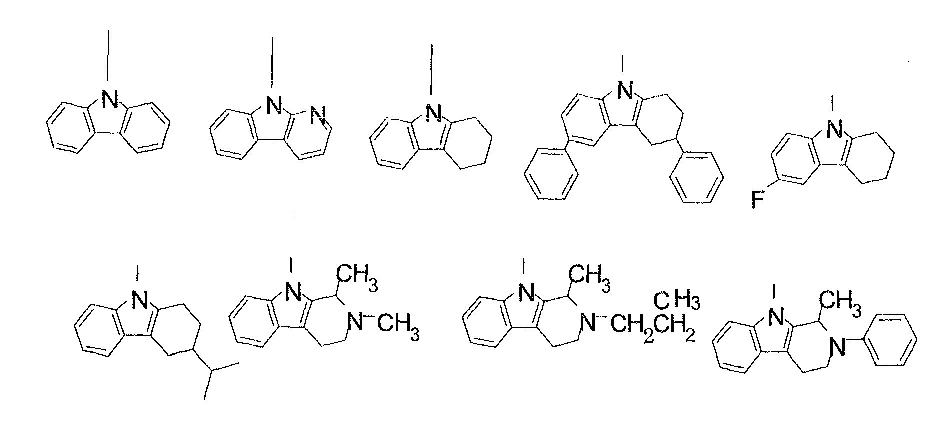

Examples of the group expressed by the general formula (5) are shown as follows, but not limited thereto.

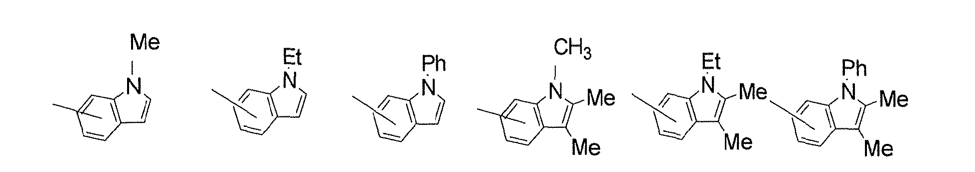

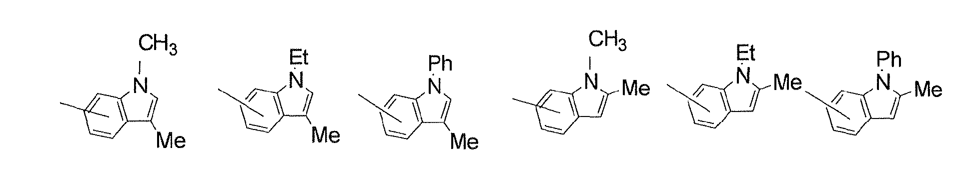

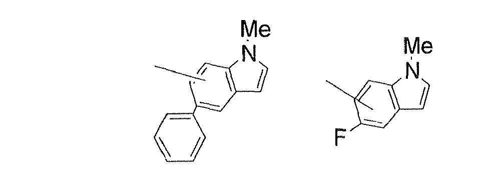

Examples of the group expressed by the general formula (6) are shown as follows, but not limited thereto.

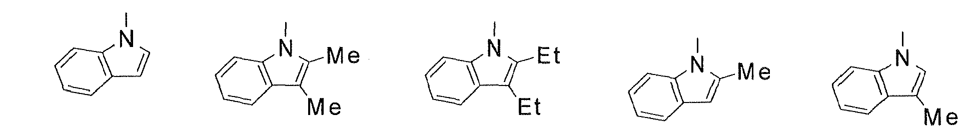

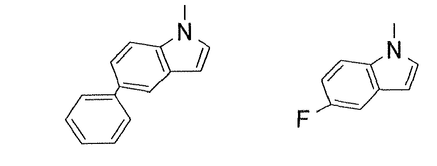

It is preferable that the general formula (7) specifically coincides with a following general formula (30).

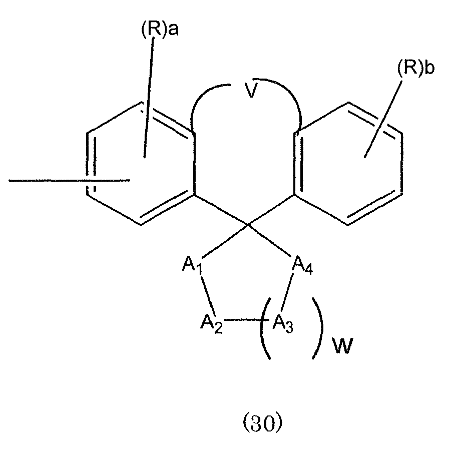

In the general formula (30), **R, V,** a and **b** each independently represents the same as aforementioned. A₁ to A₄ each independently represents **-R'R"-, -SiR'R"-, -O-, -NR'-, -CO-;** wherein, **R'** and **R"** each represents the same as R aforementioned, and R' and R" are the same with or different from each other. In addition, at least two neighboring groups among A₁ to A₄ are expressed by **―CR'R"―;** and the neighboring **R's,** the neighboring **R"s** or both **R'** and **R"** may saturatedly or unsaturatedly bond resultantly forming a ring structure having 4 to 50 carbon atoms; **w** represents an integer of from 1 to 10.

In addition, examples of the group expressed by the general formula (30) are shown as follows, but not limited thereto.

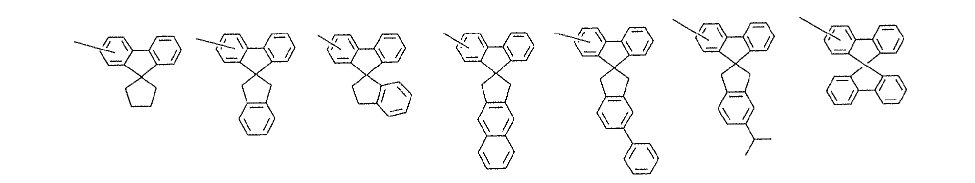

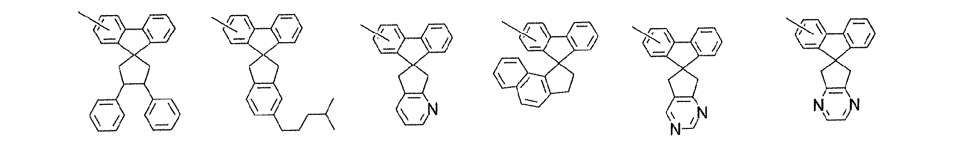

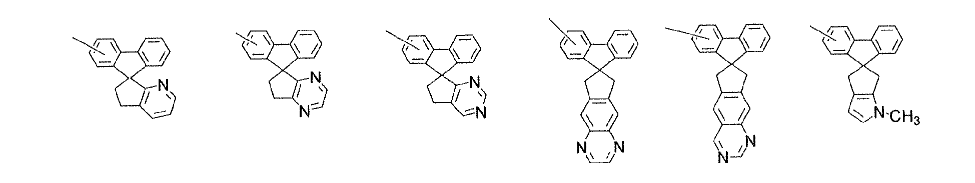

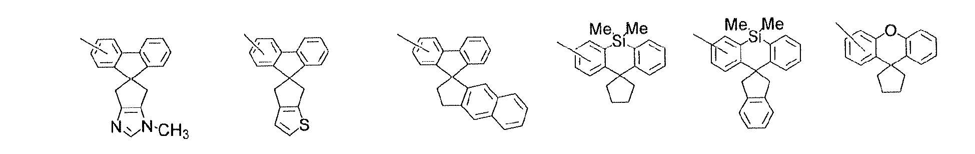

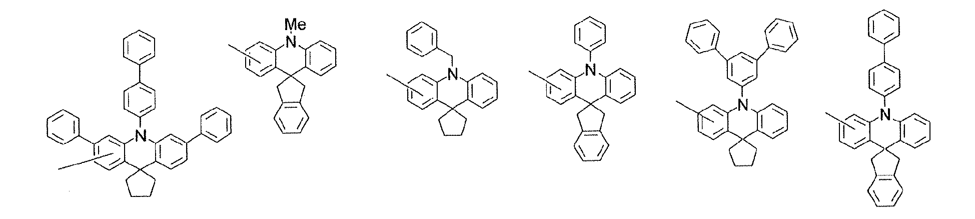

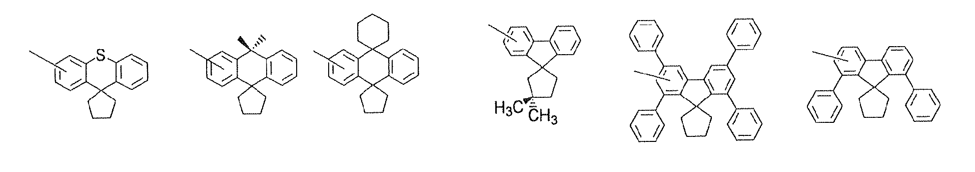

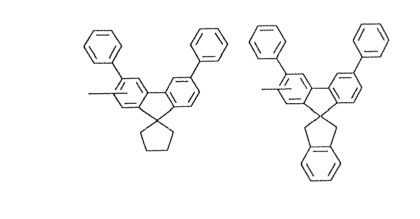

It is preferable that the general formula (8) specifically coincides with a following general formula (31).

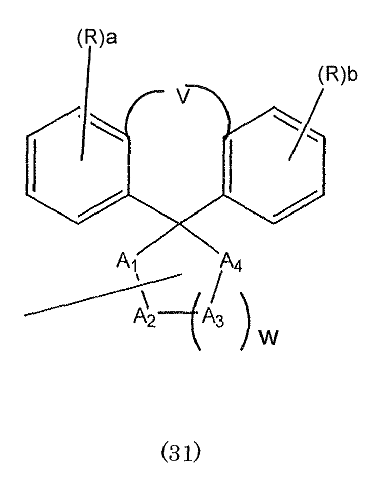

In the general formula (31), **R, V, a, b,** A₁ to A₄ and **w** each independently represents the same as aforementioned.

In addition, examples of the group expressed by the general formula (31) are shown as follows, but not limited thereto.

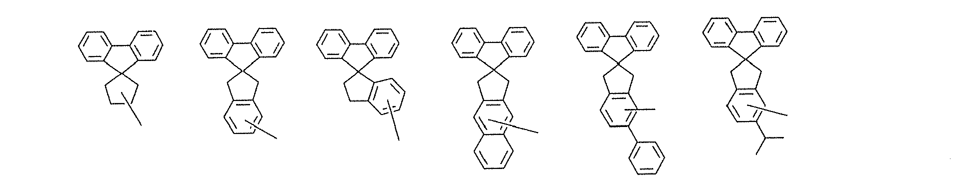

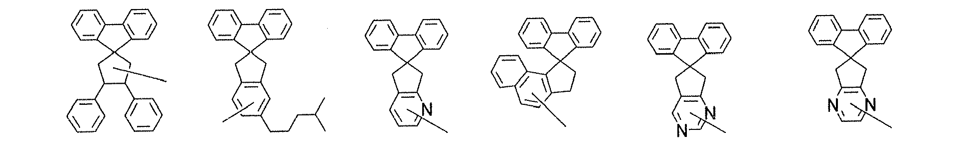

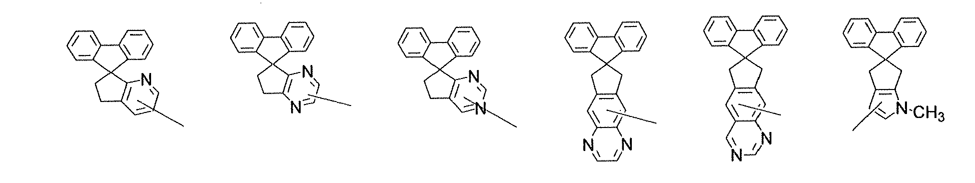

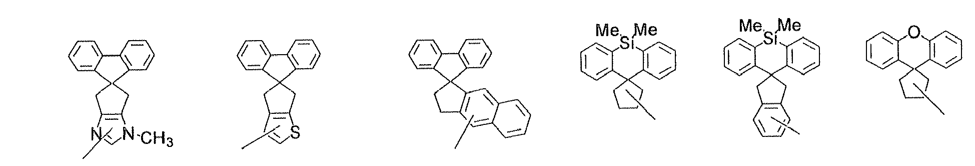

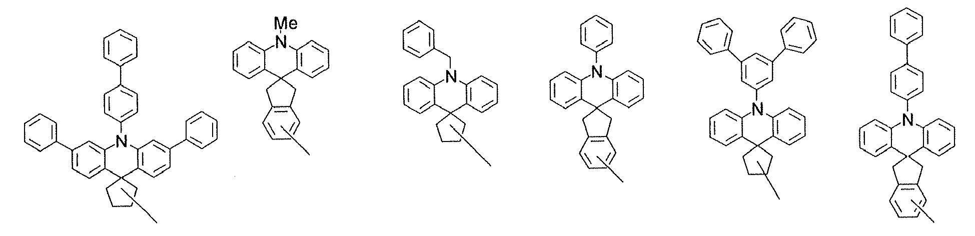

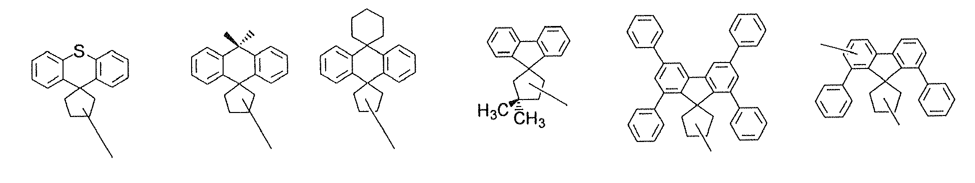

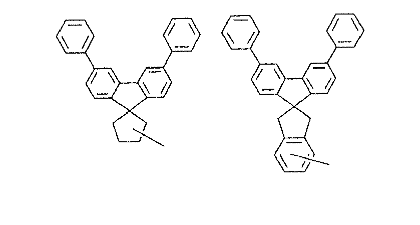

It is preferable that the general formula (9) specifically coincides with any one group expressed by following general formulae (32) to (35).

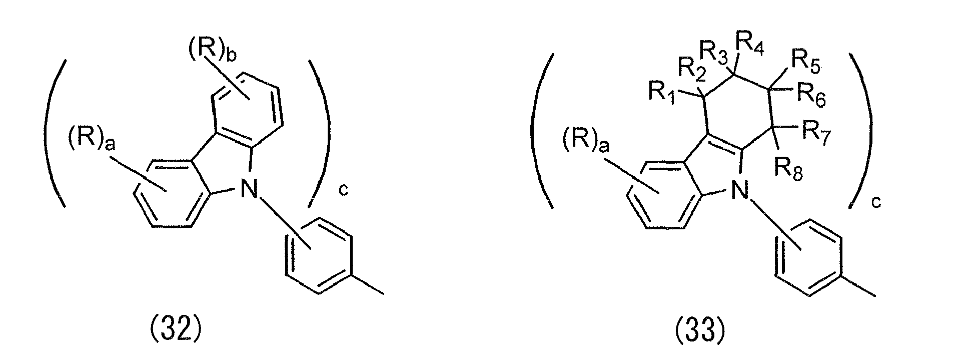

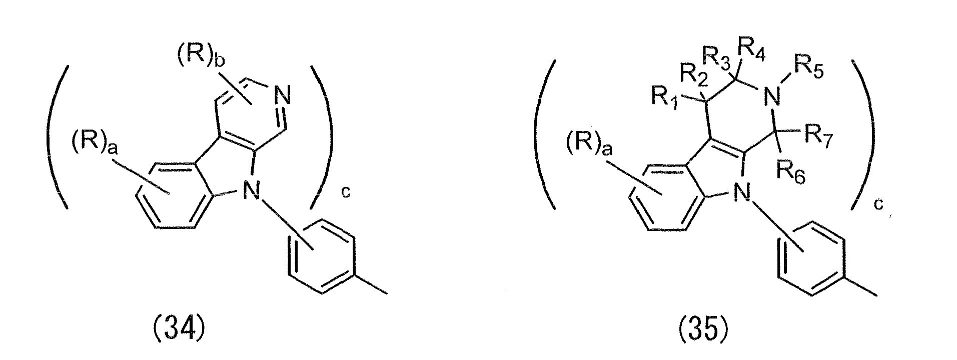

In the general formulae (32) to (35), **R, a, b** and **c** each independently represents the same as aforementioned, and R₁ to R₈ each independently represents the same as aforementioned about **R.**

In addition, examples for a group of the general formulae (32) to (35) are shown as follows, but not limited thereto.

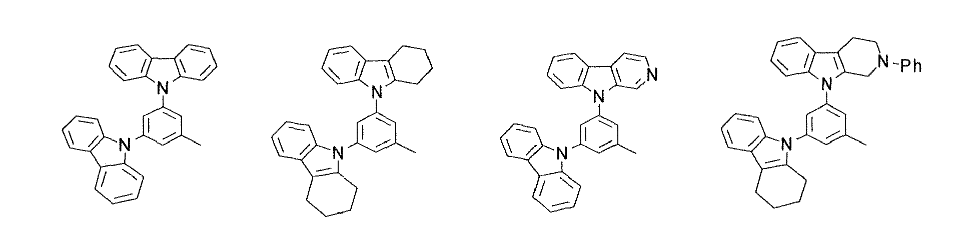

It is preferable that the general formula (10) specifically coincides with any one group expressed by following general formulae (36) to (39).

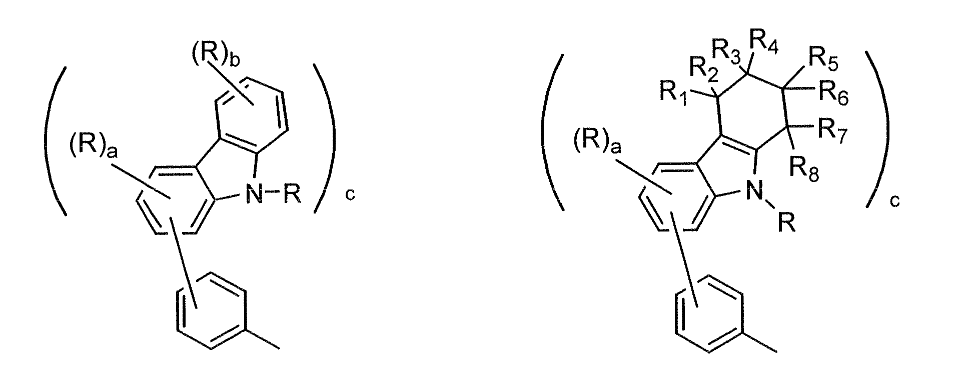

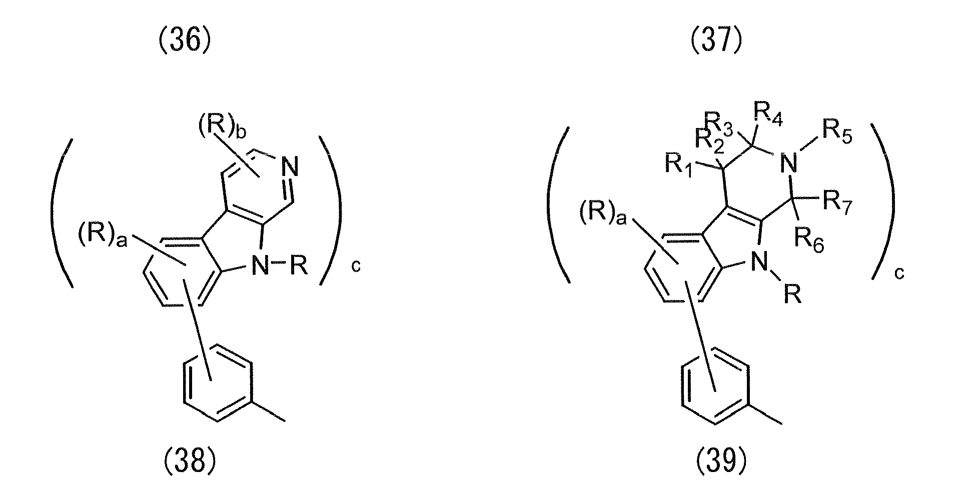

In the general formulae (36) to (39), **R, a, b** and **c** each independently represents the same as aforementioned, and R₁ to R₈ each independently represents the same as aforementioned about **R.**

In addition, examples for a group of the general formulae (36) to (39) are shown as follows, but not limited thereto.

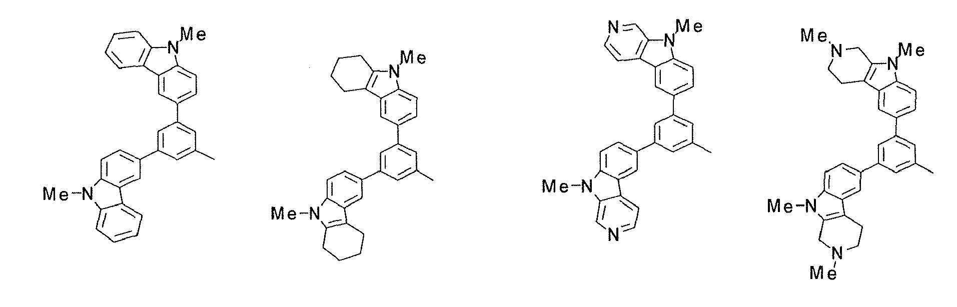

It is preferable that the general formula (11) specifically coincides with a following general formula (40):

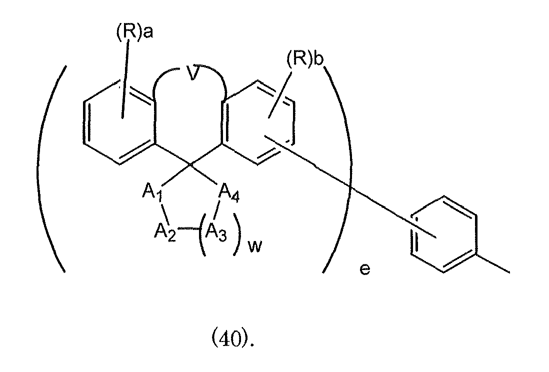

In the general formula (40), **R, V, a, b,** A ₁ to A₄, **w** and e each independently represents the same as aforementioned.

In addition, examples for a group of the general formula (40) are shown as follows, but not limited thereto.

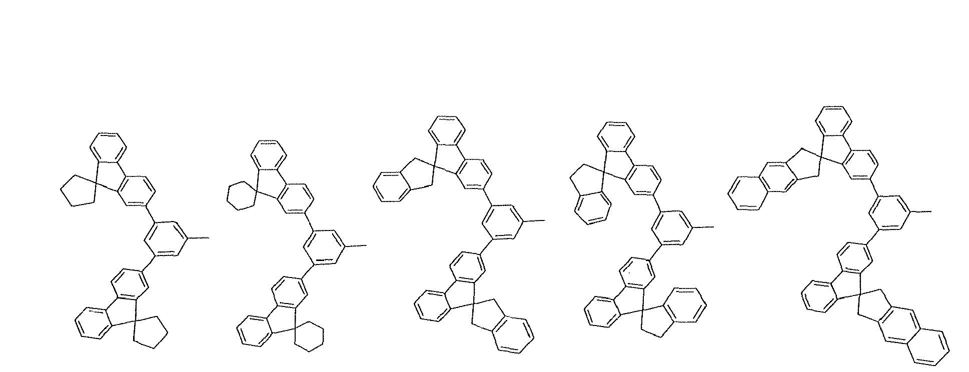

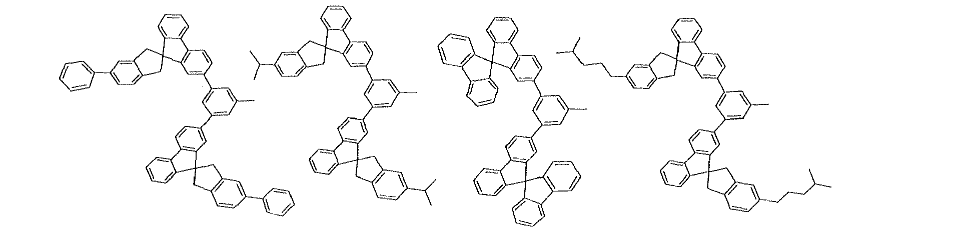

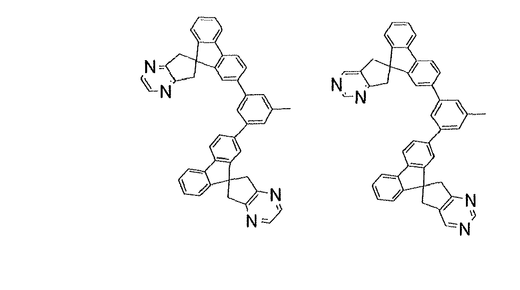

It is preferable that the general formula (12) specifically coincides with a following general formula (41):

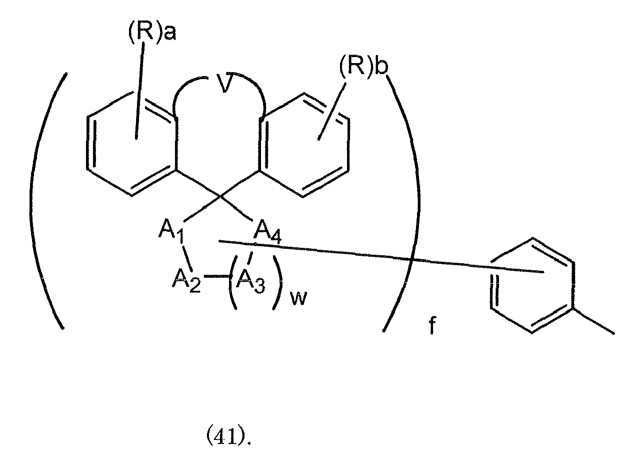

In the general formula (41), **R, V, a, b,** A ₁ to A₄, **w** and f each independently represents the same as aforementioned.

In addition, examples for a group of the general formula (41) are shown as follows, but not limited thereto.

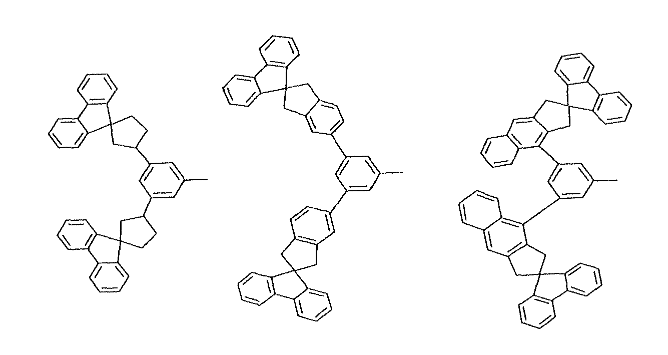

Next, B in the general formula (2) will be explained below.

In the general formula (2), **B** represents a group shown by the general formulae (13) to (15), and may be composed of each group singly or in combination thereof; q represents an integer of from 0 to 20, preferably 0 to 10.

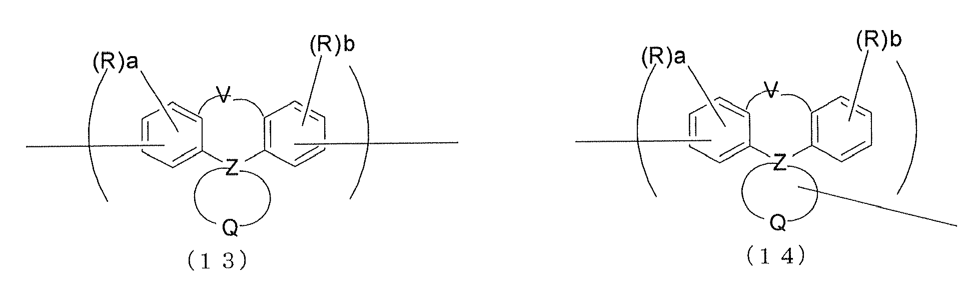

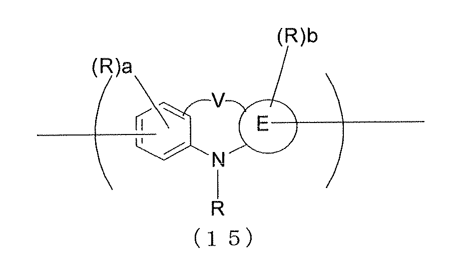

In the general formulae (13) to (15), **R, V, E, Z, Q, a** and **b** each independently represents the same as aforementioned.

It is preferable that the general formula (13) and the general formula (14) each specifically coincides with following general formula (42) and the general formula (43) respectively.

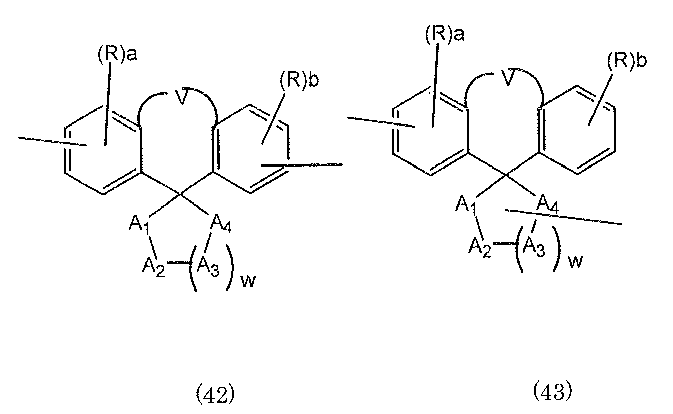

In the general formulae (42) and (43), **R, V, a, b,** A₁ to A₄ and **w** each independently represents the same as aforementioned.

In addition, examples for a group of the general formula (42) are shown as follows, but not limited thereto.

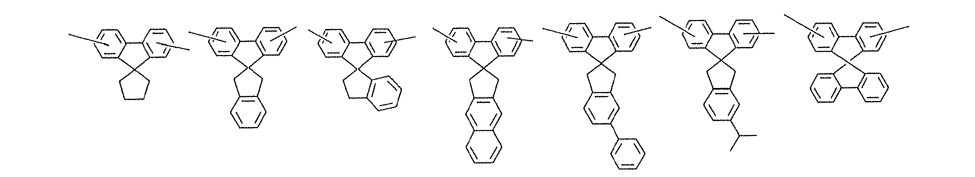

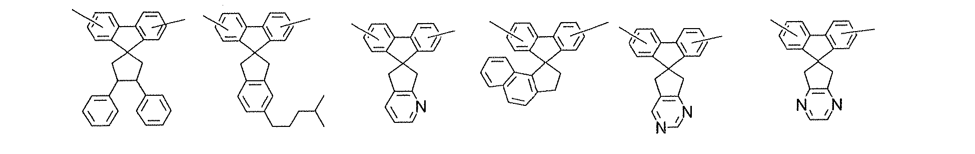

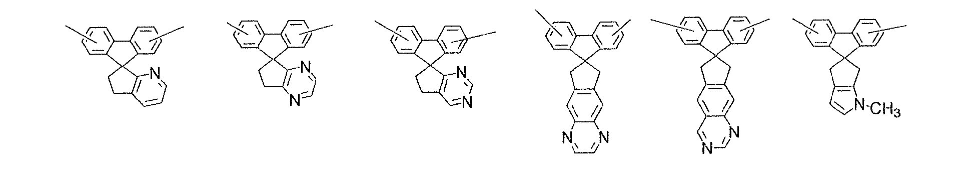

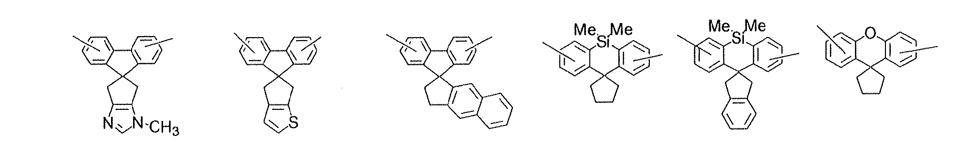

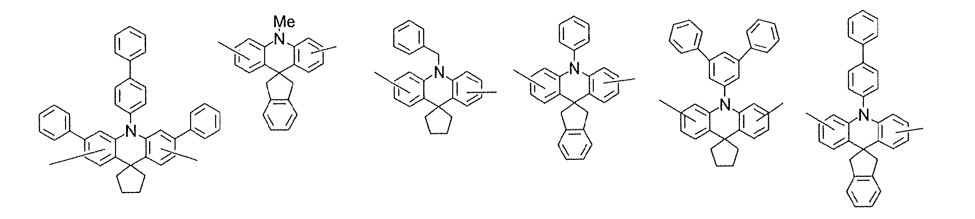

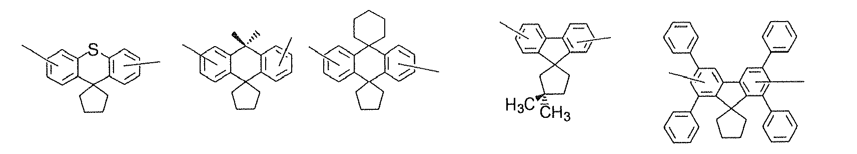

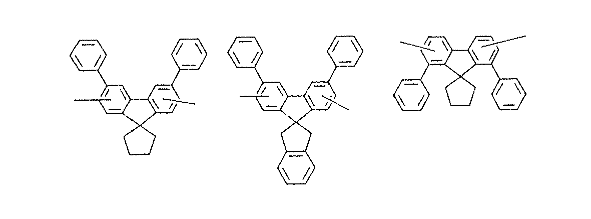

In addition, examples for a group of the general formula (43) are shown as follows, but not limited thereto.

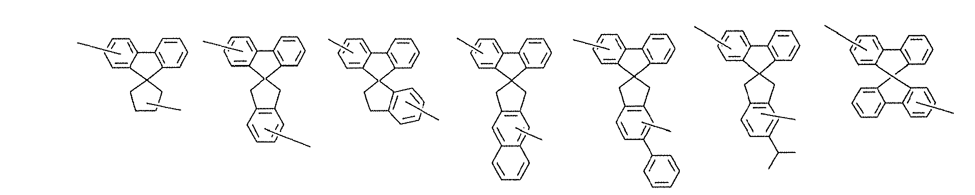

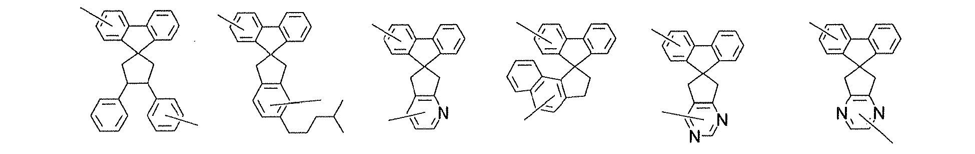

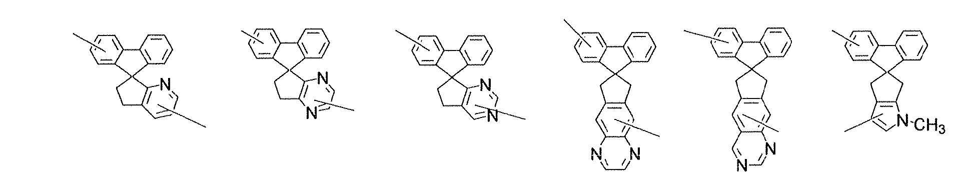

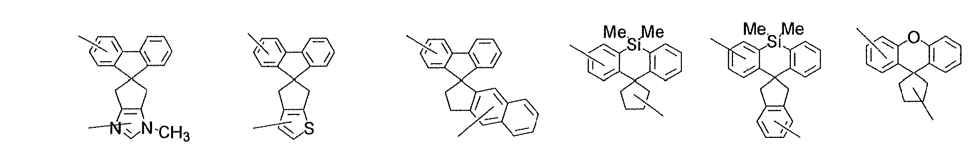

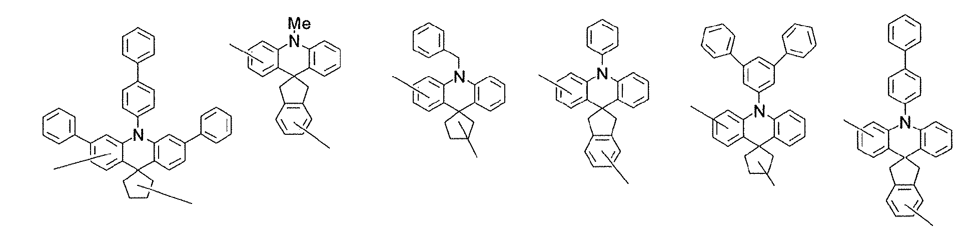

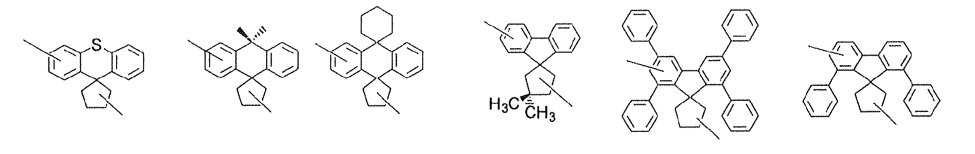

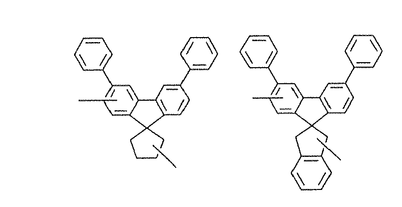

It is preferable that the general formula (15) specifically coincides with a following general formula (44):

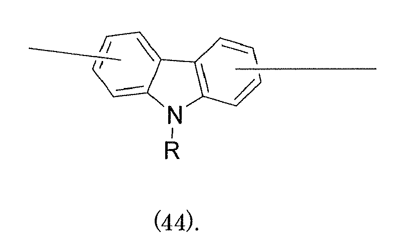

In the general formulae (44), **R** represents the same as aforementioned.

Next, C in the general formula (2) will be explained below.

In the general formula (2), **C** represents a substituted or unsubstituted alkylene group having 1 to 50 carbon atoms, or a substituted or unsubstituted aromatic hydrocarbon group having 6 to 50 ring carbon atoms and plural C, if any, may be the same with or different from each other; p represents an integer of from 0 to 20, preferably 0 to 10.

Examples of the substituted or unsubstituted alkylene group having 1 to 50 carbon atoms represented by C include methylene group, ethylene group, propylene group, isopropylene group, n-butylene group, s-butylene group, isobutylene group, dimetylmethylene group, n-pentylene group, n-hexylene group, n-heptylene group, n-octylene group, chloromethylene group, 1-chloroethylene group, 2-chloroethylene group, 2-chloroisobutylene group, 1,2-dichloroethylene group, 1,3-dichloroisopropylene group, 1,2,3-trichloropropylene group, bromomethylene group, 1-bromoethylene group, 2-bromoethylene group, 2-bromoisobutylene group, 1,2-dibromoethylene group, 1,3-dibromoisopropylene group, 1,2,3-tribromopropylene group, iodomethylene group, 1-iodoethylene group, 2-iodoethylene group, 2-iodoisobutylene group, 1,2-diiodoethylene group, 1,3-diiodoisopropylene group, 1,2,3-triiodopropylene group, cyclopropylene group, cyclobutylene group, cyclopentylene group, cyclohexylene group, 4-methylenecyclohexylene group, adamantane-1, 1-diyl group, adamantane-1, 3-diyl group and so forth.

Examples of the substituted or unsubstituted aromatic hydrocarbon group having ring carbon atoms of 6 to 50 represented by C include the following:

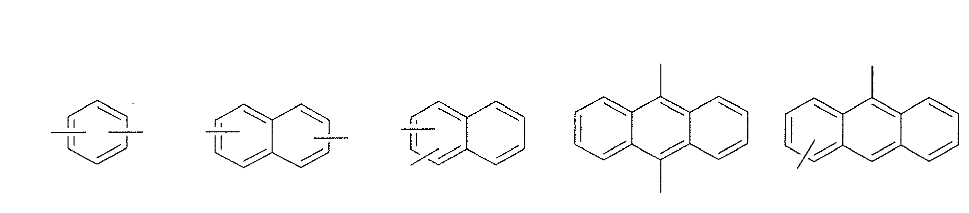

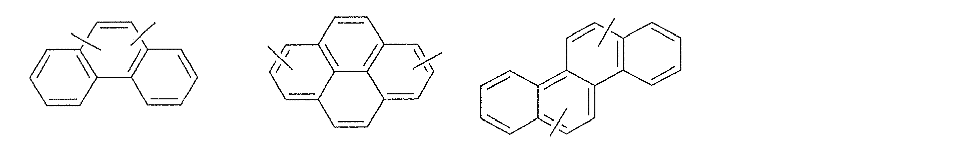

Next, D in the general formula (2) will be explained below.

In the general formula (2), it is preferable that D coordinating to a metal atom represents a group removing a hydrogen atom from the molecule expressed by the general formula (20). 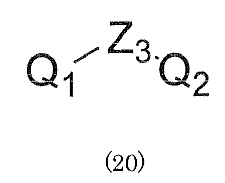 wherein Q₁ and Q₂ each independently represents a substituted or unsubstituted aromatic hydrocarbon group having 6 to 50 ring carbon atoms, a substituted or unsubstituted aromatic heterocyclic group having 5 to 50 ring atoms of or a derivative thereof; at least one of Q₁ and Q₂ represents a benzene ring or a derivative thereof; any one of Q₁ and Q₂ forms a carbon atom- a metal atom bond with the aforementioned metal atom M and the other one forms a coordination bond therewith.

An aromatic hydrocarbon group and an aromatic heterocyclic group of Q₁ and Q₂ include the same as those of the aforementioned R. Z₃ represents a single bond, -CR₀R₀'-, -SiR₀R₀'-, -O-, -CO- or NR₀; R₀ and R₀' represent the same as aforementioned.

In addition, examples of a group represented by the general formula (20) are shown as follows, but not limited thereto.

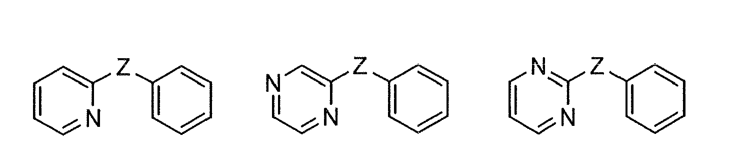

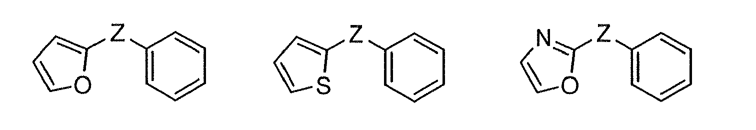

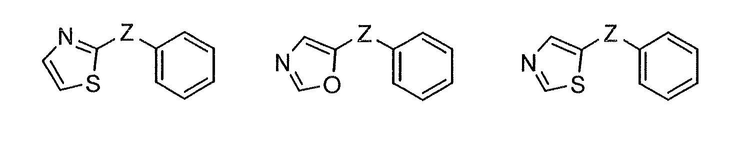

It is preferable that D in the general formula (2) represents a substituted or unsubstituted phenylpyridiyl group.

In addition, A and/or B in the general formula (2) contains at least one structure having a spiro skeleton structure.

Further, regarding with the coordination metal compound of the present invention, it is preferable that A in the general formula (2) is any one selected from among the foregoing general formulae (5) to (6) and (22) to (41) and that B in the general formula (2) is any one selected from among the foregoing general formulae (42) to (44).

Moreover, it is preferable that L₁ in the general formula (1) may also be a ligand represented by a following general formula (16):

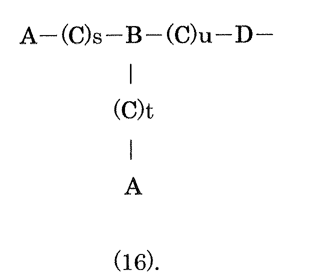

In the general formula (16), A represents a group expressed by any one of the general formulae (3) to (12), and plural **A,** if any, may be the same with or different from each other. **R, V, E, Q, Z** and **a** to **f** in the general formulae (3) to (12) each independently represents the same as aforementioned.

C in the general formula (16) may be the same as aforementioned and plural C, if any, may be the same with or different from each other s, t and u each independently represents an integer of 0 to 20, preferably 0 to 10.

**B** in the general formula (16) represents a tervalent group represented by any one of the general formulae (17) to (19) below, which may be alone or in combination of two or more kind thereof.

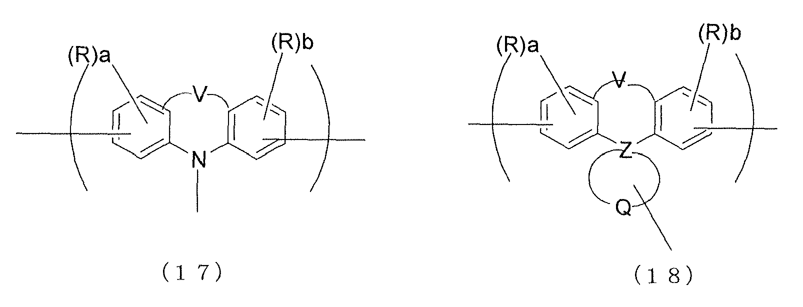

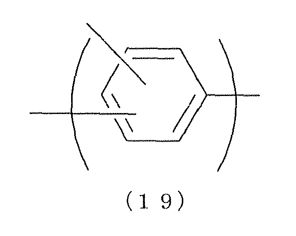

**R, V, Z, Q, a** and **b** in the general formulae (17) to (19) each independently represents the same as aforementioned.

It is preferable that a group of the general formula (17) is expressed by the general formula (45) below.

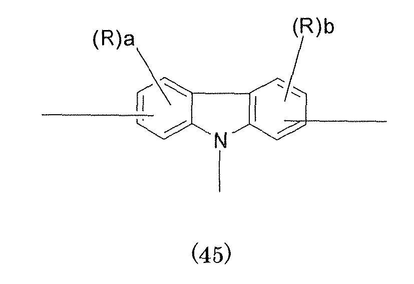

In the general formula (45), **R, a** and **b** each independently represents the same as aforementioned.

It is preferable that the above general formula (18) specifically coincides with a following general formula (46):

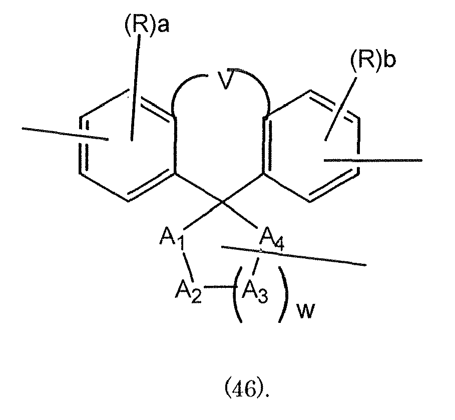

**R, V, a, b,** A₁ to A₄ and **w** in the general formula (46) each independently represents the same as aforementioned.

In addition, examples for a group of the general formula (45) and the general formula (46) are shown as follows, but not limited thereto.

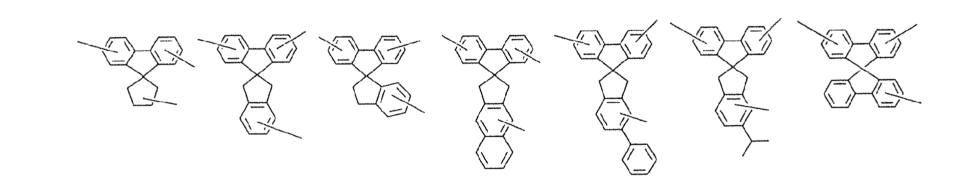

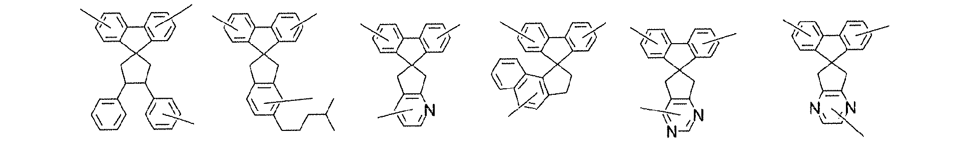

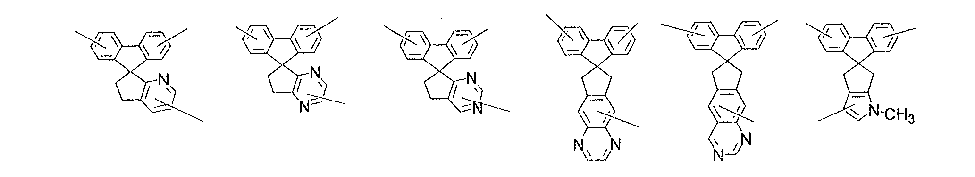

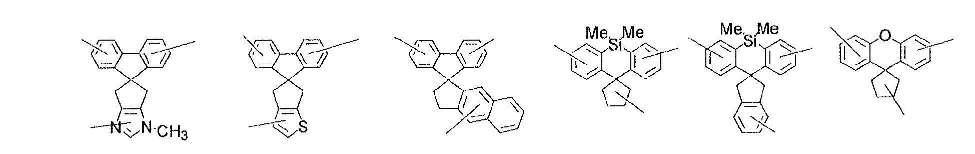

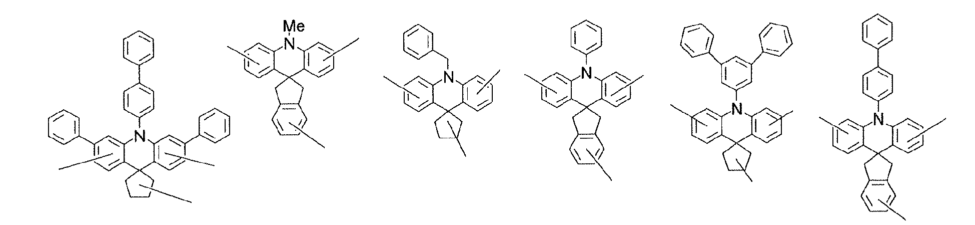

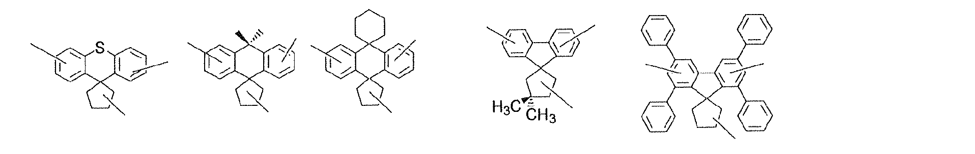

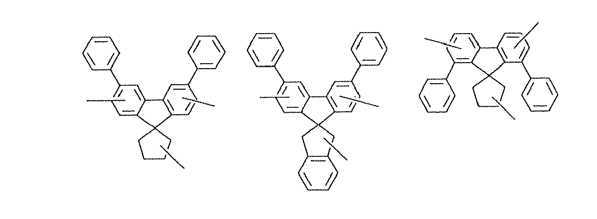

In the general formula (16), it is preferable that **D** coordinating to a metal atom represents a group removing a hydrogen atom from the molecule expressed by the general formula (20).

In the general formula (16), **D** is preferably a substituted or unsubstituted phenylpyridyl group.

Further, in the general formula (16), **A** and/or **B** contains at least one structure having a spiro skeleton structure.

In addition, it is preferable that **A** represents a group selected from the general formulae (22) to (41) and that **B** represents the foregoing general formulae (45) to (46).

In the general formula (1), x represents an integer of from 1 to the valence of a metal atom **M,** y represents an integer of from 0 to 4 and z represents an integer of from 0 to 4.

**M** in the general formula (1) is any one of a metal atom of iridium (Ir), platinum (Pt), osmium (Os), rhodium (Rh), rhenium (Re), palladium (Pd), ruthenium (Ru), tungsten (W), gold (Au) or silver (Ag), and Ir is preferred. Further, plural **M** is the same with or different from each other when y is 1 or greater.

**P** in the general formula (1) represents a ligand combining with a metal atom M when y is 1 or greater, and examples thereof are as follows, but not limited thereto.

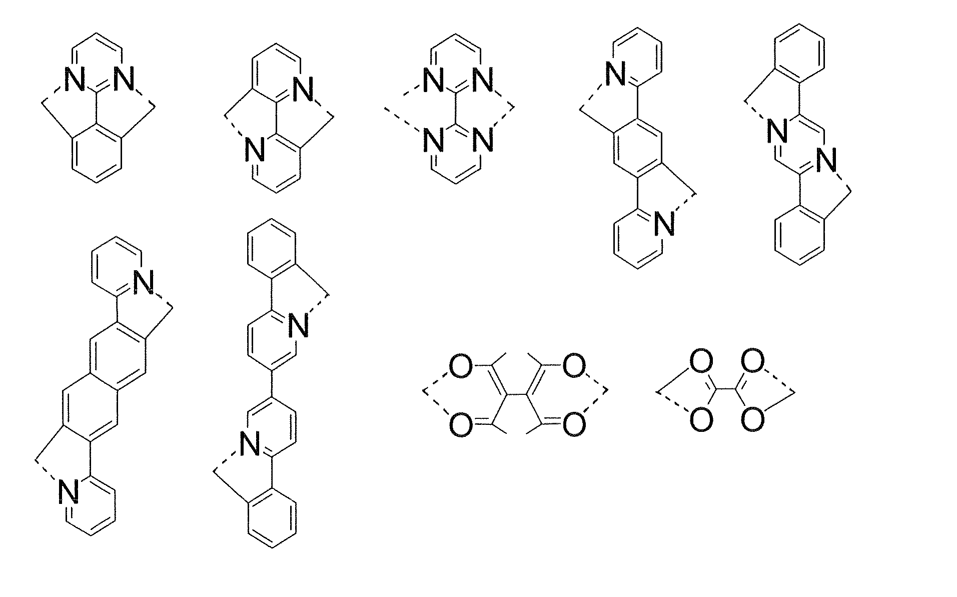

L₂ in the general formula (1) represents a ligand coordinating to a metal atom **M** and may be the same as aforementioned about L₁, examples include a halogen atom such as F, Cl, Br and I, an alkyl group and an aryl group having a hetero atom, an aromatic heterocyclic group and so forth; while at least one kind selected from among a halogen atom, an acetylaceton derivative, a 8-quinolinol derivative and a phenylpyridine derivative is preferable for L₂. Examples of L₂ are shown as follows, but not limited thereto.

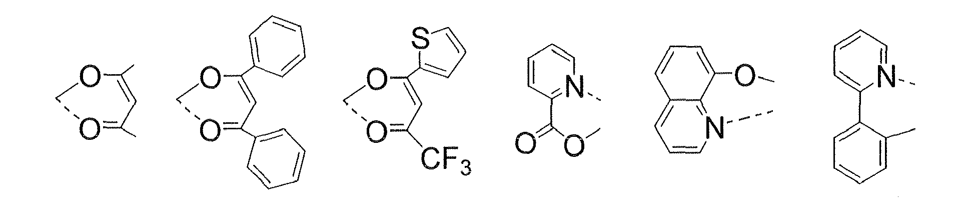

Specific examples of a coordination metal compound represented by the general formula (1) of the present invention are shown as follows, but not limited thereto;

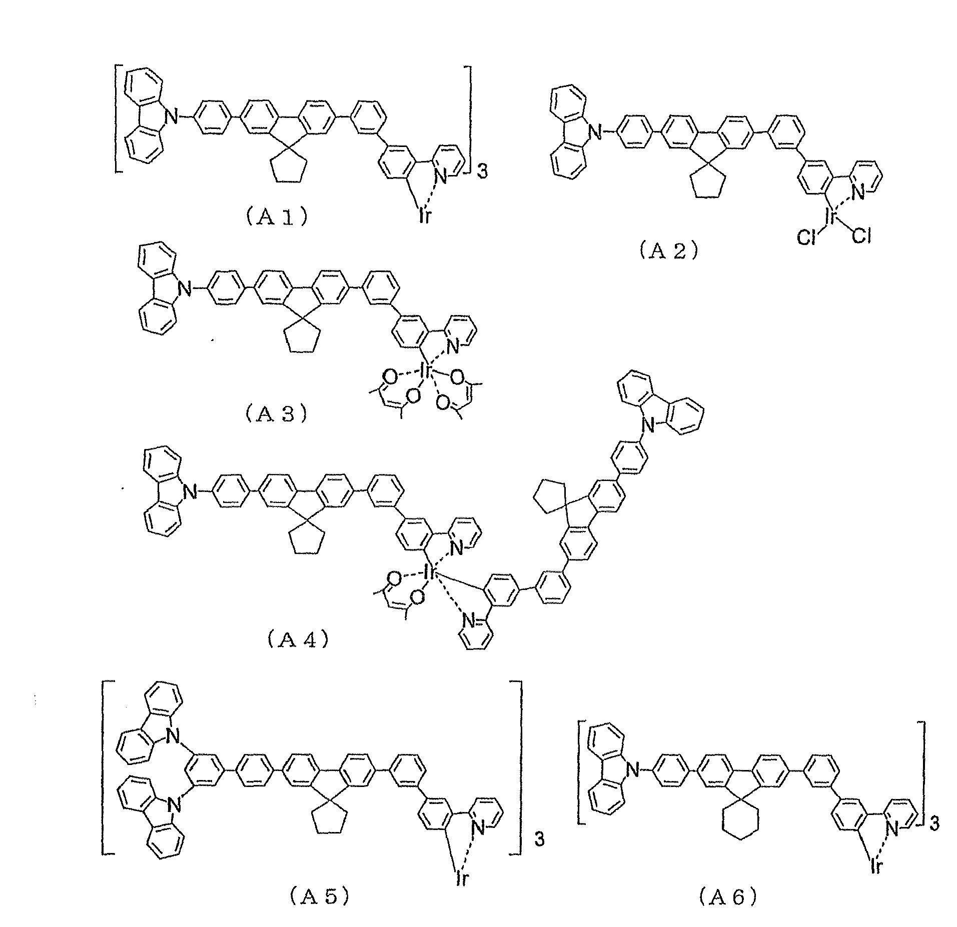

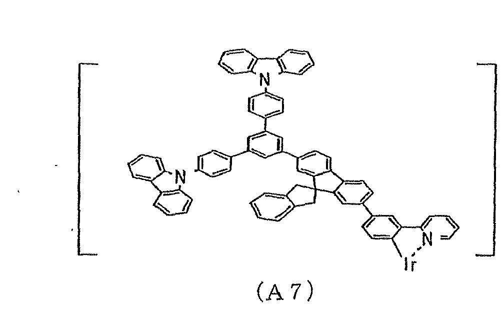

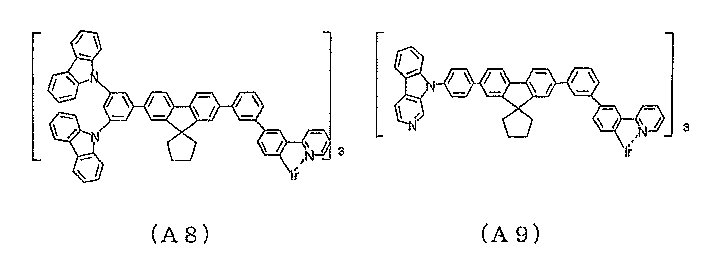

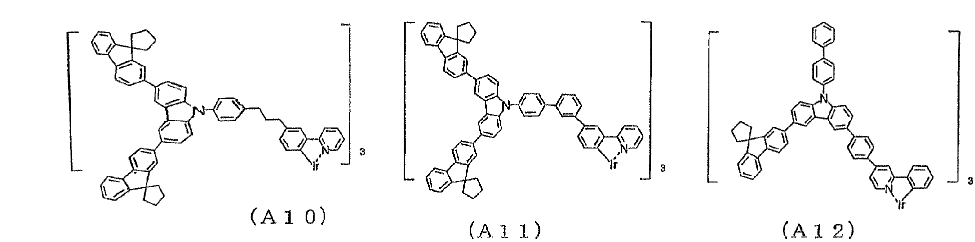

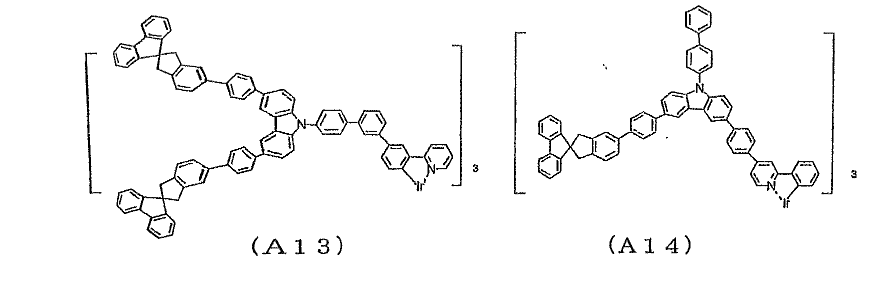

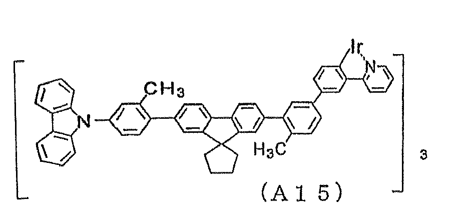

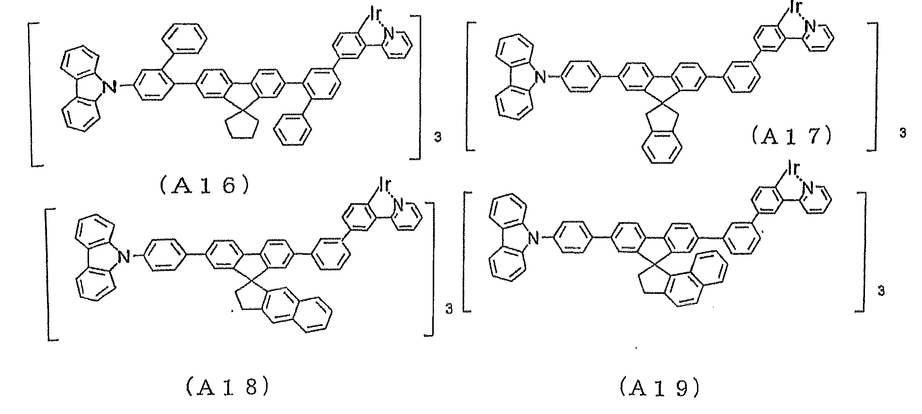

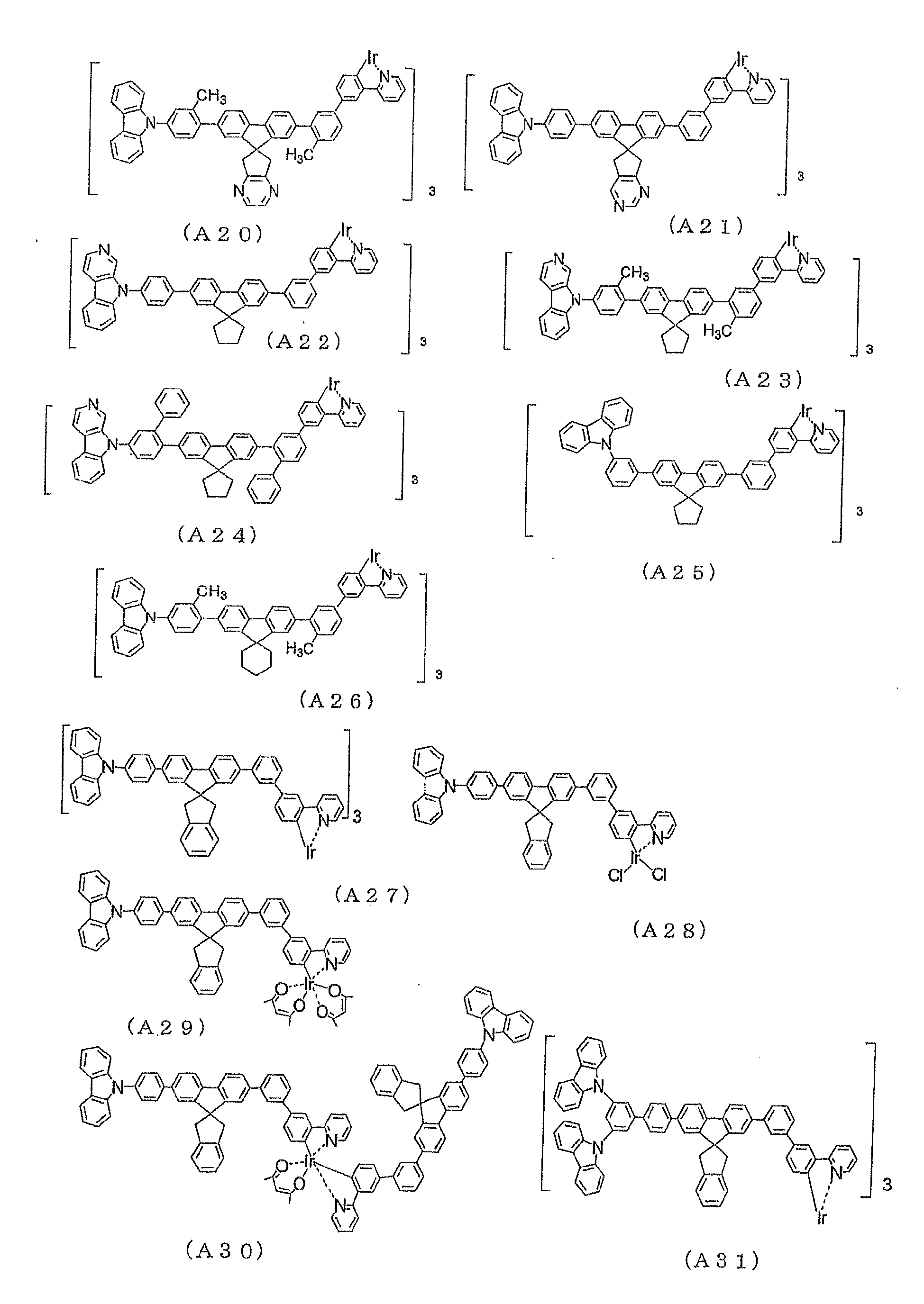

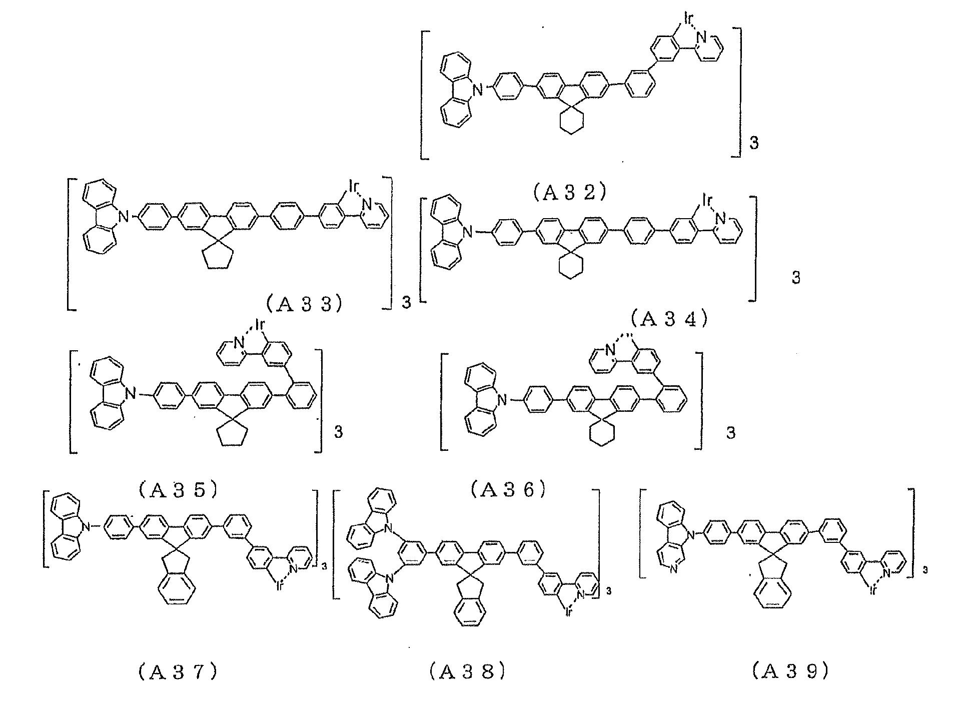

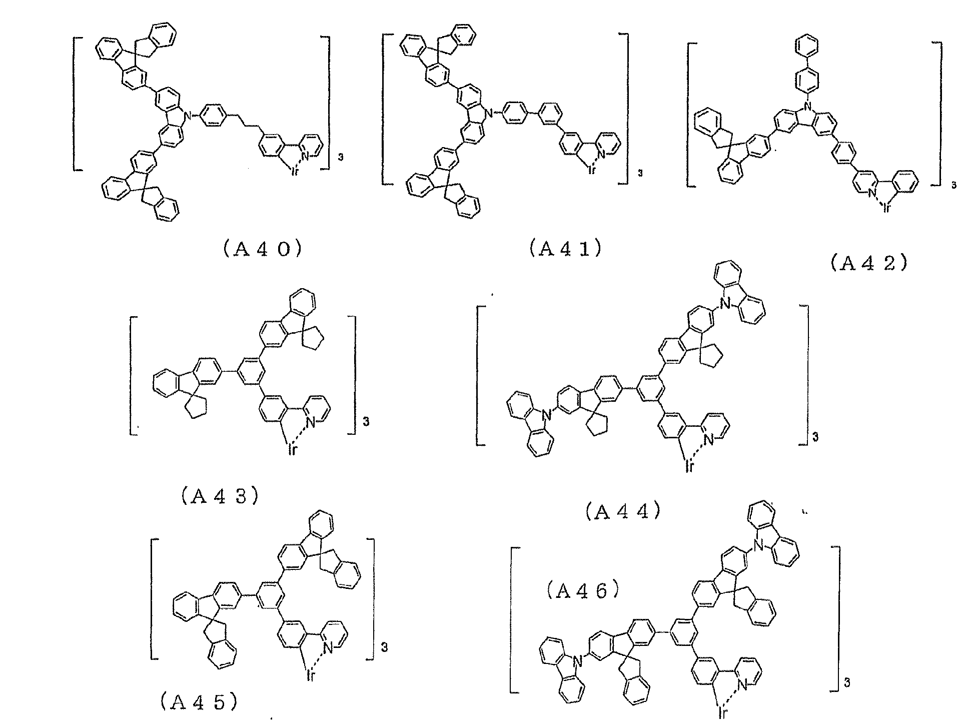

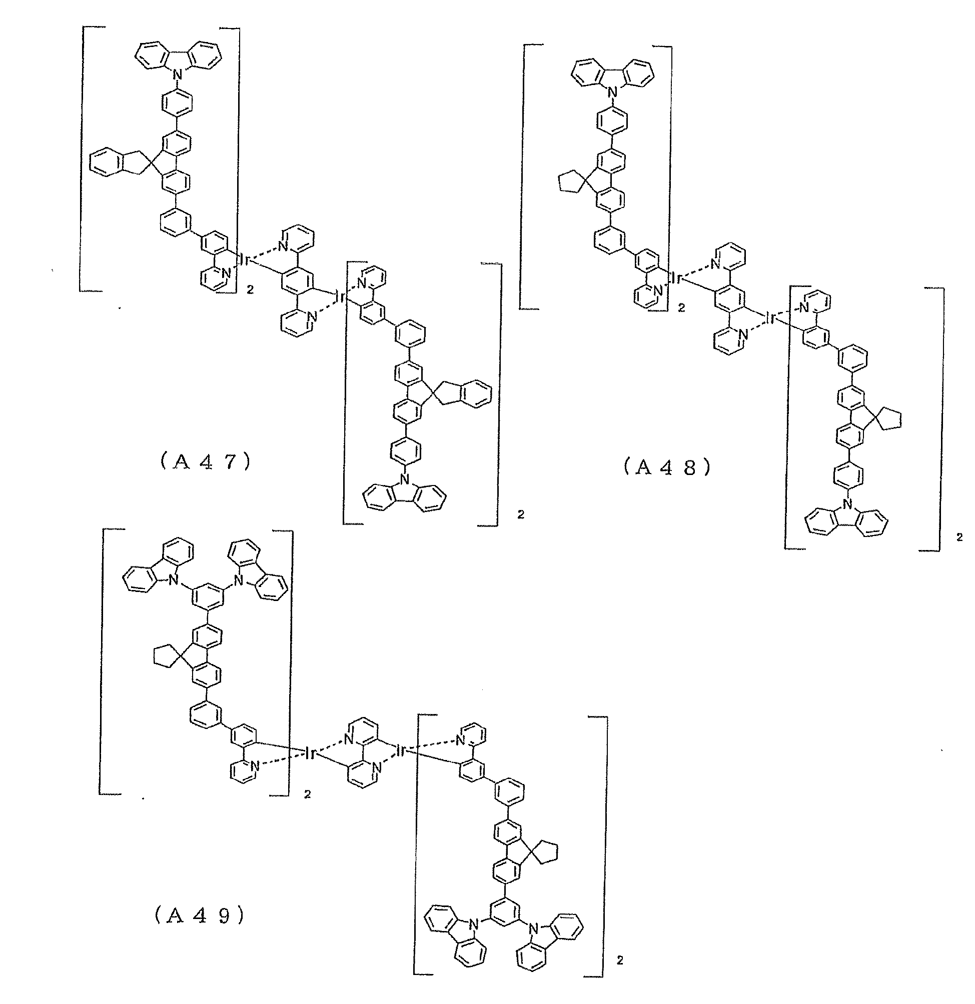

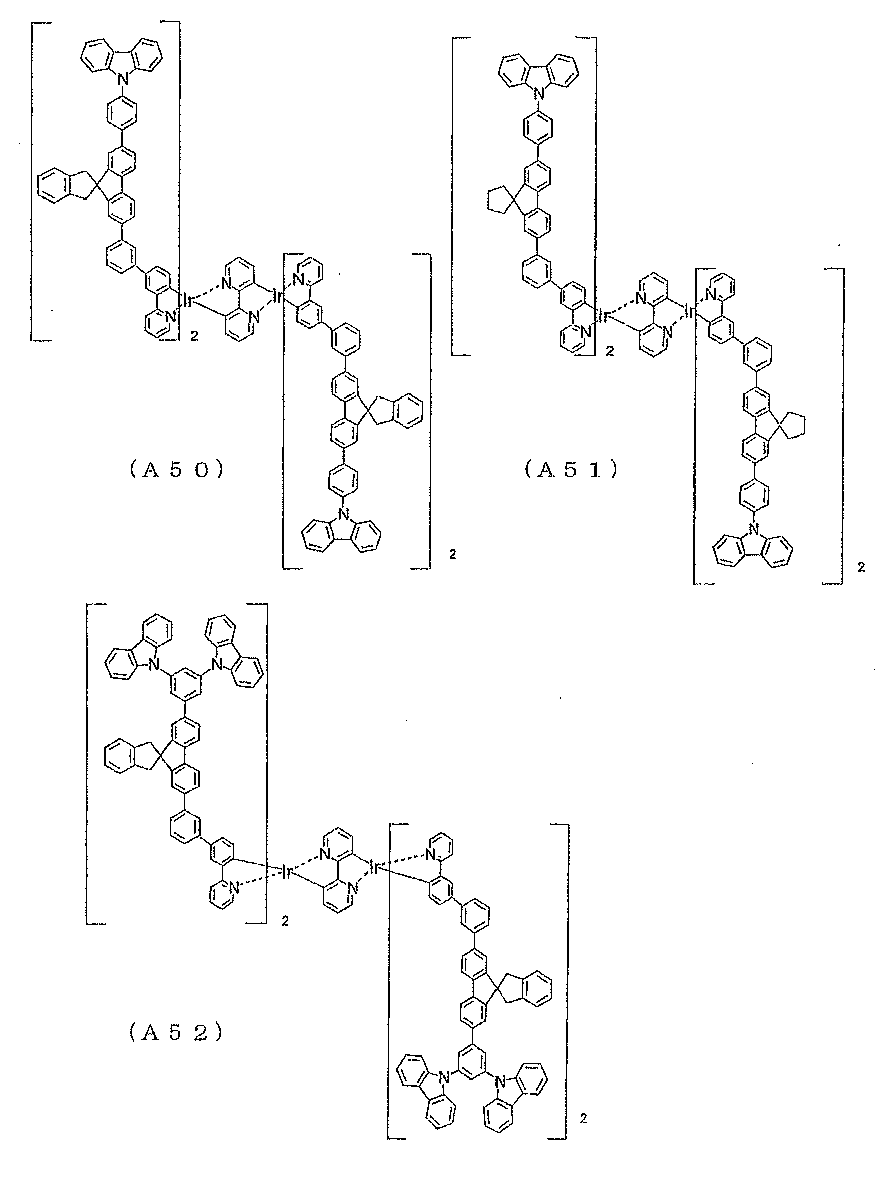

Next, a material for an organic EL device of the present invention will be explained below.

A material for an organic EL device of the present invention comprises at least one compound having a structure represented by a following general formula (1'):

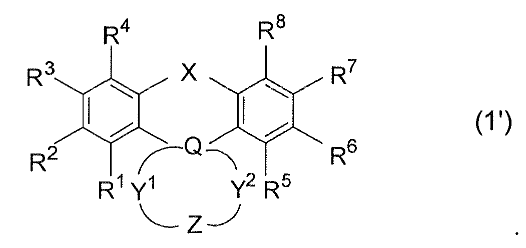

In the general formula (1'), **X,** Y¹ and Y² each independently represents a single bond, **-CR'R"-,** -Si**R'R"-,** -CO- or **NR'-,** and **Q** represents a carbon atom, a silicon atom or a germanium atom. **Z** represents a divalent group comprising a heavy metal complex. **R'** and **R"** each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms;
R¹ to R⁸ each independently represents a hydrogen atom or a group selected from among a substituted or unsubstituted alkyl group having 1 to 50 carbon atoms, a substituted or unsubstituted alkenyl group having 1 to 50 carbon atoms, a substituted or unsubstituted alkynyl group having 1 to 50 carbon atoms, a substituted or unsubstituted alkoxy group having 1 to 50 carbon atoms, a substituted or unsubstituted alkylthio group having 1 to 50 carbon atoms, a substituted or unsubstituted amino group, having 1 to 50 carbon atoms a substituted or unsubstituted alkylaminogroup having 1 to 50 carbon atoms, a substituted or unsubstituted dialkylamino group having 1 to 50 carbon atoms or a substituted or unsubstituted heterocyclic group having 1 to 50 ring carbon atoms, and an aryl group having 6 to 50 ring carbon atoms, an aryloxy group having 6 to 50 ring carbon atoms, an arylthio group having 6 to 50 ring carbon atoms, an arylamono group having 6 to 50 ring carbon atoms, a diarylamino group having 6 to 50 ring carbon atoms or an alkylarylamino group having 6 to 50 ring carbon atoms. In addition, two neighboring groups among R¹ to R⁸ may bond each other to form a ring structure;
**Z** includes a divalent group formed by removing two hydrogen atoms from the metal complex represented by a following general formula (2'): 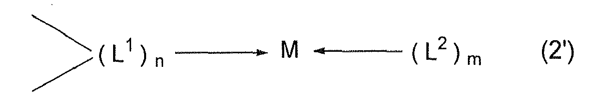 wherein L¹ represents a metal coordination part expressed by a following general formula (3'): 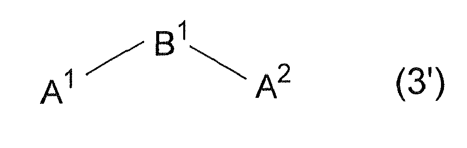 which bonds to Y¹ and Y² in the general formula (1').

A₁ and A₂ in the general formula (3') each independently represents a substituted or unsubstituted aromatic group having 6 to 50 ring carbon atoms and a substituted or unsubstituted aromatic heterocyclic group having 5 to 50 ring atoms, further at least one of A₁ and A₂ is a phenyl group or a substituted phenyl group. B₁ in the general formula (3') represents a single bond, -C**R**'**R**"-, -Si**R**'**R**"-, -CO- or **NR'-; R'** and **R"** each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms.

Preferred examples of a metal coordination part represented by the general formula (3') are as follows.

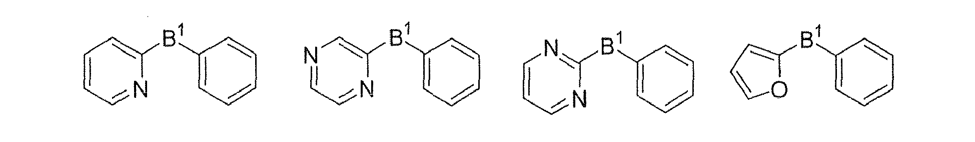

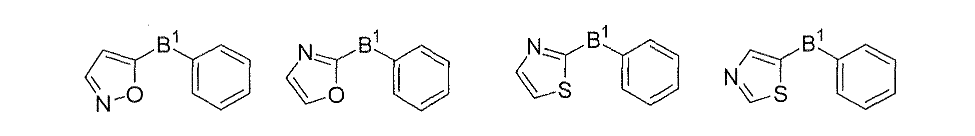

Among those, a particularly preferable metal coordination part consists of a following structure:

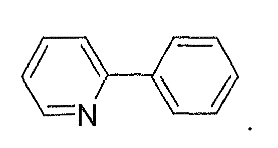

In the general formula (2'), M represents a metal atom selected from the group consisting of Ir, Pt, Os, Re, Pd, Ru, W, Au and Ag, and Ir is a preferred metal atom. In the general formula (2'), [L¹ → M] means that L¹ cordinates to a metal atom M and that it is selected from the following; 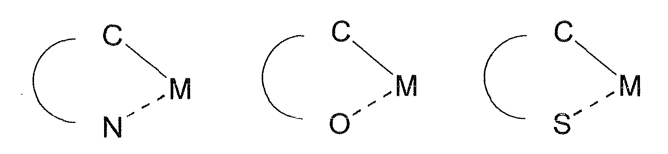 wherein, a carbon atom of L¹ bonds to a metal atom, an atom selected from the group consisting of N, O and S cordinates to a metal atom M.

In the examples of the coordination form, the following coordination form, in which a carbon atom bonds to a metal atom M and a N atom cordinates to the metal atom M, is preferred.

In the general formula (2'), L² represents a ligand cordinating to a metal and may be the same with or different from L¹; [L ² ← M] means that L ² cordinates to a metal atom M and that it is selected from a σ-bond of halogen atom or the following: 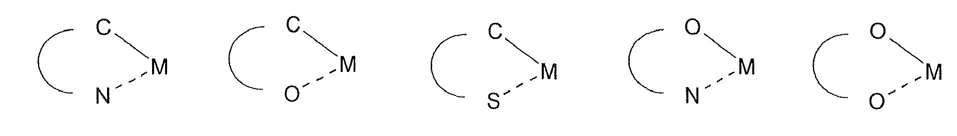 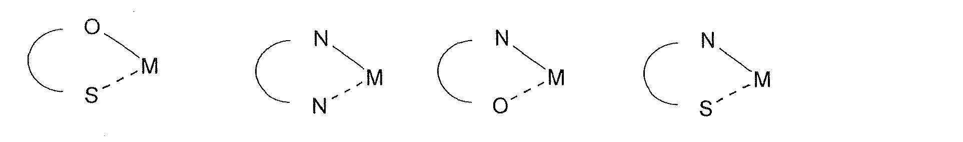 wherein, a carbon atom of L ² and an atom selected from O and N bond to a metal atom M and an atom selected from the group consisting of N, O and S cordinates to a metal atom M.

As L ², a halogen atom or at least one kind selected from among those following derivatives including an acetylaceton derivative, an 8-quinohnol derivative and a phenylpyridine derivative shown below is preferable.

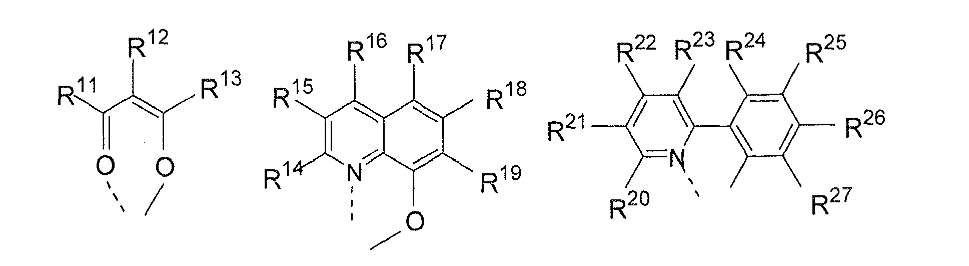

In the above, R¹¹ to R²⁷ each independently represents a hydrogen atom, a cyano group, a nitro group, a halogen atom, a substituted or unsubstituted alkyl group having 1 to 20 carbon atoms, alkoxy group having 1 to 20 carbon atoms, alkylsilyl group having 1 to 20 carbon atoms, or acryl group having 1 to 20 carbon atoms, a substituted or unsubstituted amino group and a substituted or unsubstituted aryl having 6 to 30 ring carbon atoms.

It is preferable that L² represents an acetylacetone derivative, an 8-quinolinol derivative and a phenylpyridine derivative.

In the general formula (2'), **n** represents an integer of from 1 to x **(x:** valence of a metal atom) and m represents an integer of from 0 to **(x** minus **n).**

The following shows examples of a compound comprising as least one of a structure of the general formula (1'), but not limited thereto.

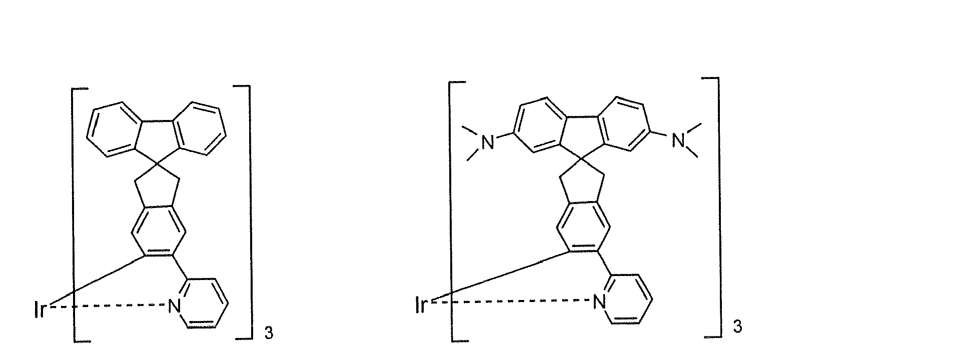

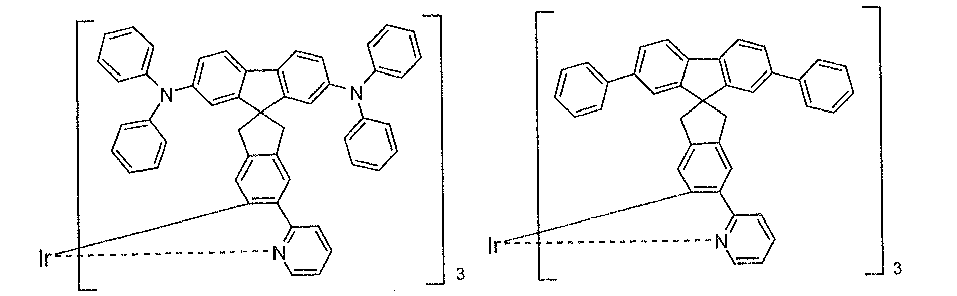

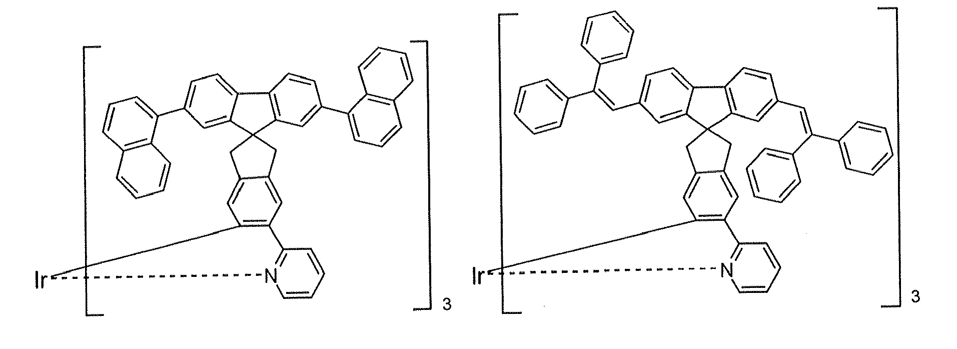

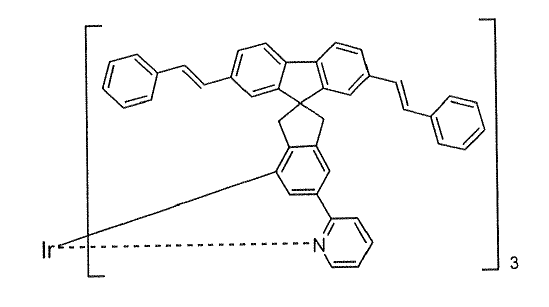

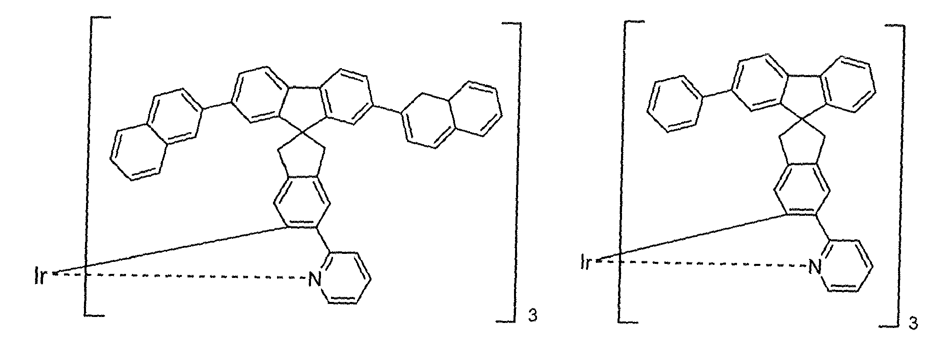

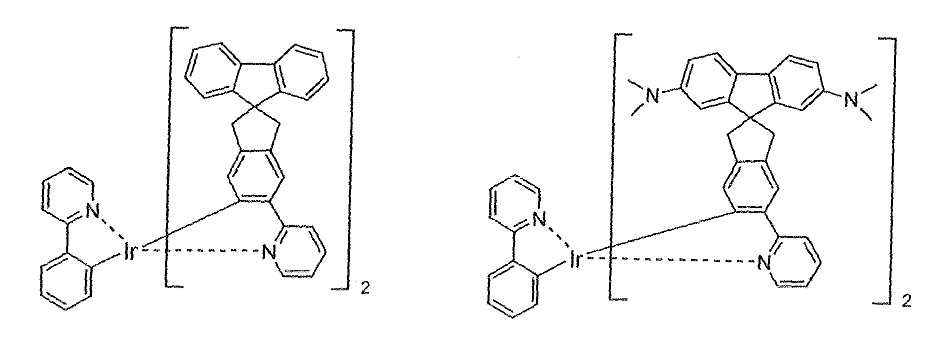

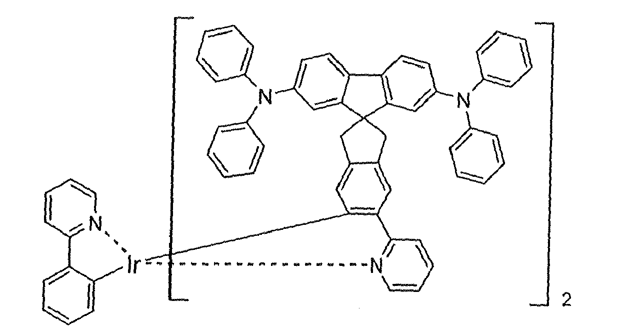

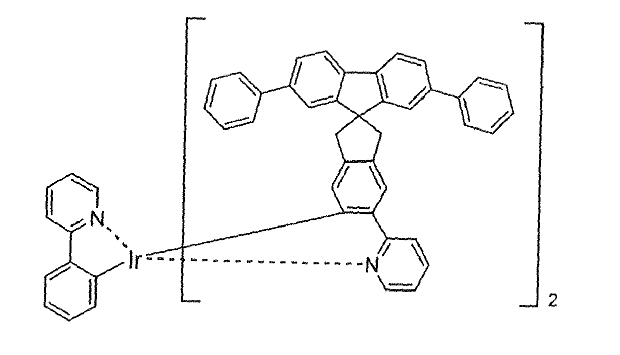

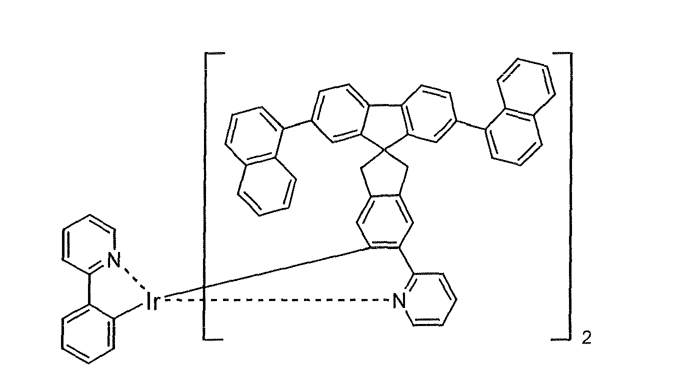

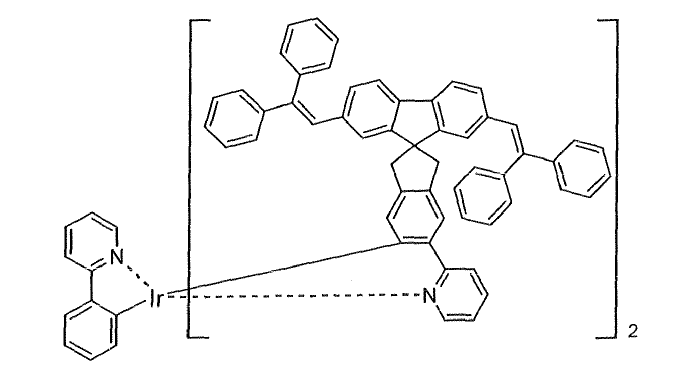

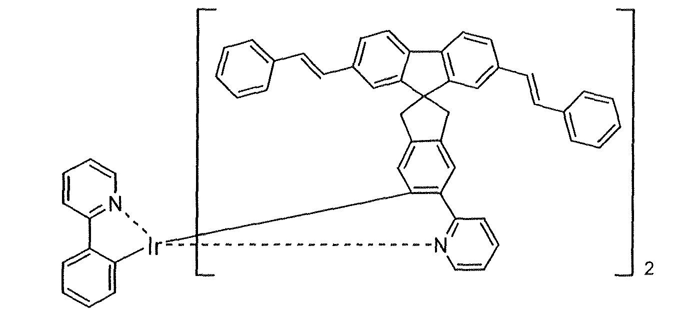

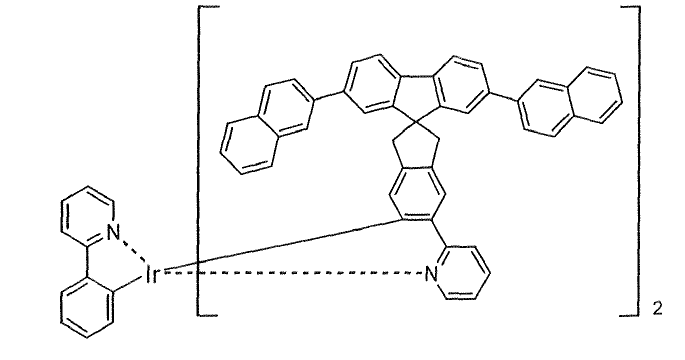

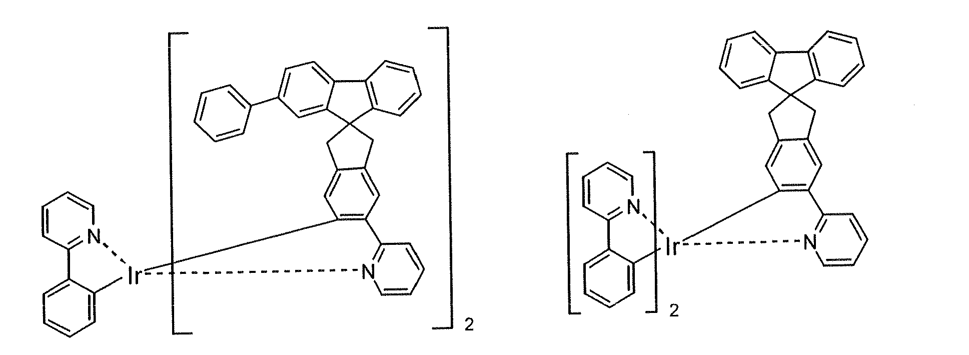

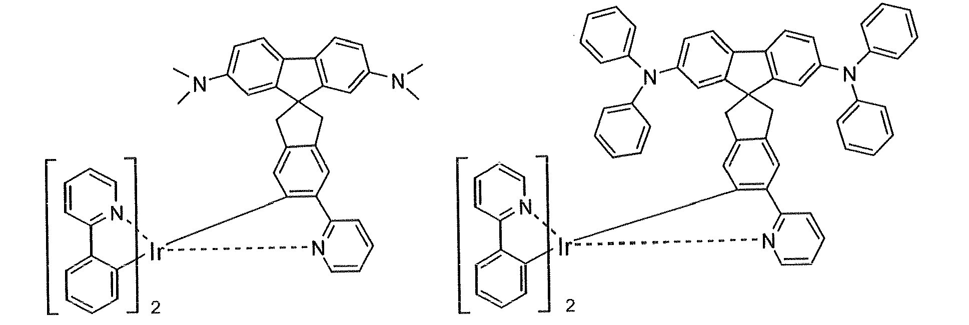

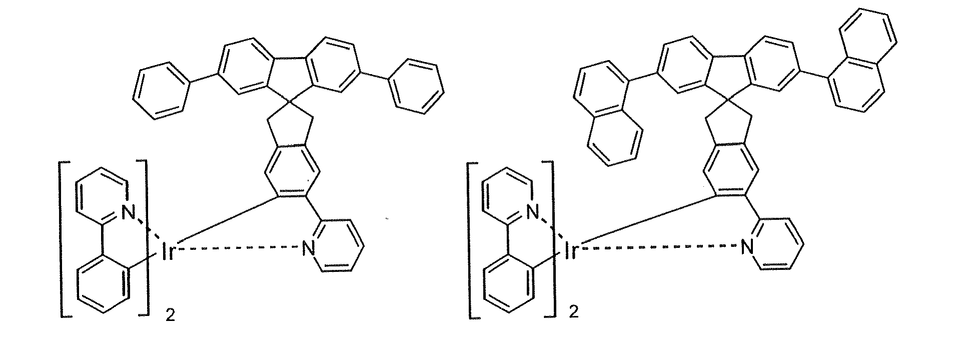

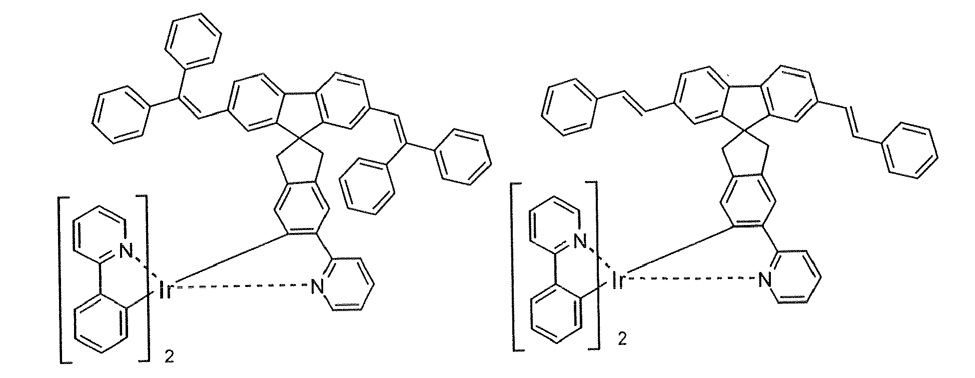

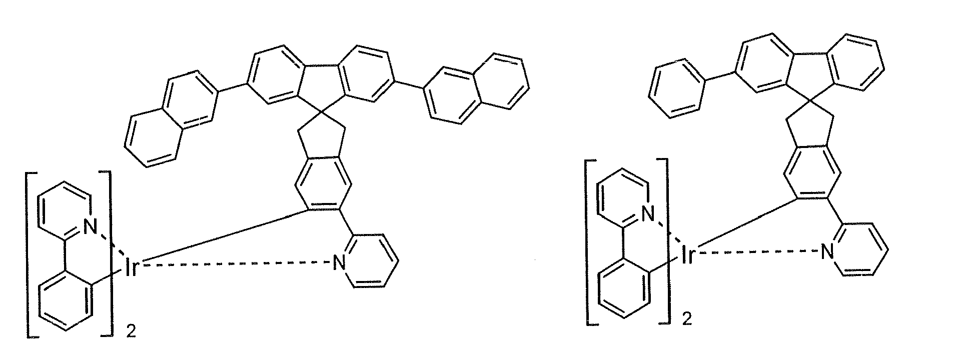

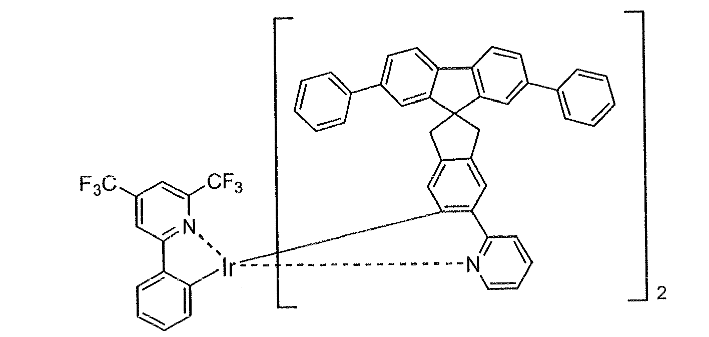

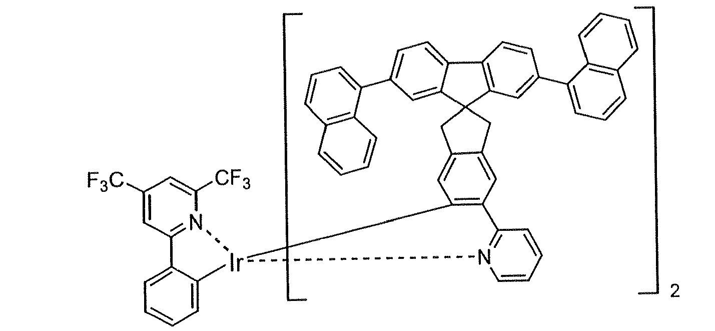

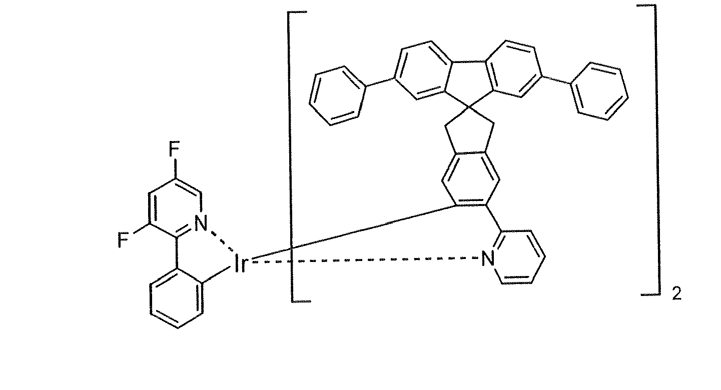

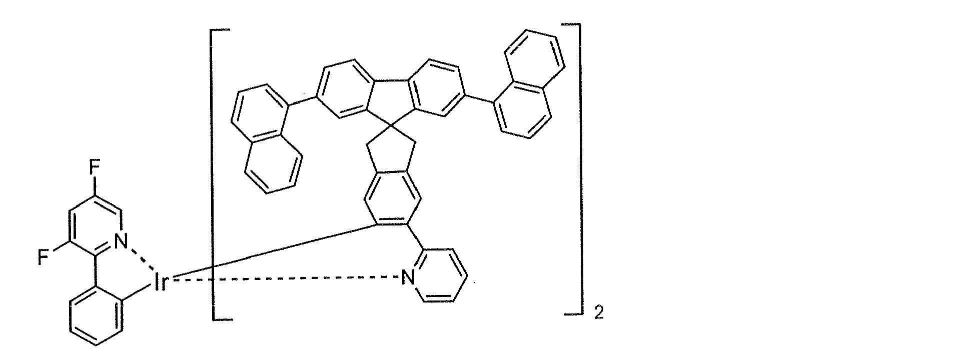

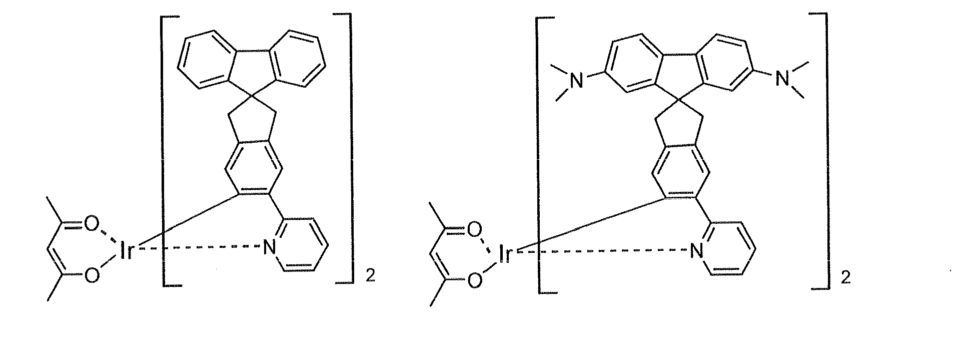

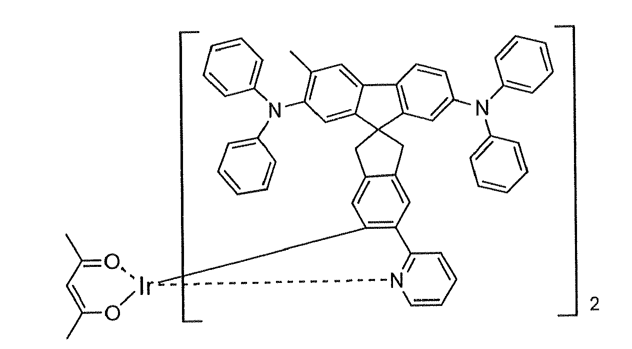

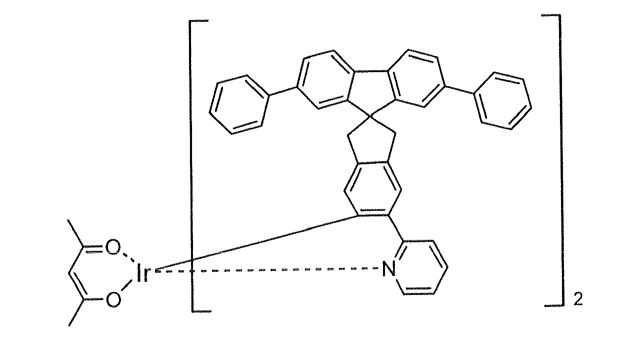

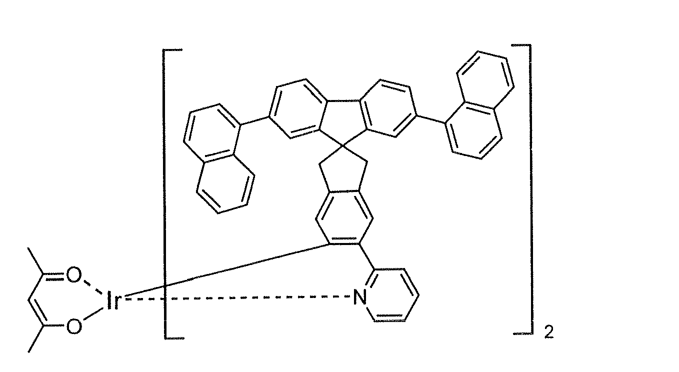

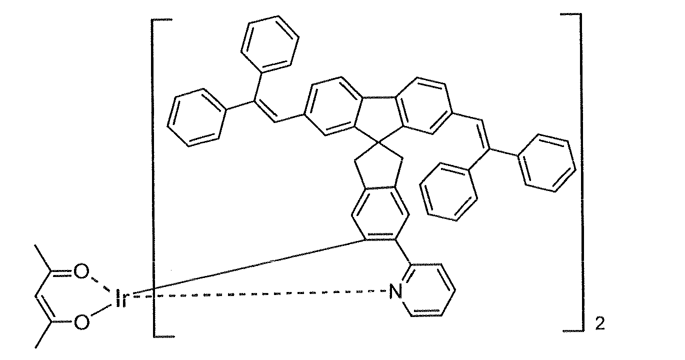

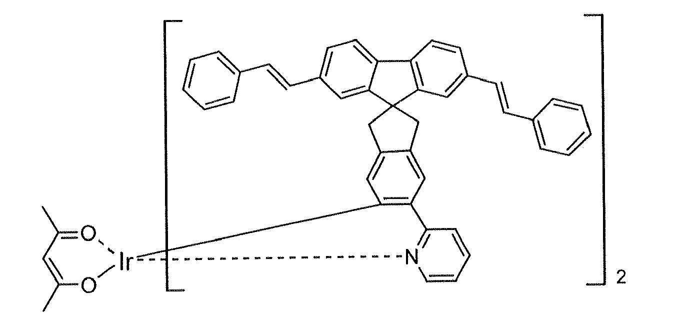

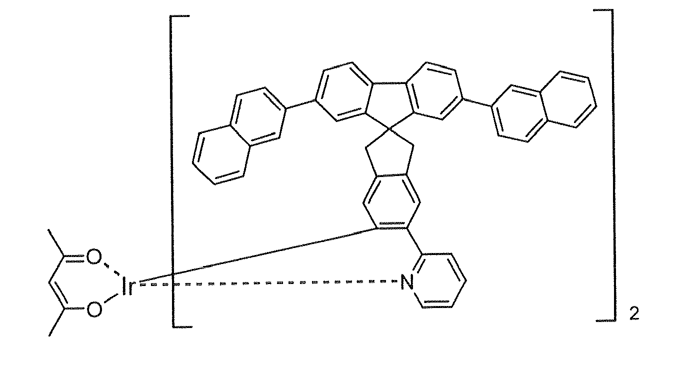

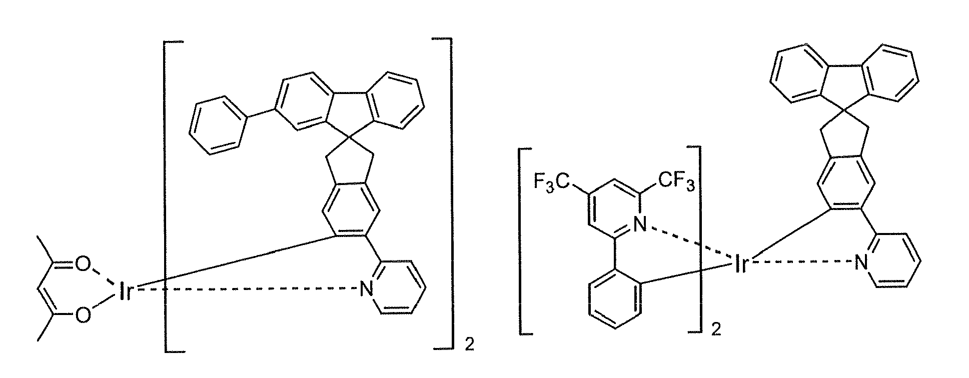

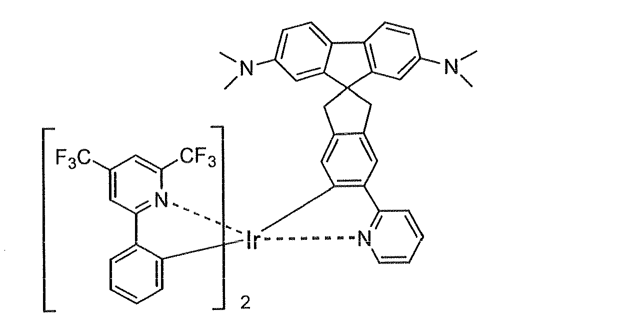

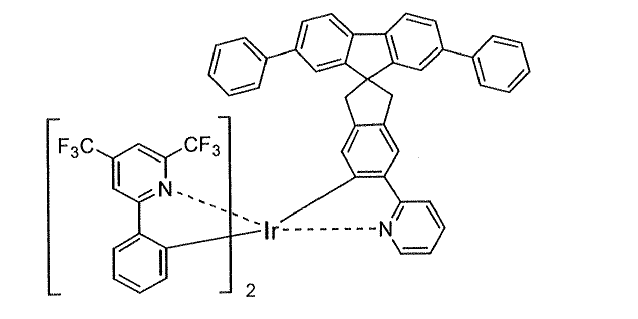

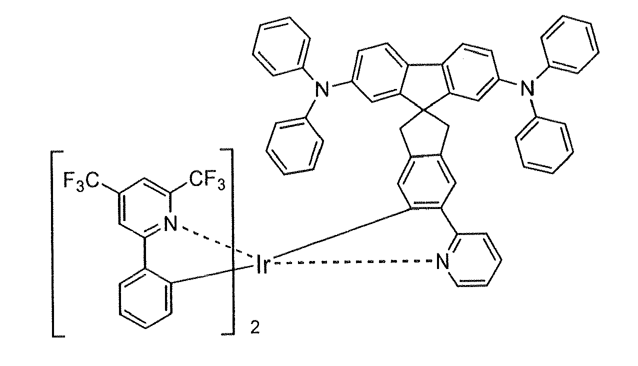

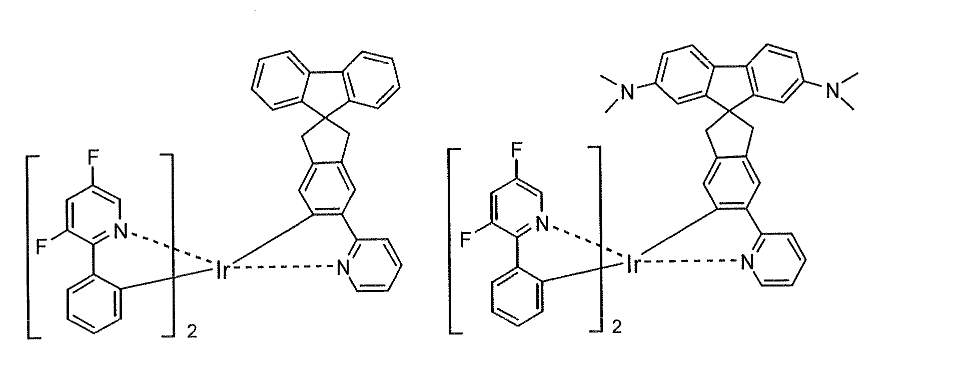

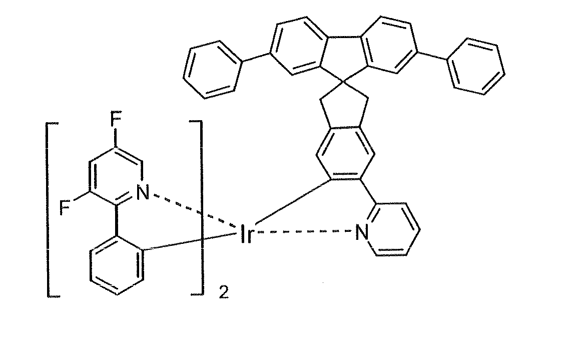

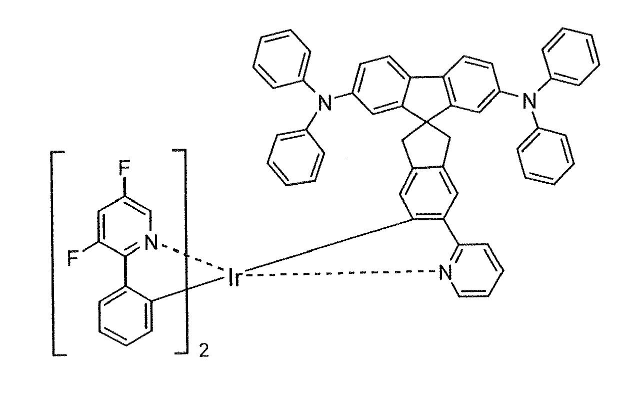

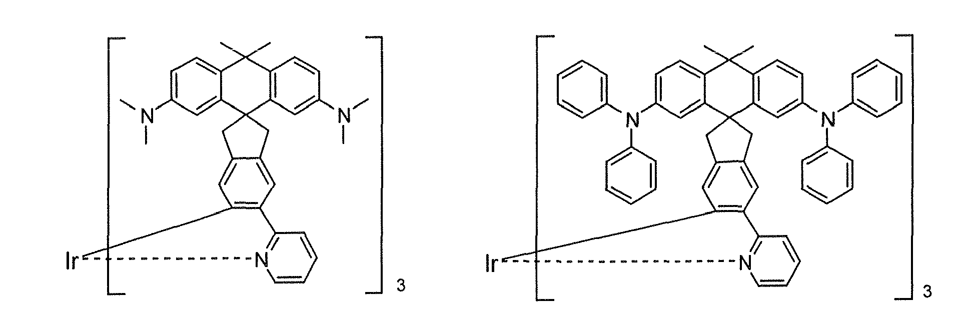

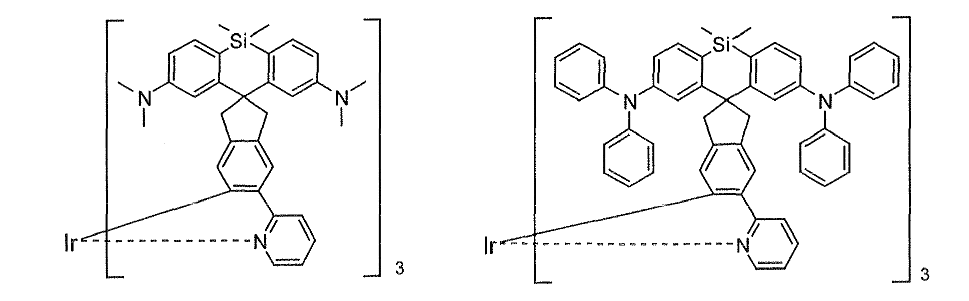

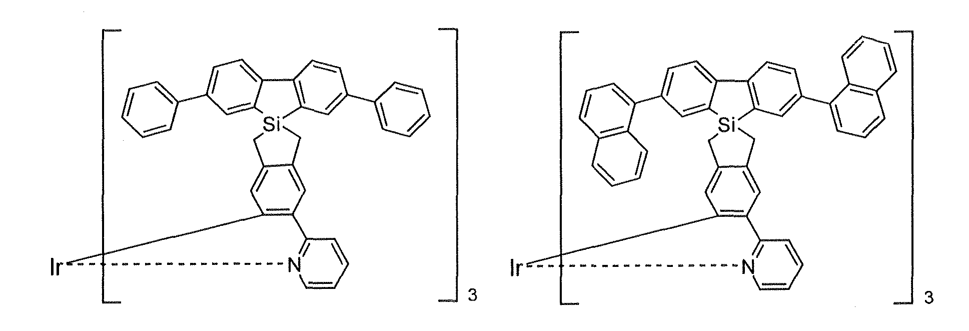

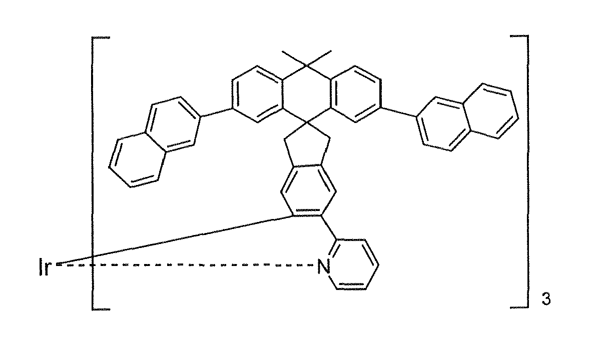

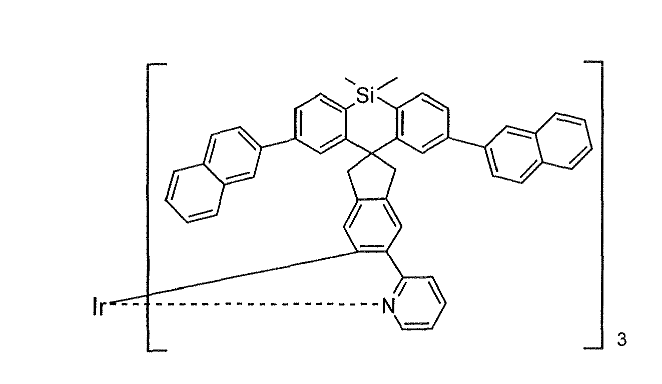

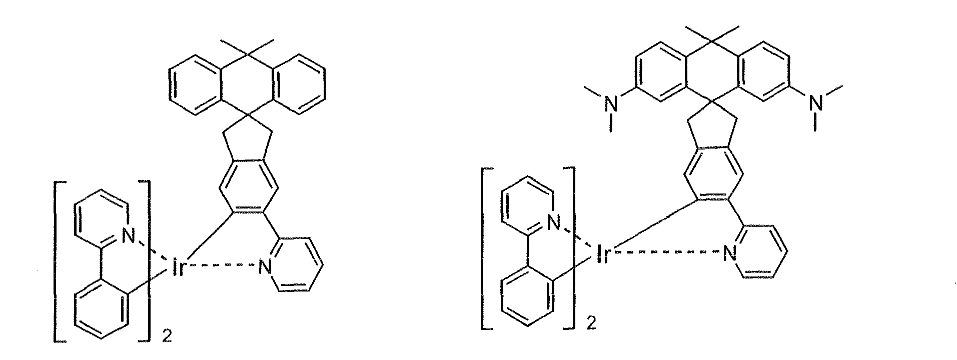

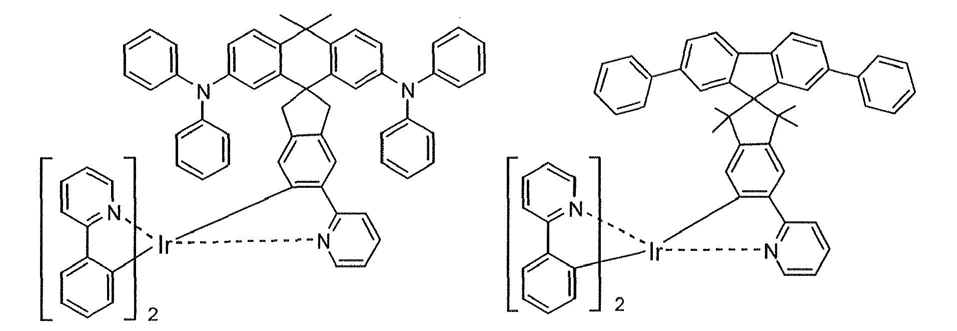

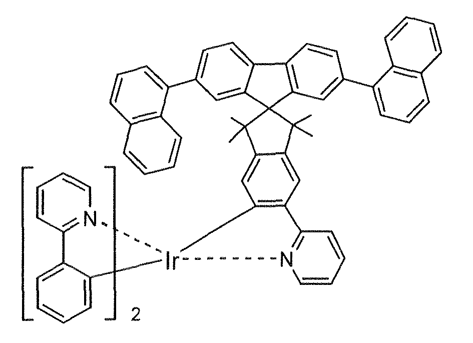

The material for an organic EL device of the present invention includes at least one having a compound represented by a following general formula (4'):

(E¹)-(C¹)ₚ₁-(C²)ₚ₂-(Phos)-(C³)ₚ₃-(C⁴)ₚ₄-(E²) (4').

In the general formula (4'), (Phos) represents a divalent group formed by removing two from among R¹ to R⁸. Z in the general formula (1') includes preferably one represented by the general formula (2'). E¹ and E² each independently represents a hydrogen atom, or a group selected from among a substituted or unsubstituted aromatic group having ring carbon atoms of 6 to 50, a substituted or unsubstituted aromatic heterocyclic group having ring atoms of 5 to 50, a substituted or unsubstituted alkyl group having carbon atoms of 1 to 50, a substituted or unsubstituted alkoxy group having carbon atoms of 1 to 50, a substituted or unsubstituted aralkyl group having carbon atoms of 7 to 50, a substituted or unsubstituted aryloxy group having ring atoms of 5 to 50, a substituted or unsubstituted arylthio group having ring atoms of 5 to 50, a substituted or unsubstituted alkoxycarbonyl group having carbon atoms of 1 to 50, a carboxyl group, a halogen atom, a cyano group and a hydroxy group. C¹ to C⁴ each independently represents a group selected from a substituted or unsubstituted alkylene group having 1 to 50 carbon atoms and a substituted or unsubstituted divalent aryl group having 6 to 50 carbon atoms; p1 to p4 each independently represents an integer of from 0 to 20, preferably from 0 to 5.

Examples of the substituted or unsubstituted aromatic group having 6 to 50 ring carbon atoms represented independently by E¹ and E² each include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, p-terphenyl-4-yl group, p-terphenyl-3-yl group, p-terphenyl-2-yl group, m-terphenyl-4yl group, m-terphenyl-3-yl group, m-terphenyl-2-yl group, o-tolyl group, m-tolyl group, p-tolyl group, p-t-butylphenyl group, p-(2-phenylpropyl) phenyl group, 3-methyl-2-naphthyl group, 4-methyl-1-naphthyl group, 4-methyl-1-anthryl group, 4'-methylbiphenyl-yl group, 4"-t- butyl-p-terphenyl-4-yl group, fluorenyl group, 9,9-dihexylfluorenyl group, 9,9-dioetylfluorenyl group and the like.

Examples of the substituted or unsubstituted aromatic heterocyclic group having 5 to 50 ring atoms include 1-pyrrolyl group, 2-pyrrolyl group, 3-pyrrolyl group, pyradinyl group, pyrimidyl group, pyridazyl group, 2-pyridinyl group, group, 3-pyridinyl group, 4-pyridinyl group, 1-indolyl group, 2-indolyl group, 3-indolyl group, 4-indolyl group, 5-indolyl group, 6-indolyl group, 7-indolyl group, 1-isoindolyl group, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrohn-8-yl group, 1,7-phenanthrolin-9-yl group, 1,7-phenanthrolin-10-yl group, 1,8-phenanthrolin-2-yl group, 1,8-phenanthrohn-3-yl group, 1,8-phenanthrolin-4-yl group, 1,8-phenanthrohn-5-yl group, 1,8-phenanthrohn-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrohn-4-yl group, 1,9-phenanthrohn-5-yl group, 1,9-phenanthrolin-6-yl group, 1,9-phenanthrolin-7-yl group, 1,9-phenanthrohn-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4yl group, 2,9-phenanthrolin-5-yl group, 2,9-phenanthrohn-6-yl group, 2,9-phenanthrohn-7-yl group, 2,9-phenanthrolin-8-yl group, 2,9-phenanthroHn-10-yl group, 2,8-phenanthrolin-1-yl group, 2,8-phenanthrolin-3-yl group, 2,8-phenanthrolin-4-yl group, 2,8-phenanthrohn-5-yl group, 2,8-phenanthrohn-6-yl group, 2,8-phenanthrolin-7-yl group, 2,8-phenanthrohn-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 2-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methyl- pyrrol-5-yl group, 3-methylpyrrol-1-yl group, 3-methylpyrrol-2-yl group, 3-methylpyrrol-4-yl group, 3-methylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl- 3-indolyl group and 4-t-butyl-3-indolyl group and the like.

Examples of the substituted or unsubstituted alkyl group having 1 to 50 carbon atoms include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy- isopropyl group, 2,3-dihydroxy-t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triamino- propyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyano-propyl group, nitromethyl group, 1-nitroethyl group, 2-nitroethyl group, 2-nitroisobutyl group, 1,2-dinitroethyl group, 1,3-dinitroisopropyl group, 2,3-dinitro-t-butyl group, 1,2,3-trinitropropyl group, cyclopropyl group, cyclobutyl group, cyclopentyl group, cyclohexyl group, 4-methylcyclohexyl group, 1-adamanthyl group, 2-adamanthyl group, 1-norbornyl group, 2-norbornyl group and the like.

The substituted or unsubstituted alkoxyl group having 1 to 50 carbon atoms is a group expressed by -OY. Examples of the group represented by Y include methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxy-isopropyl group, 2,3-dihydroxy- t-butyl group, 1,2,3-trihydroxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1.-iodoethyl group, 2-iodoethyl group, 2-iodoisobutyl group, 1,2-diiodoethyl group, 1,3-diiodoisopropyl group, 2,3-diiodo-t-butyl group, 1,2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 2-nitroisobutyl group, 1,2-dinitro- ethyl group, 1,3-dinitroisopropyl group, 2,3-dinitro-t-butyl group, 1,2,3-trinitropropyl group and the like.

Examples of the substituted or unsubstituted aralkyl group having 7 to 50 carbon atoms include benzyl group, 1-phenylethyl group, 2-phenylethyl group, 1-phenyl-isopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenyhsopropyl group, 1-chloro-2-phenyhsopropyl group and the like.

The substituted or unsubstituted aryloxy group having 5 to 50 ring atoms is a group expressed by -OY'. Examples of the group represented by Y' include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, 2-pyrrolyl group, 3-pyrrolyl group, pyradinyl group, 2-pyridinyl group, 3-pyridinyl group, 4-pyridinyl group, 2-indolyl group, 3-indolyl group, 4-indolyl group, 5-indolyl group, 6-indolyl group, 7-indolyl group, 1-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 3-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoquinolyl group, 5-isoquinolyl group, 6-isoquinolyl group, 7-isoquinolyl group, 8-isoquinolyl group, 2-quinoxanyl group, 5-quinoxanyl group, 6-quinoxanyl group, 1-carbazolyl group, 2-carbazolyl group, 3-carbazolyl group, 4-carbazolyl group, 1-phenanthridinyl group, 2-phenanthridinyl group, 3-phenanthridinyl group, 4-phenanthridinyl group, 6-phenanthridinyl group, 7-phenanthridinyl group, 8-phenanthridinyl group, 9-phenanthridinyl group, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthrolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrohn-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-pbenanthrohn-3-yl group, 2,7-phenanthrohn-4-yl group, 2,7-phenanthrolin-5yl group, 2,7-phenanthrohn-6-yl group, 2,7-phenanthrohn-8-yl group, 2,7-phenanthrolin-9-yl group, 2,7-phenanthrolin-10-yl group, l-phenazinyl group, 2-phenazinyl group, 1-phenothiazinyl group, 2-phenothiazinyl group, 3-phenothiazinyl group, 4-phenothiazinyl group, 1-phenoxazinyl group, 2-phenoxazinyl group, 3-phenoxazinyl group, 4-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methyl- pyrrol-5-yl group, 3-methylpyrrol-1-yl group, 3-methyl- pyrrol-2-yl group, 3-methylpyrrol-4-yl group, 3nnethylpyrrol-5-yl group, 2-t-butylpyrrol-4-yl group, 3-(2-phenylpropyl)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group and the like.

The substituted or unsubstituted arylthio group having 5 to 50 ring atoms is expressed by -SY' and examples of Y' include the same as aforementioned.

The substituted or unsubstituted alkoxycarbonyl group having 1 to 50 ring carbon atoms is represented by -COOY and examples of Y include the same as aforementioned.

Examples of the substituted or unsubstituted alkylene group having 1 to 50 carbon atoms represented independently by C¹ to C⁴ each include methylene group, ethylene group, propylene group, isopropylene group, n-butylene group, s-butylene group, isobutylene group, dimetylmethylene group, n-pentylene group, n-hexylene group, n-heptylene group, n-octylene group, chloromethylene group, 1-chloroethylene group, 2-chloroethylene group, 2-chloroisobutylene group, 1,2-dichloroethylene group, 1,3-dichloroisopropylene group, 1,2,3-trichloropropylene group, bromomethylene group, 1-bromoethylene group, 2-bromoethylene group, 2-bromoisobutylene group, 1,2-dibromoethylene group, 1,3-dibromoisopropylene group, 1,2,3-tribromopropylene group, iodomethylene group, 1-iodoethylene group, 2-iodoethylene group, 2-iodoisobutylene group, 1,2-diiodoethylene group, 1,3-diiodoisopropylene group, 1,2,3-triiodopropylene group, cyclopropylene group, cyclobutylene group, cyclopentylene group, cyclohexylene group, 4-methylenecyclohexylene group, adamantane-1, 1-diyl group, adamantane-1, 3-diyl group and the like.

Examples of a substituted or unsubstituted divalent arylene having carbon atoms of 6 to 50 represented independently by C¹ to C⁴ each include the following.

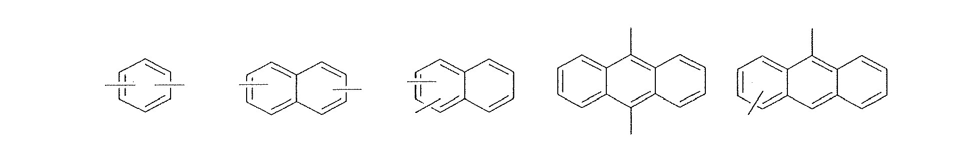

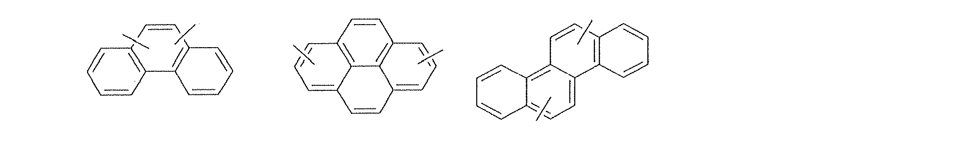

Examples of a compound represented by the general formula (4') are shown as follows, but not limited thereto.

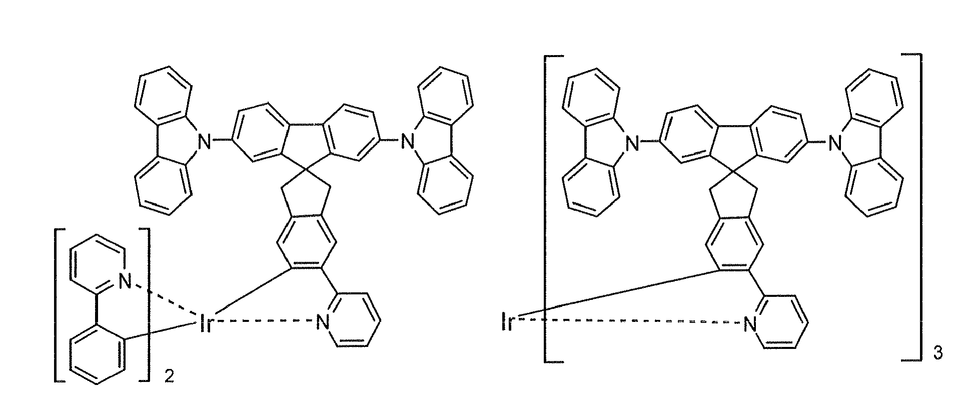

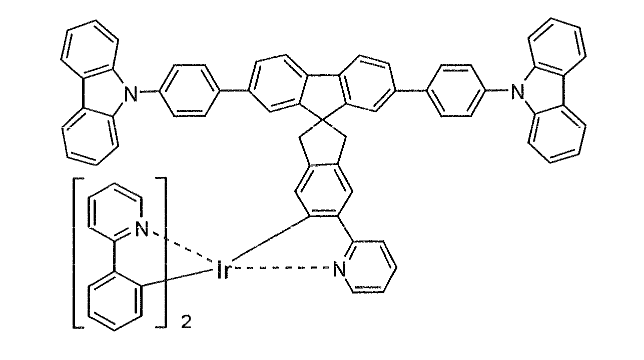

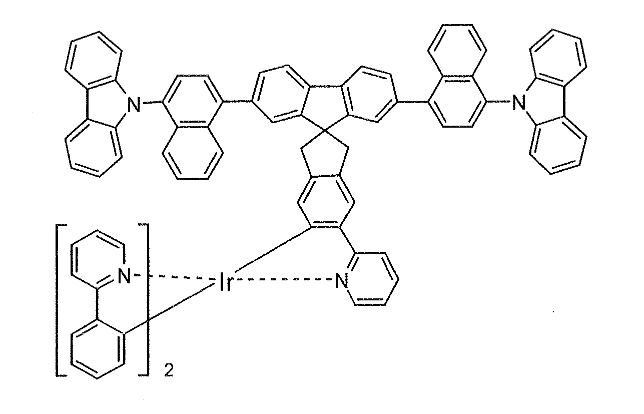

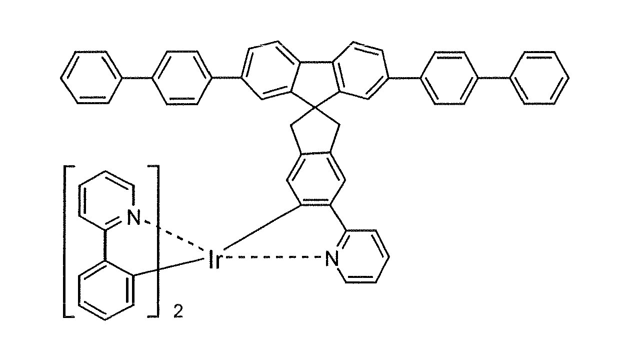

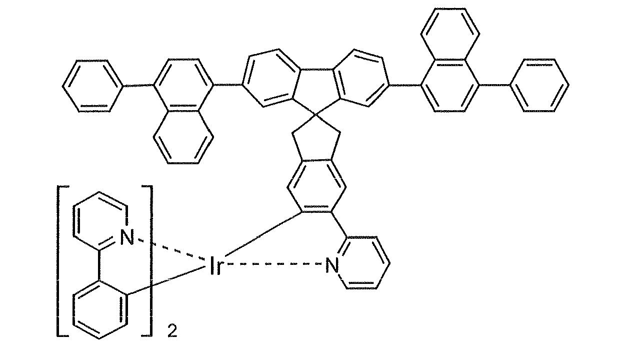

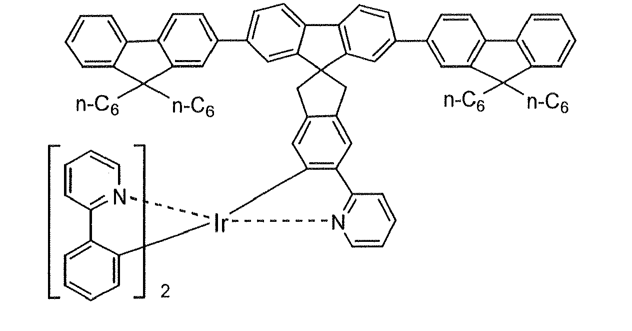

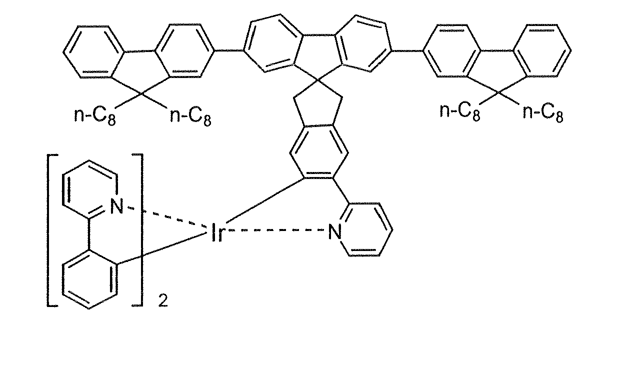

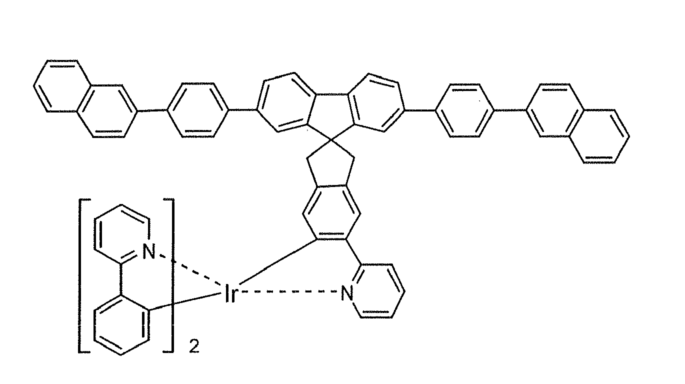

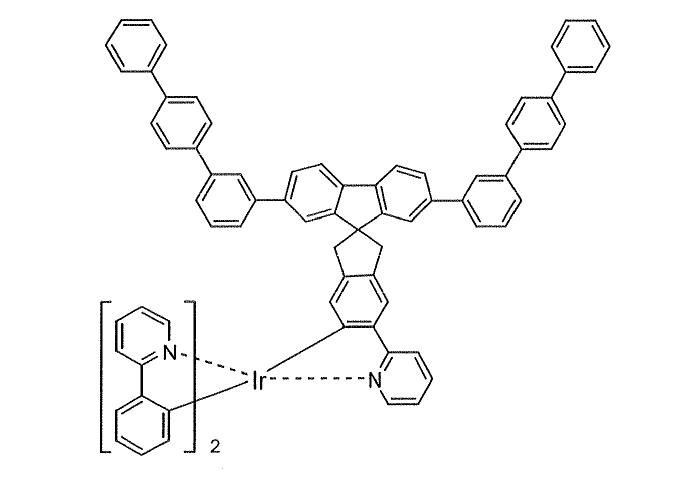

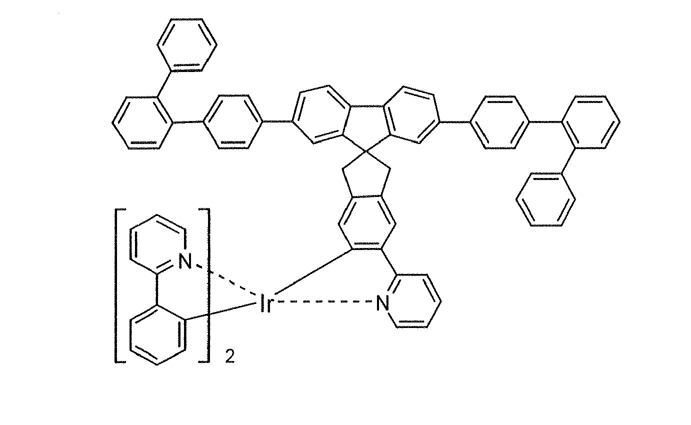

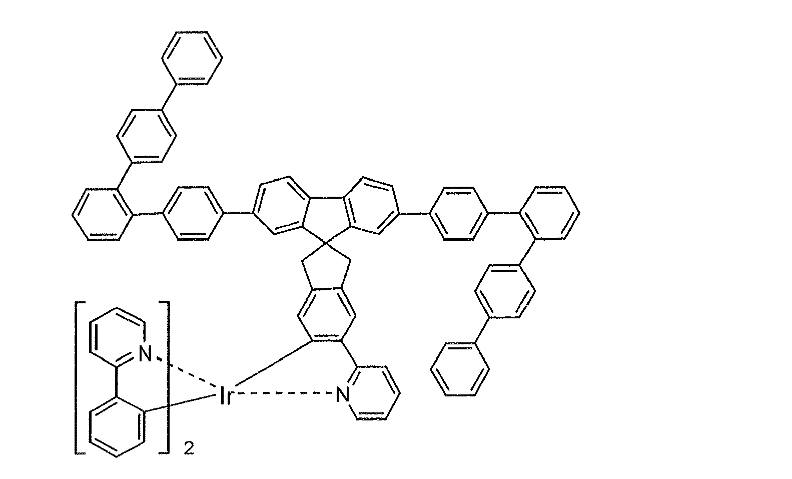

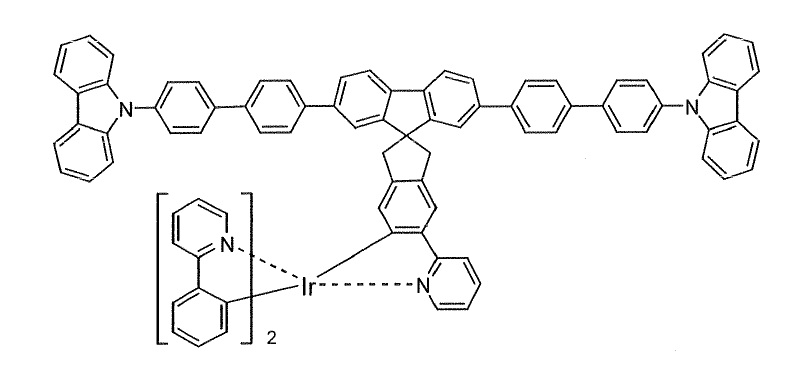

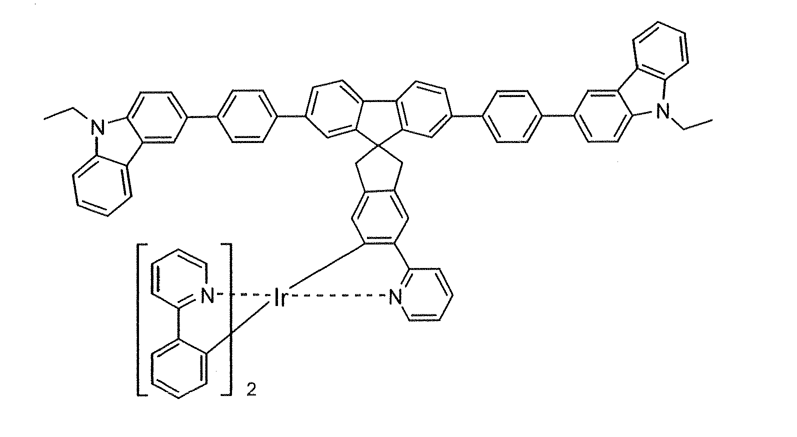

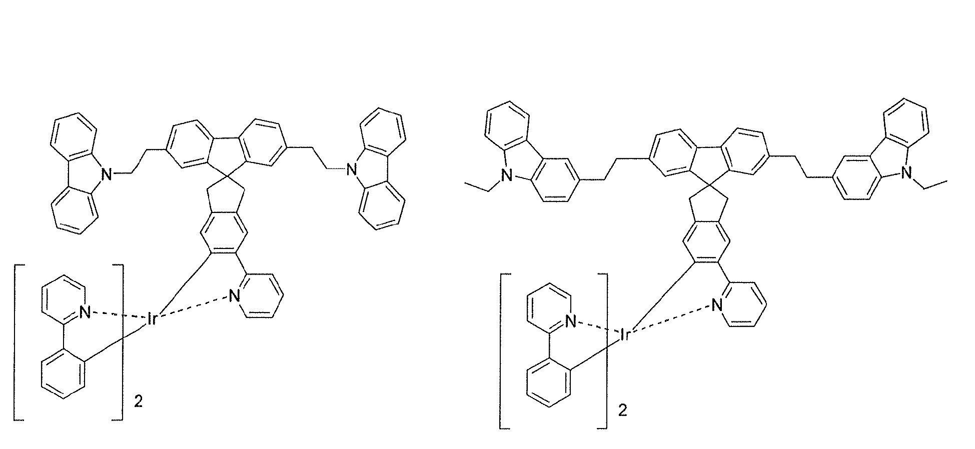

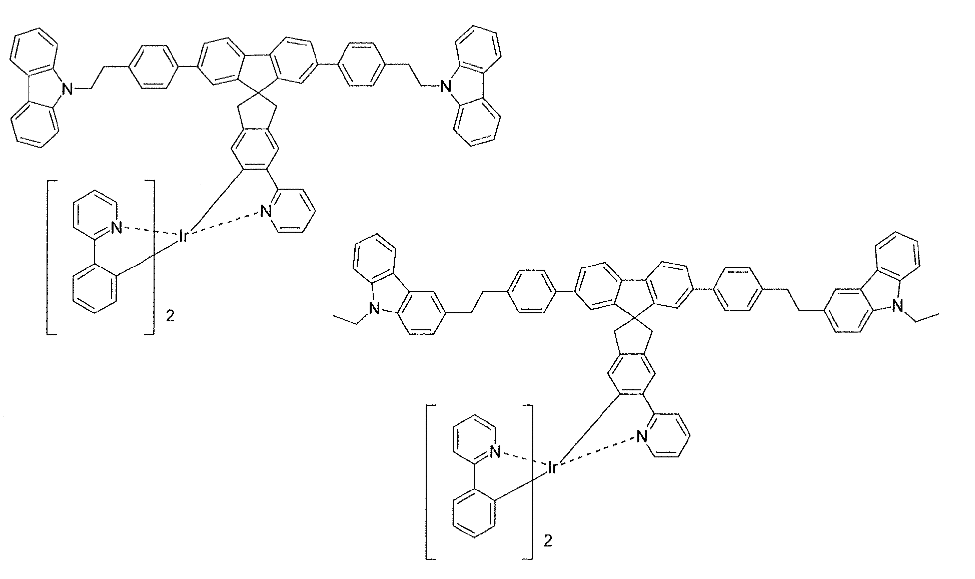

Further, a material for an organic EL device of the present invention includes a material containing a following polymer A or a following polymer B.

The polymer A comprises a polymer formed by polymerizing or copolymerizing a compound represented by the general formula (1'), and at least one among R¹ to R⁸ of the formula (1') is an aromatic group having ring carbon atoms of 6 to 50 containing a polymerizable group or a copolymerizable group. A polymerizable group includes a vinyl group, an epoxy group and the like, preferably a vinyl group.

The following shows examples of the polymer A, but not limited thereto.

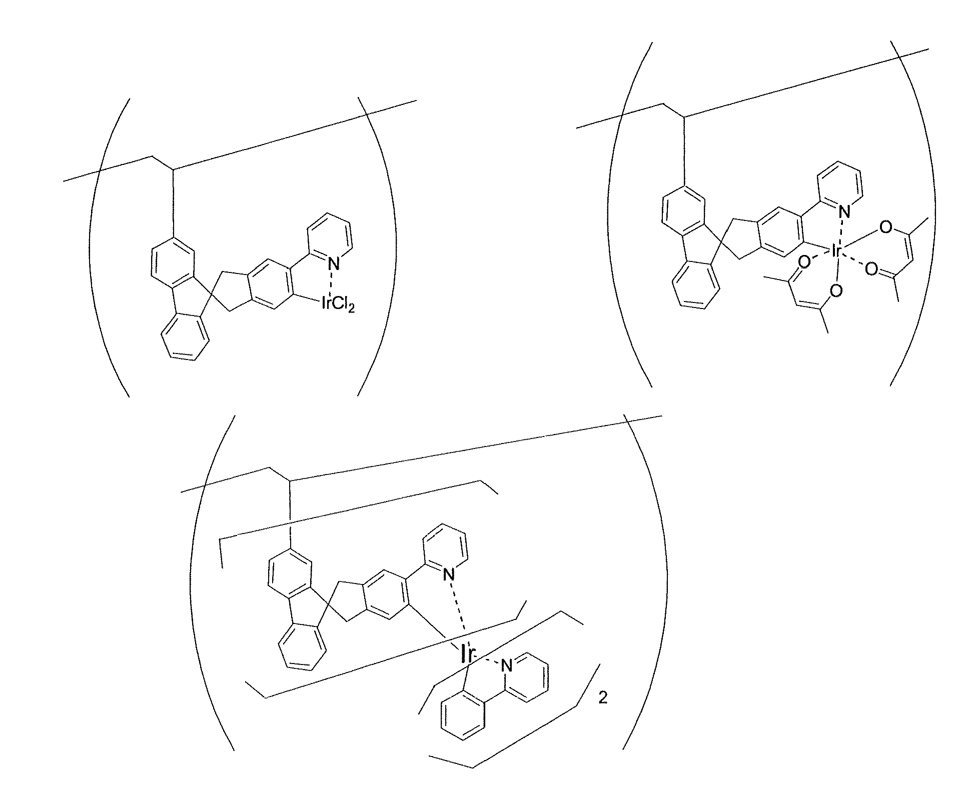

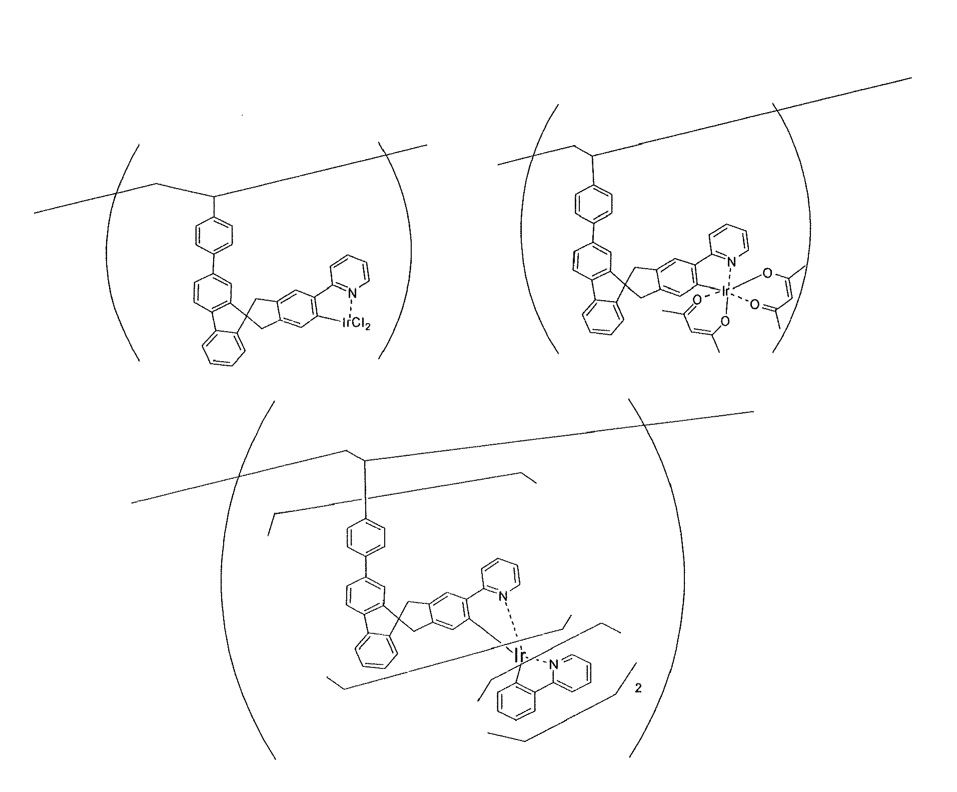

A copolymerizable comonomer includes a compound having a polymerizable vinyl group. The following is preferable compounds having a polymerizable vinyl group. In addition, plural comonomer thereof, if required, may be copolymerized.

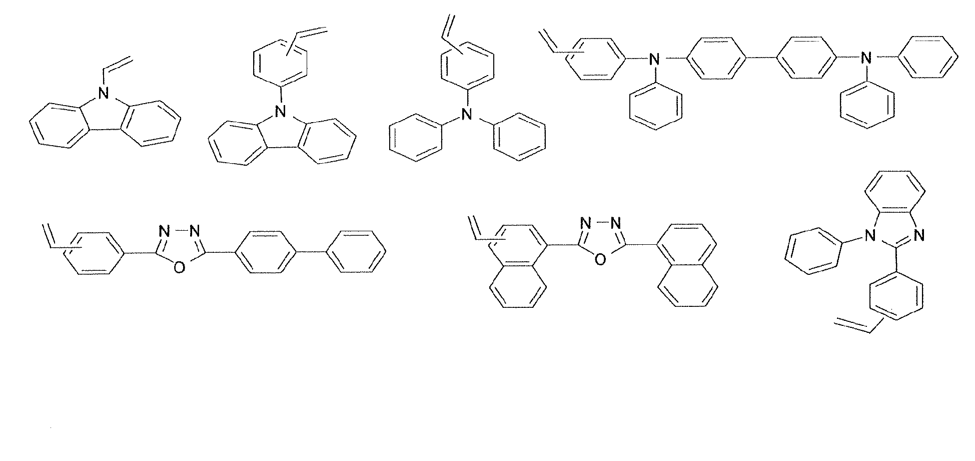

Examples of the copolymers are shown as follows, but not limited thereto.

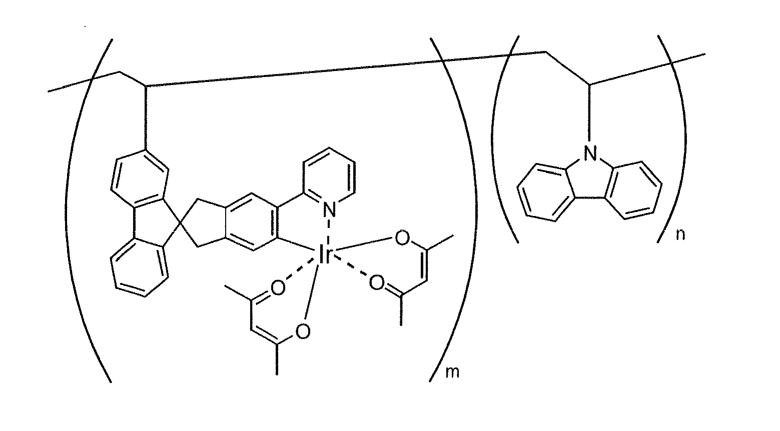

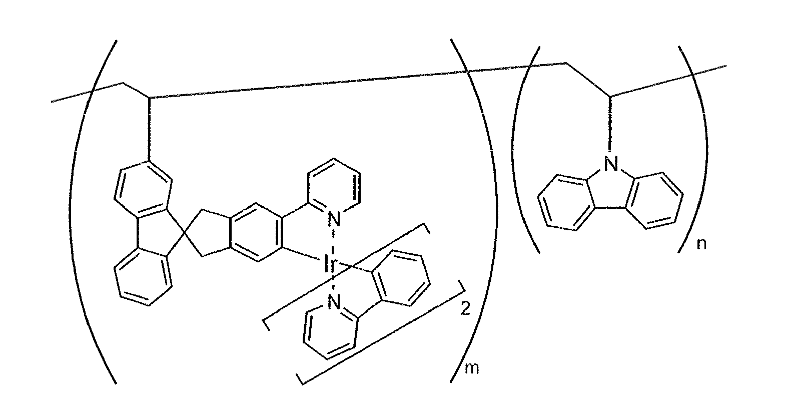

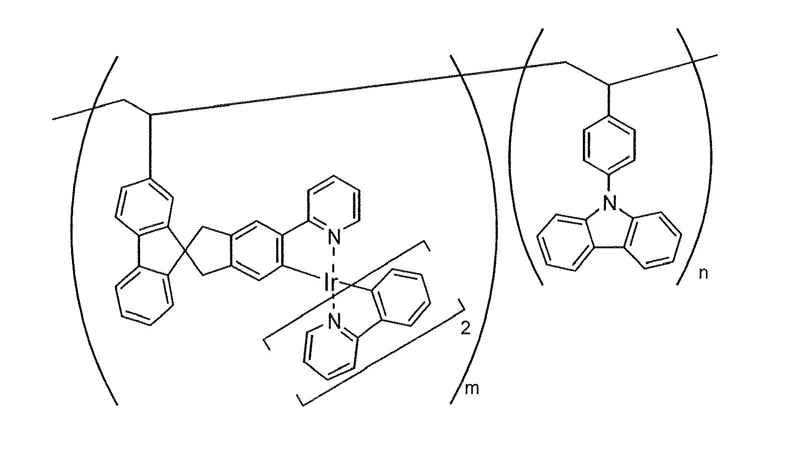

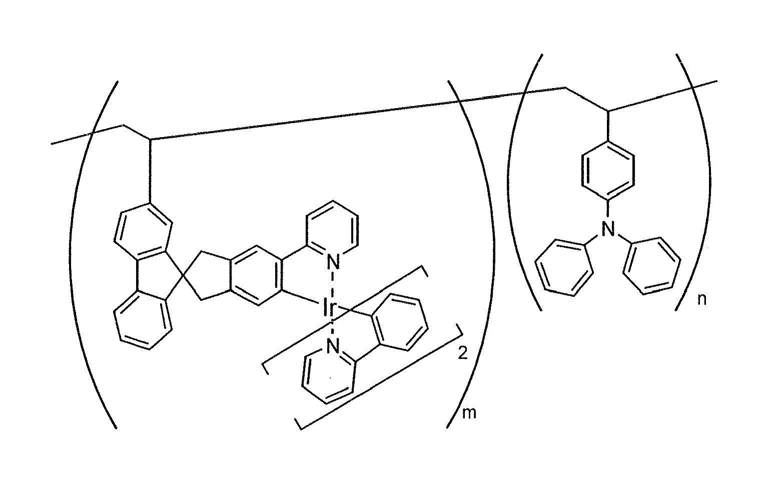

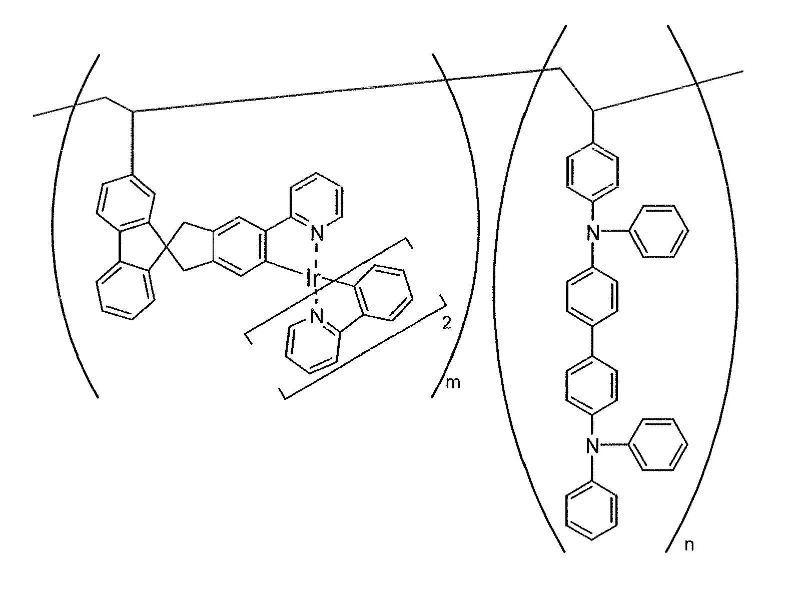

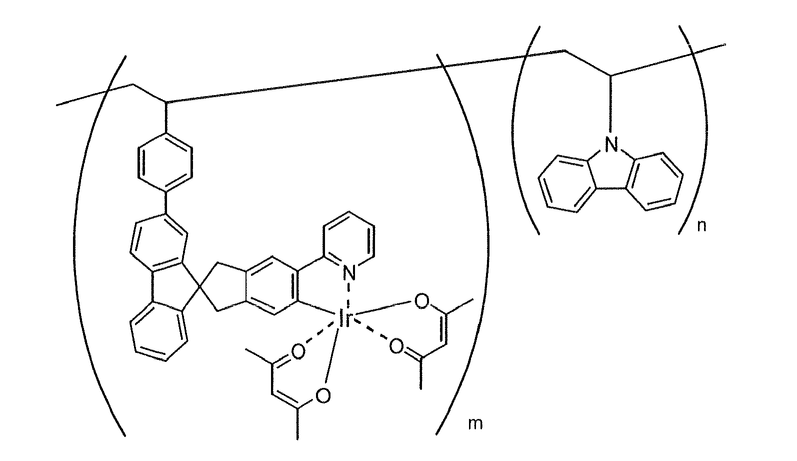

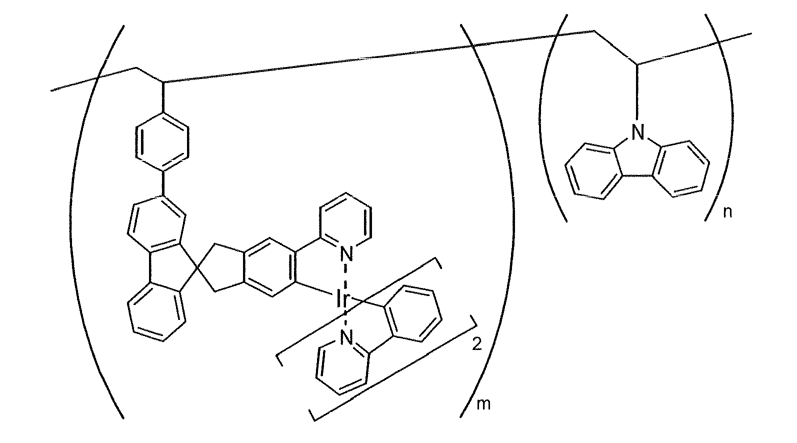

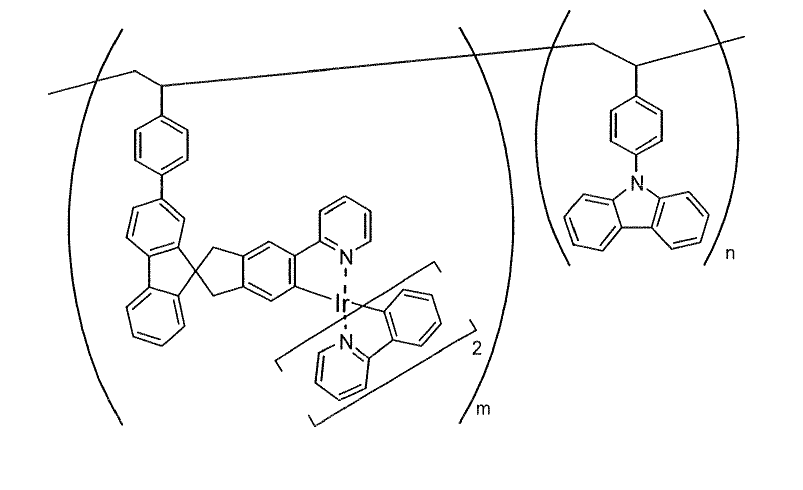

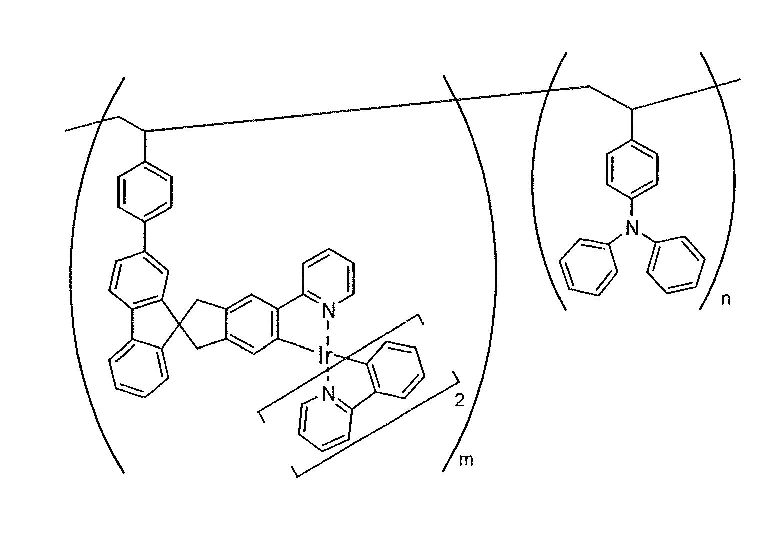

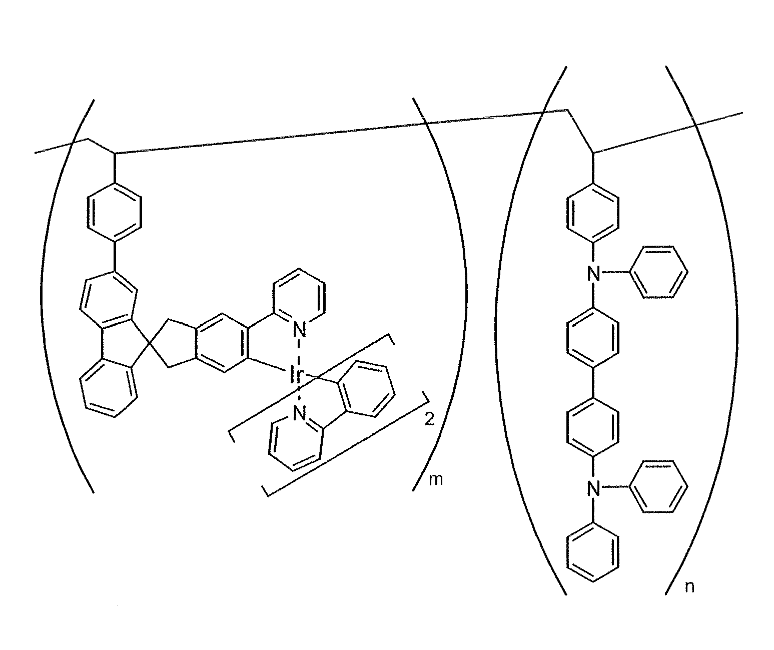

The polymer B comprises a polymer or a copolymer containing a unit structure of a divalent group formed by removing two selected from among R¹ to R⁸ in the general formula (1'). The following is example of the unit structure:

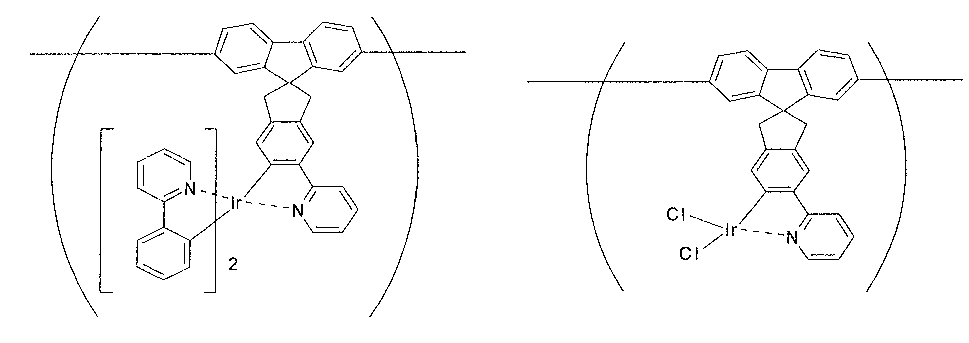

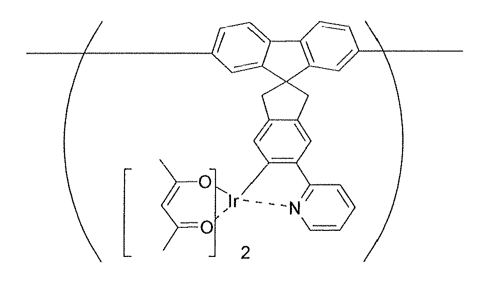

A copolymerizable comonomer includes preferably a substituted or unsubstituted divalent aromatic group having ring carbon atoms 6 to 50, a substituted or unsubstituted divalent aromatic heterocyclic group having ring carbon atoms of 5 to 50, and a divalent triarylamine derivative having carbon atoms of 18 to 50, and further plural comonomer thereof may be copolymerized. Moreover, followings are preferable comonomer units.

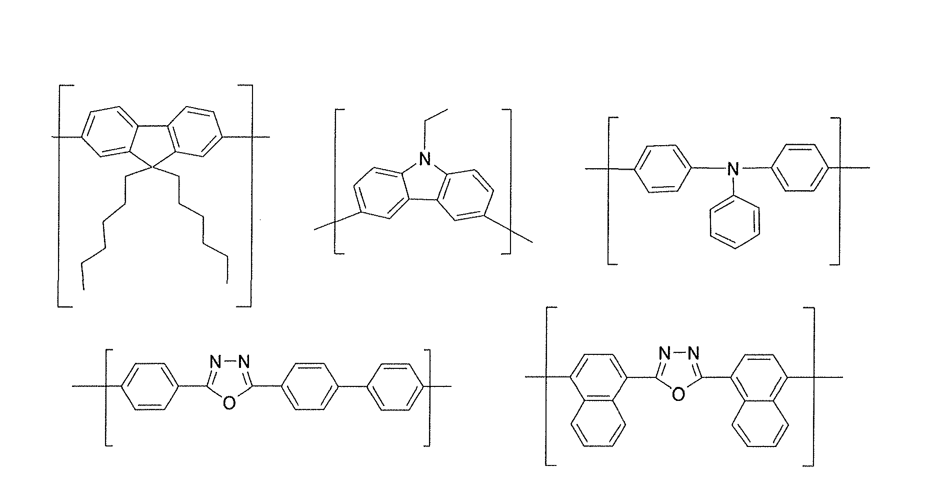

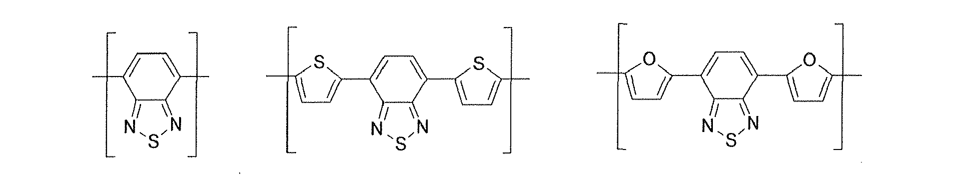

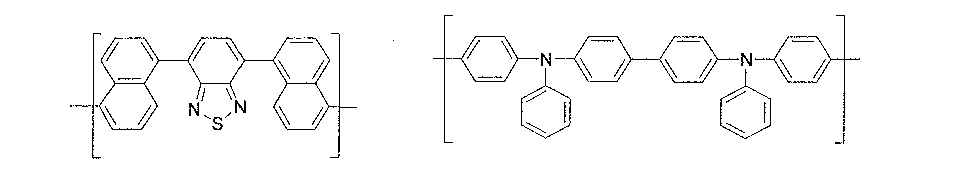

Molecular weight of the polymer A or the polymer B is preferably 1,000 to 3,000,000, more preferably 1,000 to 1,000,000. Examples of the polymer B including the copolymer are shown as follows, but not limited thereto.

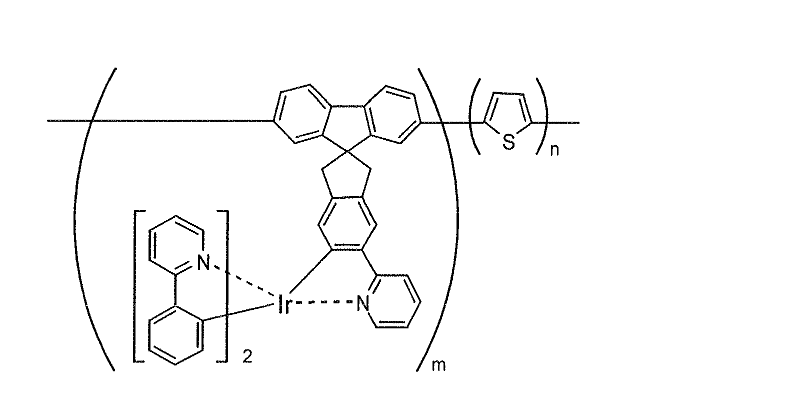

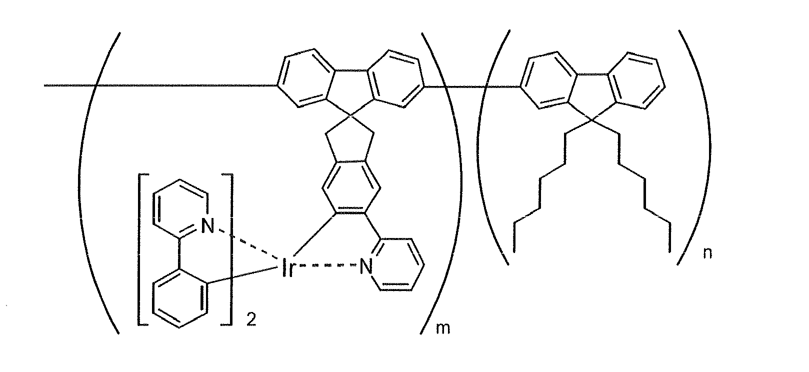

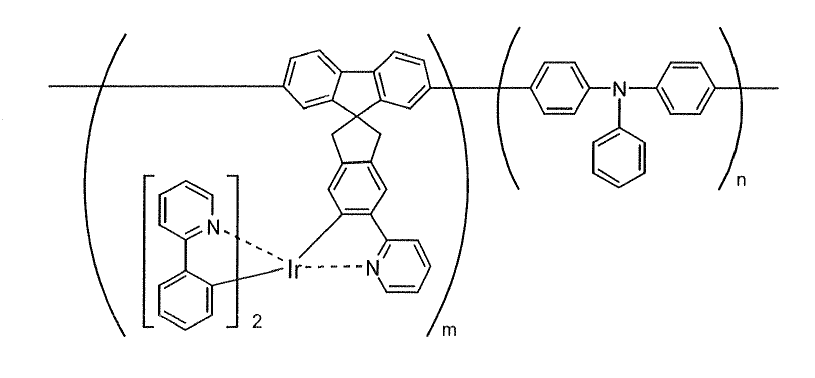

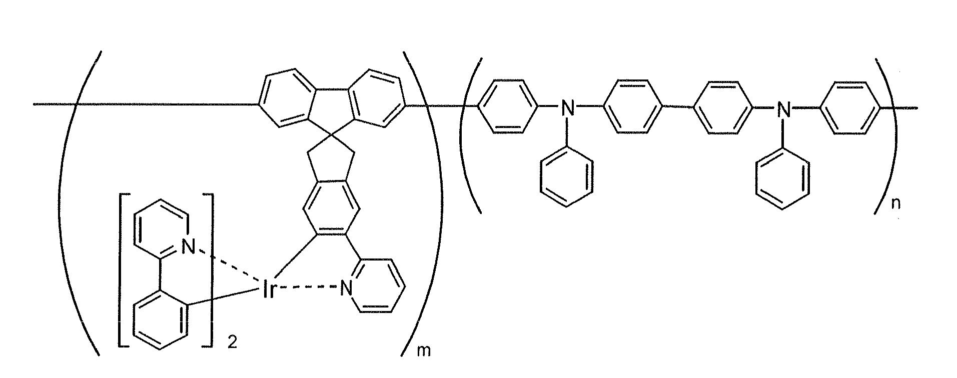

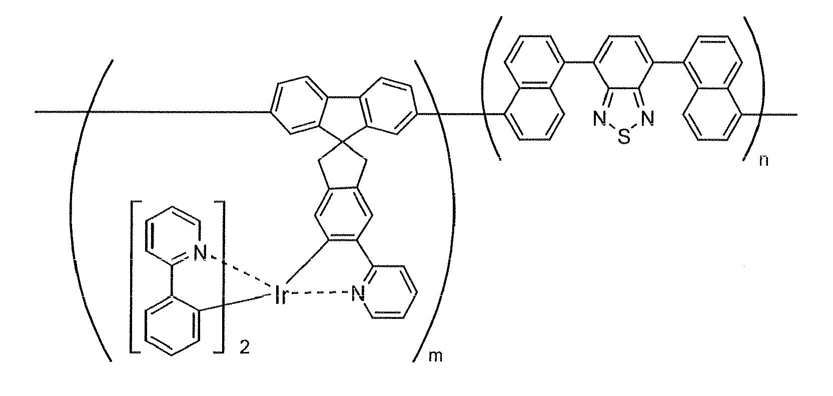

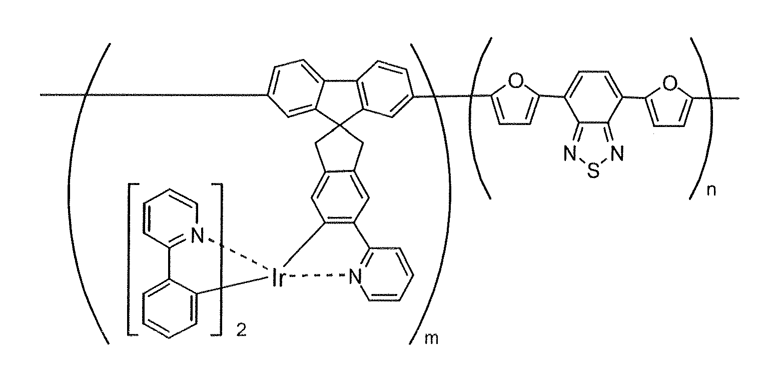

Following is a description regarding a device structure about the organic EL device of the present invention.

The present invention provides an organic EL device which comprises at least one organic thin film layer sandwiched between a pair of electrodes consisting of an anode and a cathode, wherein at least one organic thin film layer comprises the foregoing coordination metal compound or the foregoing material for the organic EL device.

Typical examples of the construction of the organic EL device of the present invention include:
(1) An anode / a light emitting layer / a cathode;
(2) An anode / a hole injecting layer / a light emitting layer / a cathode;
(3) An anode / a light emitting layer / an electron injecting layer / a cathode;
(4) An anode / a hole injecting layer / a light emitting layer / an electron injecting layer / a cathode;
(5) An anode / an organic semiconductor layer / a light emitting layer / a cathode;
(6) An anode / an organic semiconductor layer / an electron barrier layer / a light emitting layer / a cathode;
(7) An anode / an organic semiconductor layer / a light emitting layer / an adhesion improving layer / a cathode;
(8) An anode / a hole injecting layer / a hole transporting layer / a light emitting layer / an electron injecting layer / a cathode;
(9) An anode / an insulating layer / a light emitting layer / an insulating layer / a cathode;
(10) An anode / an inorganic semiconductor layer / an insulating layer / a light emitting layer / an insulating layer / a cathode;
(11) An anode / an organic semiconductor layer / an insulating layer / a light emitting layer / an insulating layer / a cathode;
(12) An anode / an insulating layer / a hole injecting layer / a hole transporting layer / a light emitting layer / an insulating layer / a cathode; and
(13) An anode / an insulating layer / a hole injecting layer / a hole transporting layer / a light emitting layer / an electron injecting layer / a cathode.

However, the construction of the organic EL device is not limited to those shown above as the examples.

It is preferable, but not limited thereto, for the organic EL device of the present invention to employ the material of the present invention as a constituting material for the light emitting layer. In the case of that the compound having a spiro bond of the present invention is employed in the light emitting layer, the compound can be usually used with various organic materials employed for the organic EL device in combination. It is particularly preferable to employ an amine compound having a styryl group or an arylamine compound as a dopant.

In general, it is preferable that the organic EL device is fabricated on a substrate which transmits light. It is preferable that the substrate which transmits light has a transmittance of light of 50% or greater in the visible region of 400 to 700 nm. It is also preferable that a flat and smooth substrate is employed.

As the substrate which transmits light, for example, glass sheet and synthetic resin sheet are advantageously employed. Specific examples of the glass sheet include soda ash glass, glass containing barium and strontium, lead glass, aluminosilicate glass, borosilicate glass, barium borosilicate glass and quartz. Specific examples of the synthetic resin sheet include sheet made of polycarbonate resins, acrylic resins, polyethylene terephthalate resins, polyether sulfide resins and polysulfone resins.

The anode in the organic EL device of the present invention covers a role of injecting holes into a hole transport layer or into a light emitting layer, and it is effective that the anode has a work function of 4.5 eV or greater. Specific examples of the material for the anode include indium tin oxide (ITO) alloy, tin oxide (NESA), gold, silver, platinum, copper, etc. With regard to the cathode, it is preferable that a material has a small work function with the objective of injecting electrons into an electron transport layer or into a light emitting layer.

The anode can be prepared by forming a thin film of the electrode material described above in accordance with a process such as a vapor deposition process or a sputtering process.

When the light emitted from the light emitting layer is observed through the anode, it is preferable that the anode has a transmittance of the emitted light greater than 10 %. It is also preferable that the sheet resistivity of the anode is several hundred Ω/□ or smaller. The thickness of the anode is, in general, selected in the range of from 10 nm to 1 µm and preferably in the range of from 10 to 200 nm.

It is preferable that an organic device of the present invention has a hole transporting layer between the light emitting layer and the anode, and the hole transporting layer contains an arylamine derivative as an essential component. In addition, a hole transporting material to be contained in a hole transporting layer has preferably a triplet energy of 2.52 to 3.7 eV, more preferably 2.8 to 3.7 eV By using a hole transporting material in the range of the above, it is possible to avoid deactivation of excitation energy of a light emitting layer.

The hole transportation material includes preferably a material represented by the general formulae (A) and (B): 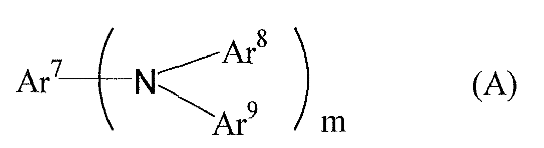 wherein, Ar⁷ represents an aromatic group having carbon atoms of 6 to 40, Ar⁸ and Ar⁹ each independently represents a hydrogen atom or an aromatic group having carbon atoms of 6 to 40, and m represents an integer of from 1 to 6. 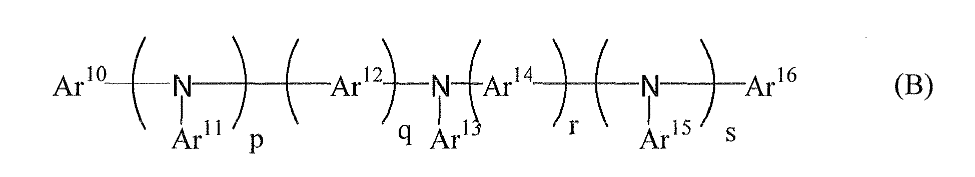 wherein, Ar¹⁰ and Ar¹⁶ each independently represents an aromatic group having carbon atoms of 6 to 40, Ar¹¹ to Ar¹⁵ each independently represents a hydrogen atom or an aromatic group having carbon atoms of 6 to 40, and a condensation numbers of p, q, r and s each independently represents an integer of from 0 to 1.

In the general formulae (A) and (B), the preferable aryl group having 5 to 40 ring carbon atoms among the aromatic hydrocarbon groups having ring carbon atoms of 6 to 40 is a phenyl group, a naphthyl group, an anthranyl group, a phenanthryl group, a pyrenyl group, a coronyl group, a biphenyl group, a terphenyl group, a pyrrolyl group, a furanyl group, a thiophenyl group, a benz thiophenyl group, an oxadiazolyl group, a diphenyl anthranyl group, an indolyl group, a carbazolyl group, a pyridyl group, a benzoquinolyl group, a fluoranthenyl group, an acenaphthofluoranthenyl group and the like. In addition, preferable examples of the arylene group having carbon atoms of 5 to 40 include a phenylene group, a naphthylene group, an anthranylene group, phenanthrylene, a pyrenylene group, colonylene group, a biphenylene group, a terphenylene group, a pyrrolylene group, a furanylene group, a thiophenylene gorup, a benzothiophenylene group, an oxadiazolylene group, a diphenylanthranylene, an indolylene group, a carbazolylene group, a pyridilene group, a benzoquinolilene group, a fluolanthenylene group, acenaphthofluoranthenylene and the like. Moreover, an aromatic group having carbon atoms of 6 to 40 may be substituted by a substituent, and a preferable substituent includes an alkyl group having carbon atoms of 1 to 6 such as ethyl group, methyl group, i-propyl group, n-propyl group, s-butyl group, t-butyl group, pentyl group, hexyl group, cyclopentyl group and cyclohexyl group, an alkoxy group having carbon atoms of 1 to 6 such as ethoxy group, methoxy group, i-propoxy group, n-propoxy group, s-butoxy group, t-butoxy group, pentoxy group, hexyloxy group, cyclopentoxy group, cylcohexyloxy group, an aryl group having ring carbon atoms of 5 to 40, an amino group substituted by an aryl group having ring carbon atoms of 5 to 40, an ester group having an aryl group having ring carbon atoms of 5 to 40, an ester group having an alkyl group having carbon atoms of 1 to 6, a cyano group, a nitro group and a halogen atom.

In addition, a hole transporting material having triplets energy of 2.8 eV or larger includes preferably a material represented by following general formulae (C) to (E). 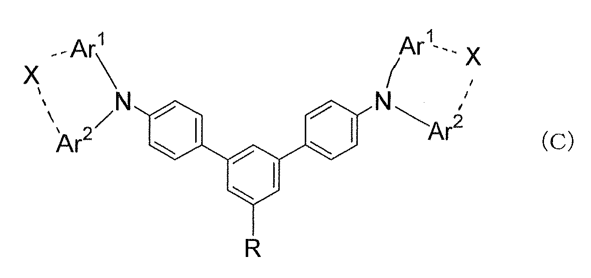 wherein, Ar¹ and Ar² each independently represents an alliyl group having carbon atoms of 1 to 6 and an aryl group having ring carbon atoms of 6 to 18 which may be substituted by an alkoxy group or a phenyl group, and R represents an alkyl group or an alkoxy group having carbon atoms of 4 to 6, or an aryl group having ring carbons of 6 to 18; X represents a single bond or an interconnection group represented by -O- or -S-, which may exist or not. 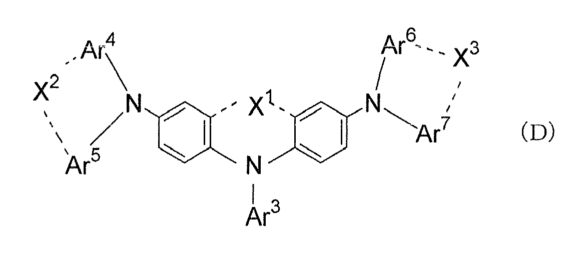 wherein, Ar³ represents an aryl group having ring carbon atoms of 6 to 18, which may be substituted; Ar⁴ to Ar⁷ each respectively represents arylene group having ring carbon atoms of 6 to 18, which may be substituted; X¹ represents a single bond or an interconnection bond of -O-, -S-, -(CH₂)ₙ- (n represents an integer of from 1 to 6) or -C(CH₃)₂- and the interconnection bond may exist or not; X² and X³ each independently represents a single bond, an connection bond of -O-, -S-, -(CH₂)ₙ-, n represents an integer of from 1 to 6 or -C(CH₃)₂-, and these may be the same with or different from each other.

In the general formulae (C) and (D), specific examples represented by each group and each substituent of Ar¹ to Ar⁷, **R, X** and X¹ to X³ includes the same as aforementioned about Ar¹ to Ar⁶. 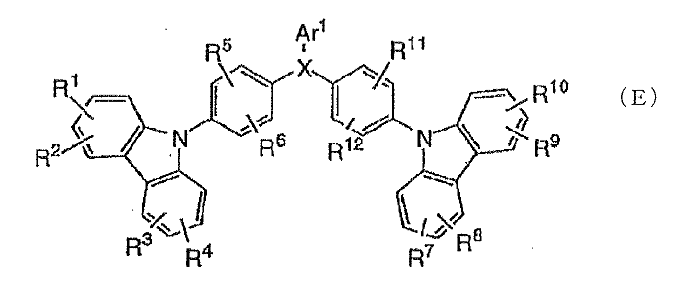 wherein, R¹ to R¹² each independently represents a hydrogen atom, a halogen atom, an alkyl group, an aralkyl group, an alkenyl group, a cyano group, an amino group, an acryl group, an alkoxycarbonyl group, a carboxyl group, an alkoxy group, an alkylamino group, an aralkylamino group, a haloalkyl group, a hydroxyl group, an aryloxy group, and an aromatic hydrocarbon ring group and an aromatic heterocyclic group which may be substituted, both R¹ and R², both R³ and R⁴, both R⁵ and R⁶, both R⁷ and R⁸, both R⁹ and R¹⁰, and both R¹¹ and R¹² each independently may form a ring of neighboring groups thereof; **X** represents a trivalent interconnection group as follows: 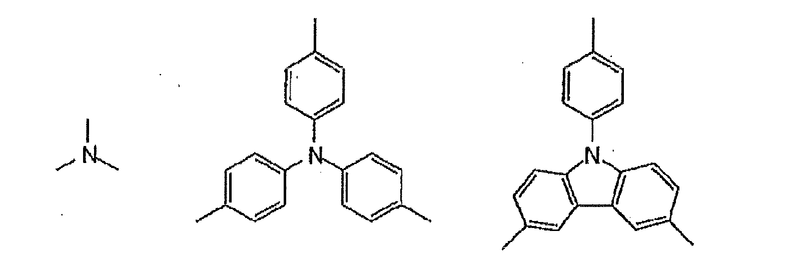 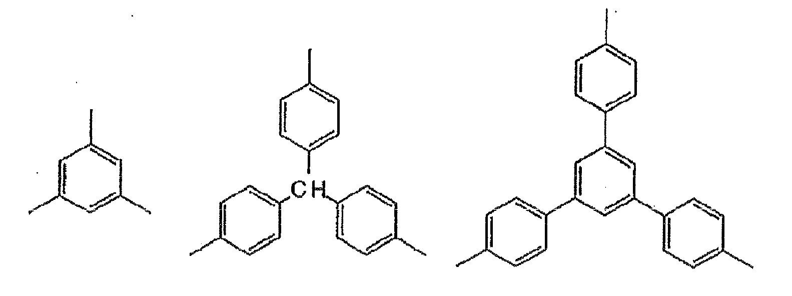 and Ar¹ is expressed by any one of an aromatic hydrocarbon ring group which may be substituted, an aromatic heterocyclic group which may be substituted or the general formula (F): 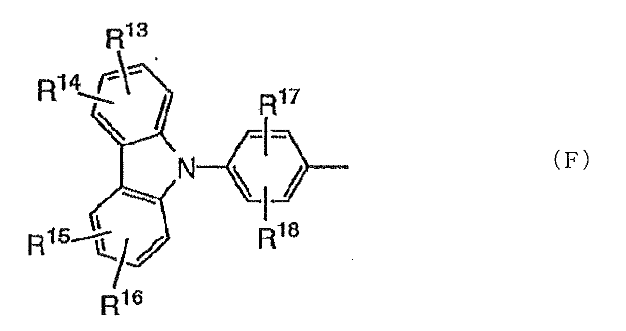 wherein, R¹³ to R¹⁸ each independently represents a hydrogen atom, a halogen atom, an alkyl group, an aralkyl group, an alkenyl group, a cyano group, an amino group which may be substituted, an acryl group, an alkoxycarbonyl group, a carboxyl group, an alkoxy group, an alkylamino group, an aralkylamino group, a haloalkyl group, a hydroxyl group, an aryloxy group, and an aromatic hydrocarbon ring group and an aromatic heterocyclic group which may be substituted, both R¹³ and R¹⁴, both R¹⁵ and R¹⁶, and both R¹⁷ and R¹⁸ each independently may form a ring of neighboring groups thereof. In the general formula (F), specific examples of each group and substituent represented by R¹³ to R¹⁸ include the same as aforementioned about Cz and Ar¹ to Ar⁶.

In the organic EL device of the present invention, a hole transportation layer is explained as aforementioned. In addition, an organic EL device of the present invention may has a further hole transportation layer. As a material for the further hole transportation layer, a material which transports holes to the light emitting layer at a small strength of the electric field is preferable. A material which exhibits, for example, a mobility of holes of at least 10⁻⁴ cm²/V · sec under application of an electric field of from 10⁴ to 10⁶ V/cm is preferable. Any arbitrary material selected from conventional material commonly used as a charge transporting material for the holes in photo conducting materials and well known material employed for the hole injecting layer in the EL device is usable.

As an hole injecting material, it is preferable that a compound has a hole transporting capabilit6y, a hole injecting effect from an anode, a excellent hole injecting effect to a light emitting layer or a light emitting material, and it has a prevention ability of excitons formed in the light emitting layer from transferring to an electron injecting layer or an electron injecting material and an excellent ability forming a thin film. Specific examples thereof include a phthalocyanine derivative, a naphthalocyanine derivative, a porphyrine derivative, oxazole, oxadiazole, triazole, imidazole, imidazolone, imidazolthion, pyrazoline, pyrazolone, tetrahydroimidazole, hydrazone, acylhydrazone, polyarylalkane, stilbene, butadiene, benzidine-base triphenylamine, styrylamine-base triphenylamine, diamine-base triphenylamine, diamine-base triphenylamine and the like, derivatives thereof, and polymer materials such as polyvinyl carbazole, polysilane, polyethylene dioxythiophene, polystyrene sulfonate, electroconductive polymer, but not to limited thereto.

Among the hole injecting materials, a further effective hole injecting material includes a aromatic tertiary amine derivative or a phthalocyanine derivative. Specific examples of aromatic tertiary amine include, triphenylamine, tritolylamine, tolyldiphenylamine, N,N'-diphenyl-N,N'-(3-methylphenyl)-1,1'-biphenyl-4,4'-diamine, N,N,N',N'-(4-methylphenyl)-1,1'-phenyl-4,4'-diamine, N,N,N',N'-(4-methylphenyl)-1,1'-biphenyl-4,4'-diamine, N,N'-diphenyl-N,N'-dinaphthyl-1,1'-biphenyl-4.4'-diamine, N,N'-(methylphenyl)-N,N'-(4-n-butylphenyl)-phenanthrene-9, 10-diamine, N,N'-bis(4-di-4-tolylaminophenyl)-4-phenyl-cyclohexane and the like, or oligomer or polymer having an aromatic tertiary amine skeleton structure thereof, but not limited thereto. Specific examples of a phthalocyanine derivative (Pc) include a phthalocyanine derivative such as H₂Pc, CuPc, CoPc, NiPc, ZnPc, PdPC, FePc, MnPc, ClAlPc, ClGaPc, ClInPc, ClSnPc, Cl₂SiPc, (HO)AlPc, (HO)GaPc, VOPc, TiOPc, MoOPc, GaPc-O-GaPc and a naphthalocyanine derivative, but not limited thereto.

For forming the hole injecting/transporting layer, a well known process such as the vapor deposition process, the spin coating process and the LB process can be employed so as to form a thin film of the aforementioned compounds. Although a film thickness for the hole injecting/transporting layer is not limited, it is generally 5 nm to 5 µ m. The hole injecting/transporting layer may be constructed by a layer comprising at least one of the aforementioned materials or by laminating a hole injecting/transporting layer comprising a different compound other than the aforementioned hole injecting/transporting layer.

In addition, an organic semiconductor layer is to help hole injection or electron injection into a light emitting layer, and a electric conductivity of 10⁻¹⁰ S/cm or greater thereof is preferable. With regard to a material for the organic semiconductor layer, an electroconductive oligomer such as an oligomer having thiophene, an oligomer having arylamine disclosed in Japanese Unexamined Patent Application Laid-Open No. 8-193191 and the like, electroconductive dendrimers such as a dendrimer having an arylamine dendrimer and the like are employable.

In the organic EL device of the present invention, the light emitting layer has the following functions:
(1) The injecting function: the function of injecting holes from the anode or the hole injecting layer and injecting electrons from the cathode or the electron injecting layer when an electric field is applied;
(2) The transporting function: the function of transporting injected charges (electrons and holes) by the force of the electric field; and
(3) The light emitting function: the function of providing the field for recombination of electrons and holes and leading the recombination to the light emission. Although there may be a difference between the capability of the holes being injected and the capability of the electrons being injected, and although there may be a grade about the transporting function expressed by mobility of the holes and the electrons, it is preferable to move charges of either ones.

As the process for forming the light emitting layer, a well known process such as the vapor deposition process, the spin coating process and the LB process can be employed.

In the present invention, any well known light emitting material such as PVK, PPV, CBP, Alq, BAlq and a well known complex other than the light emitting material comprising a coordination metal compound of the present invention or a light emitting material explained below may be optionally contained in the light emitting layer in an extent of not obstructing to achieve the objective of the present invention. Further, a compound of the present invention may be used without having a metal atom cordinated, and also such compound may be used together, as a mixture, with a compound of the present invention having a metal atom cordinated.

A compound to be contained in the light emitting layer includes, for example, a structure such as any of following general formulae (L1) to (L22). In addition, in the following structures, a phenyl part and a thiophene part include one substituted by an alkyl group or an aryl group having carbon atoms of 6 to 10.

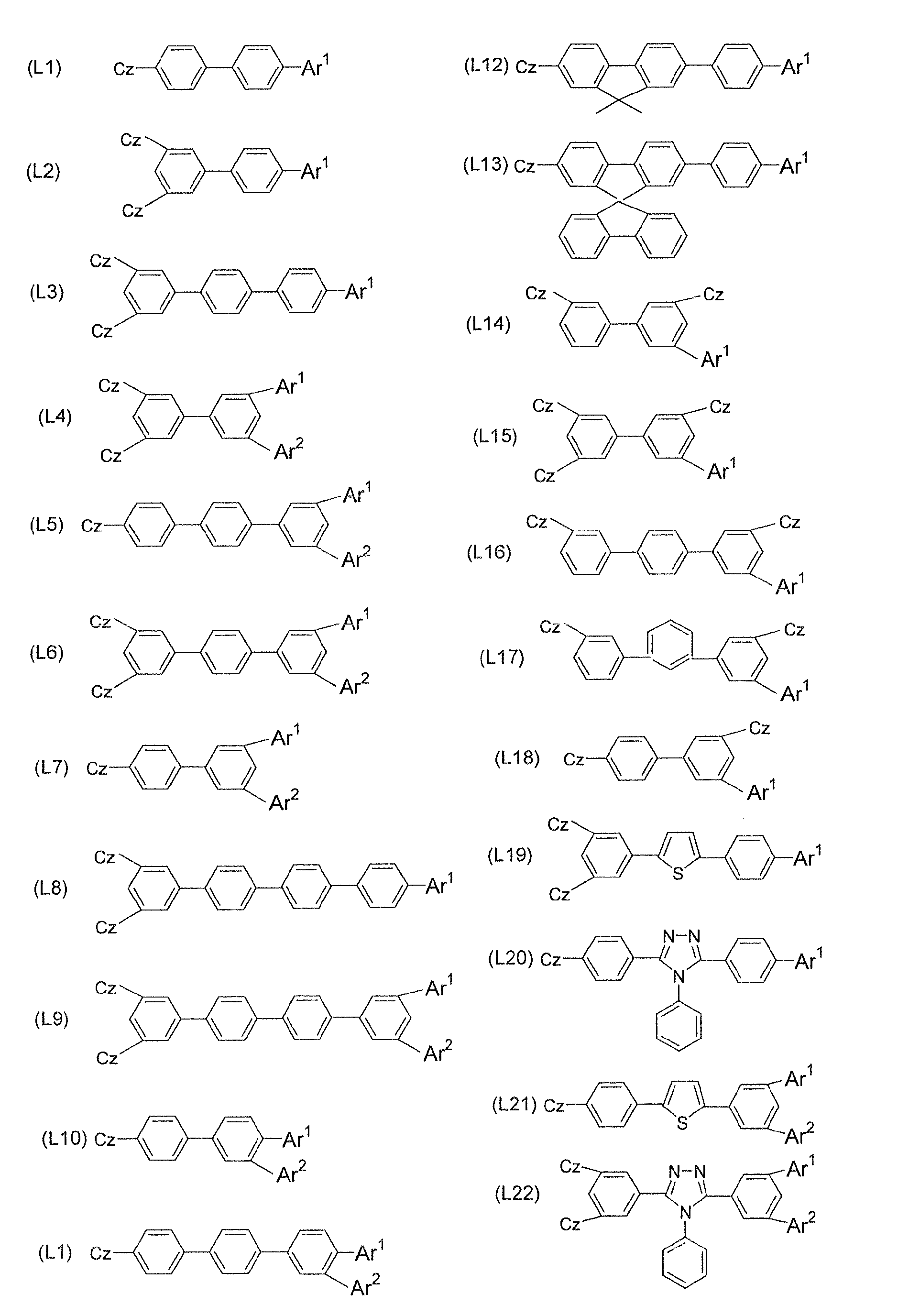

In the above general formulae, Cz includes a carbazolyl group, an arylacrbazoleyl group having carbon atoms of 16 to 60, an azacarbazolyl group, an arylazacarbazoleyl having carbon atoms of 18 to 60 group, an acridinyl group, a phenoxadinyl group or a dibenzoazevinyl group, which may be substituted. Ar¹ and Ar² each independently represents a substituted or unsubstituted aryl group having ring carbon atoms of 6 to 60 or a substituted or unsubstituted heterocyclic group having carbon atoms of 3 to 60.

Further, a light emitting material expressed by the general formulae (L1) to (L22) includes following compounds.

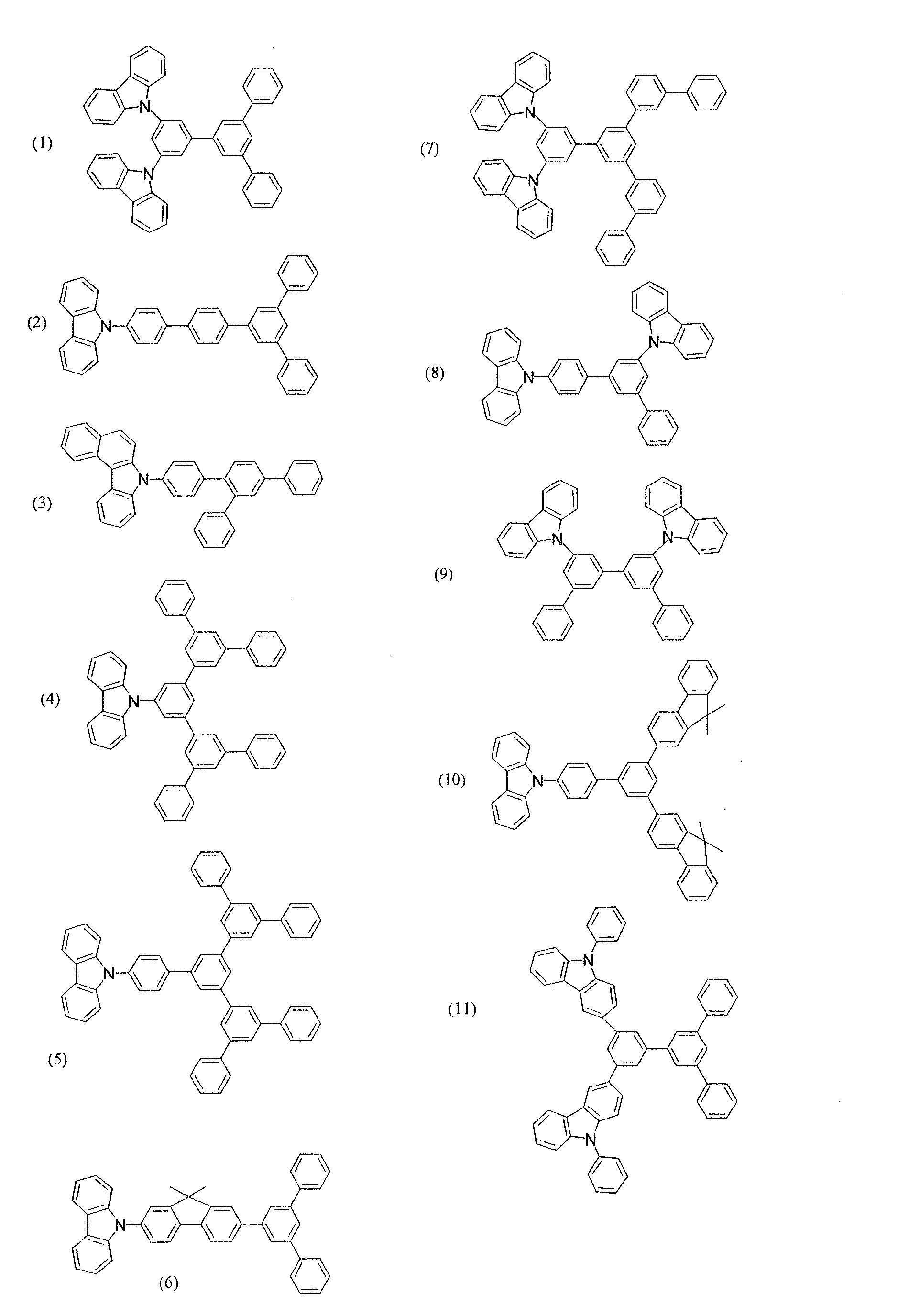

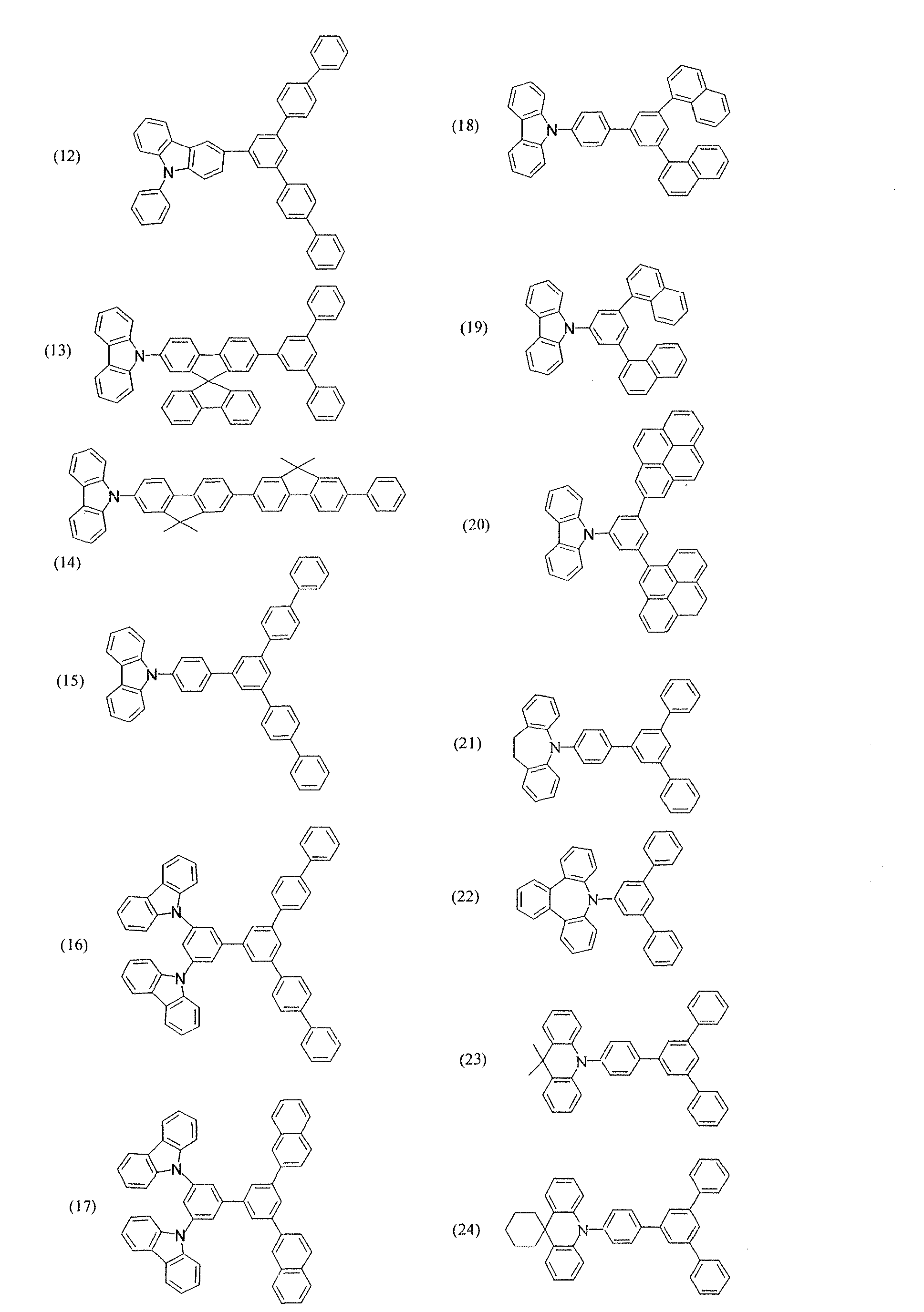

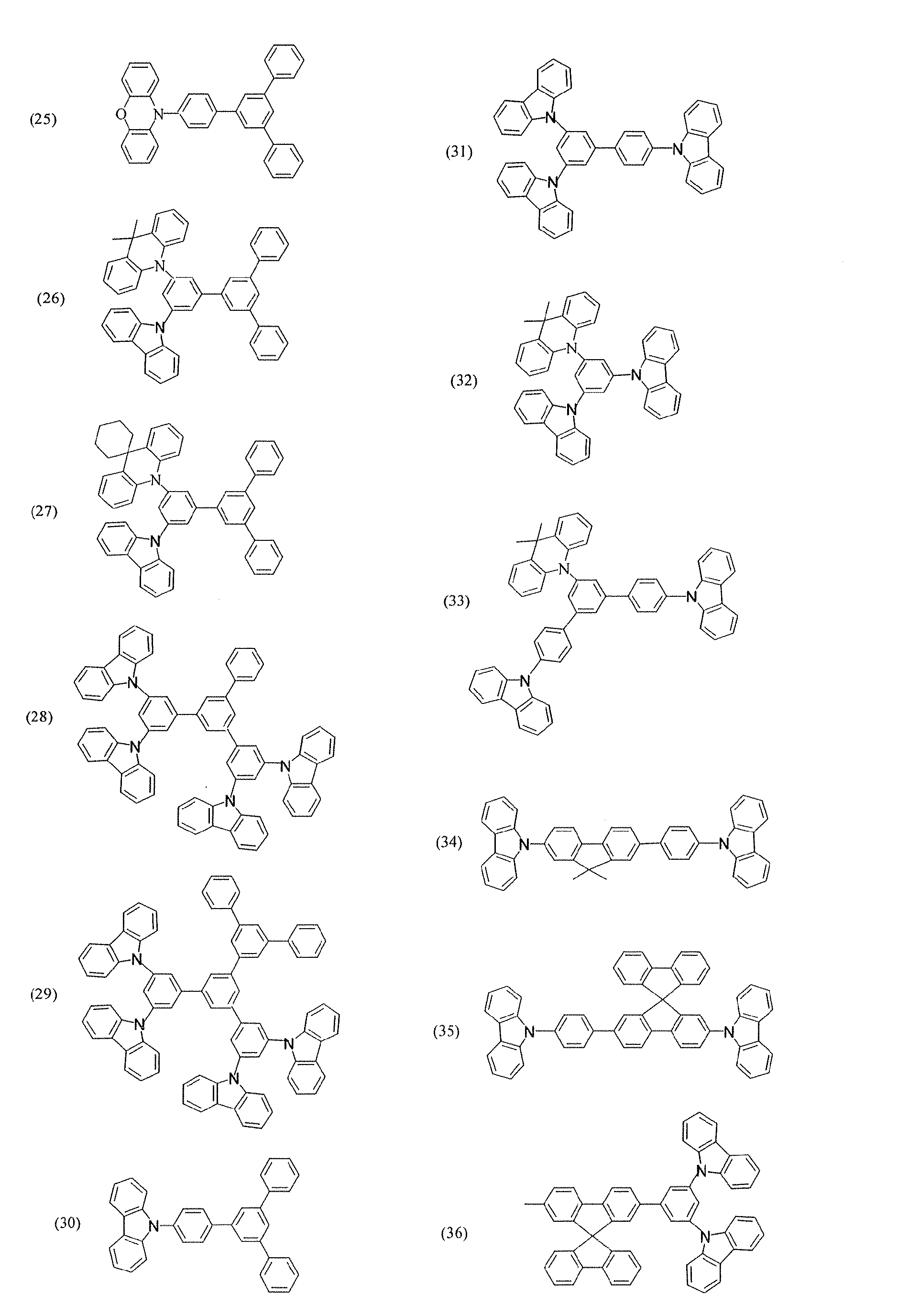

Moreover, those compounds are preferable to be a host material and transporting electric charge, and its glass transition temperature is 110 °C or higher. In addition, if triplet energy thereof is 2.76 eV or greater, it is preferable that they have a capability of exciting a complex emitting a green light and a red light. Furthermore, these compounds have a glass transition temperature of 110°C or higher and triplets energy of 2.82eV or greater, and it is possible for them to have triplets energy of 2.85 eV or greater so that they are excellent in storage at elevated temperature and possible to improve an efficiency of light emission of a green light emitting device in comparison with that of CBP. In addition, so as to excite a complex emitting a green light and a red light, the triplet energy thereof of 2.82 to 2.92 eV is preferable.

In an organic EL device of the present invention, in the case of that a host material of a light emitting layer thereof having triplet energy of 2.76 eV or greater, it is preferable that a capability of emitting blue light is high, and further 2.85eV or greater thereof is more preferable.

Further, it is preferable that a host material of the light emitting layer has electron transporting ability. In the present invention, "a host material of the light emitting layer has electron transporting ability" means either an item (1) below or an item (2) below:
(1) An electron mobility of the host material in the light emitting layer is 10⁻⁶cm²/Vs or greater. The electron mobility can be measured by a time-of-flight method (TOF) or "transient measurement of space charge limited current". For references, TOF method is described in synthetic metals 111/112, (2000) p133, and "transient measurement of space charge limited current" is described in Electrical Transport in Solids, Pergamon Press, 1981, pages 346-348.
(2) Recombination between holes and electrons in zone of an anode side in a light emitting layer is caused easier than recombination between them in zone of a cathode therein. In the case of that a layer construction is constituted by "a cathode / an electron injecting layer at an anode side / a light emitting layer at a cathode side / a hole transporting layer / an anode" by dividing the zone of the light emitting layer in two, and a device AN comprised by a light emitting layer at an anode side, only to which a phosphorescent luminescent compound is added is compared with a device CA comprised by a light emitting layer at a cathode side, only to which a phosphorescent luminescent compound is added so that it is the case that an efficiency of light emission of the device AN is higher than that of the device CA. In the above case, it should be noted that a excited state is not to be quenched optically by the electron injecting layer or the hole transporting layer.

In addition, the electron transporting ability does not mean that there is no hole transporting ability. Therefore, although it has a electron transporting ability, it is the case that it has a electron transporting ability even at the measured hole mobility of 10⁻⁷cm²/Vs or more.

In the past, a polycarbazole compound such as polyvinylcarbazole, biscarbazole and the like has generally a hole transportability, therefore an electron transportability is small. In the case of that these materials having a hole transportability is used as a host material, a main recombination zone is around interfacial zone of a cathode side in a light emitting layer. In this case, a excited state occurred mainly around the interfacial zone of the cathode side in the light emitting layer is deactivated and the efficiency thereof becomes very low, in the case of that an electron transporting material having a smaller energy gap than an energy gap of a host material constituting a light emitting layer is contained in an electron injecting layer by placing the electron injecting layer between the light emitting layer and the cathode. Further, even though the triplet energy of an electron material forming an electron injecting layer is smaller than the triplet energy of a host material forming a light emitting layer, a excited state occurred mainly around the interfacial zone of the cathode side in the light emitting layer is deactivated by the electron injection layer and the efficiency thereof becomes very low.

On the other hand, in the case of that a host material forming a light emitting layer is to be an electron transportability or a light emitting layer is to be an electron transportability, a recombination zone of an electron and a hole is apart from an interfacial zone between the electron injecting layer and the light emitting layer so that deactivation thereof can be avoided. In addition, in the present invention, a preferable host material for a light emitting material is a 5 member derivative containing nitrogen or a 6 member derivative containing nitrogen which are electron deficiency. Here, the electron deficiency means a derivative, of which, for example, one or more of carbon for a 6 π aromatic ring is replaced by nitrogen.

The 5 member derivative containing nitrogen includes preferably a derivative having at least a skeleton structure selected from imidazole, benzimidazole, triazole, tetrazole, oxadiazole, thiadiazole, oxatriazole and thiatriazole, and, a derivative having a skeleton structure of imidazole or benzimidazole is more preferable.

The 6 member derivative containing nitrogen includes preferably a derivative having at least a skeleton structure selected from triazine, quinoxaline, benzpyrimidine, pyridine, pyrazine and pyrimidine, and a derivative having a skeleton structure of triazine or pyrimidine is more preferable.

A preferable host material in the light emitting layer is particularly a material represented by the general formulae (G) and (H):

(Cz-)ₘ A (G)

wherein, Cz represents a substituted or unsubstituted carbazole group, or a substituted or unsubstituted azacarbazole group; A represents a nitrogen containing ring group substituted by an aryl group, a nitrogen containing ring group substituted by a diaryl group, or a nitrogen containing ring group substituted by a triaryl group; m represents an integer of from 1 to 3.

Cz-Aₙ (H)

wherein, Cz represents a substituted or unsubstituted carbazole group, or a substituted or unsubstituted azacarbazole group; A represents a nitrogen containing ring group substituted by an aryl group, a nitrogen containing ring group substituted by a diaryl group, or a nitrogen containing ring group substituted by an triaryl group; n represents an integer of from 1 to 3.

In the general formulae (G) and (H), a preferable nitrogen containing ring includes pyridine, quinoline, pyrazine, pyrimidine, quinoxaline, triazine, imidazoline and imidazopyridine.

Further, in the general formulae (G) and (H), an ionization potential value is subjected to Cz, and the value is from 5.6 eV to 5.8 eV

The preferable organic EL device comprises an electron injecting/transporting layer between the light emitting layer and the cathode and the electron injecting/transporting layer contains nitrogen containing ring derivative as the main component. An electron transporting material to be used for the electron injecting/transporting layer includes preferably an aromatic heterocyclic compound having at least one of a hetero atom therein, more preferably a nitrogen containing ring derivative. The nitrogen containing ring derivative is preferably a derivative having an azole skeleton structure of a 5 member ring. The aromatic hetero compound means its compound having at least two atoms other than a carbon atom and a hydrogen atom within the basic skeleton structure thereof, and it may be a single ring or a condensed ring. The nitrogen containing ring derivative includes preferably its derivative having at least one atom selected from a nitrogen atom, an oxygen atom and a sulfur atom, and also includes more preferably an aromatic heterocyclic ring having at least two of nitrogen atoms within the skeleton structure thereof. The hetero atom may be located at a condensed part or a non-condensed part. The heterocyclic skeleton structure having at least two hetero atoms includes, for example, pyrazole, imidazole, pirazine, pyrimidine, indazole, purine, phthalazine, naphthylidine, quinoxaline, quinazoline, cinnoline, pteridine, perimidine, phenanthroline, pyrroimidazole, pyrootriazole, pyrazoloimidazole, purazolotriazole, pyrazolopyrimidine, pyrazolotriazine, imidazoimidazole, imidazopyridazine, imidazopyridine, imidazopyrazine, triazopyridine, benzoimidazole, naphtoimidazole, benzoxazole, naphtoxazole, benzothiazole, naphtothiazole, benzotriazole, tetrazaindene, triazine and the like.

Among the above, the electron transportable host material includes preferably a compound thereof having a condensed azole skeleton structure such as imidazopyridazine, imidazopyridine, imidazopyrazine, benzoimidazole and aphtoimidazole, or a compound having a triazine skeleton structure, and more preferably condensed imidazopyridine.

A compound having the azole skeleton structure is preferably represented by the general formula (J): 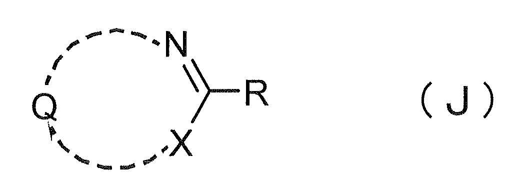 wherein, **R** represents an aromatic group, **X** represents O, S or N-Ra; Ra represents a hydrogen atom, a aliphatic hydrocarbon group, an aryl group or a heterocyclic group; **Q** represents an atom group which is required for forming a heterocyclic ring by bonding with N and **X.** Further, both **R** and **X,** and both **R** and **Q** may bond each other to form a ring if possible.

The preferable nitrogen containing ring derivative includes the following:

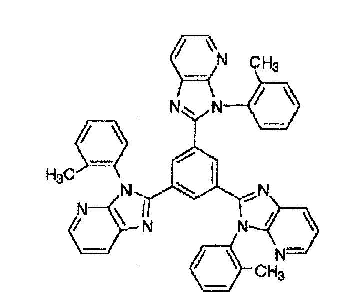

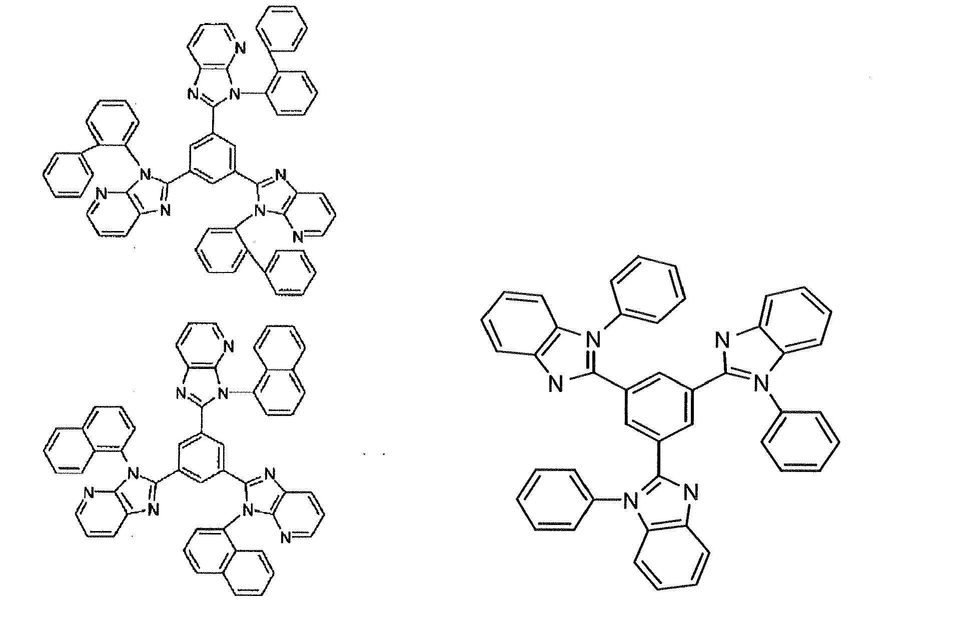

On the other hand, an electron transporting material includes the following oxazole derivatives: 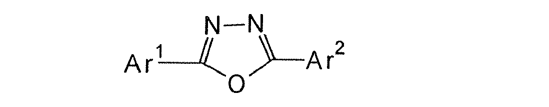 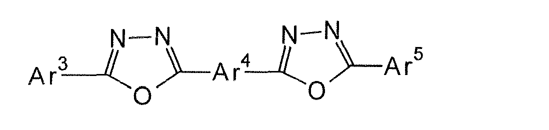 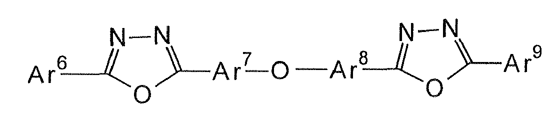 wherein, Ar¹, Ar², Ar³, Ar⁵, Ar⁶ and Ar⁹ each independently represents a substituted or unsubstituted aryl group, and may be the same with or different from each other. Further, Ar⁴, Ar⁷ and Ar⁸ each independently represents a substituted or unsubstituted aryl group, and may be the same with or different from each other.

Here, the aryl group includes a phenyl group, a biphenyl group, an anthranyl group, a perylenyl group, a pyrenyl group and the like. In addition, the arylene group includes a phenylene group, a naphtylene group, a biphenylene group, a perylenylene group, a pyrenylene group and the like. Moreover, the substituent includes an alykyl group having carbon atoms of 1 to 10, an alkoxy group having carbon atoms of 1 to 10 a cyano group or the like. The electron transporting compound includes preferably a compound having a film forming capability.

Specific examples of the electron transporting compound include the following:

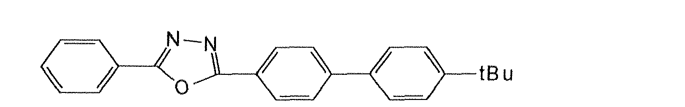

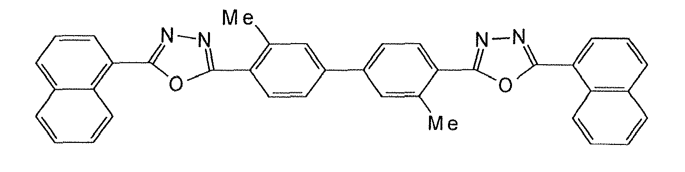

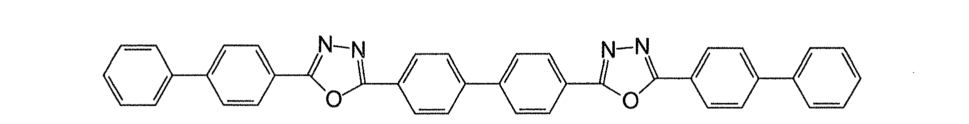

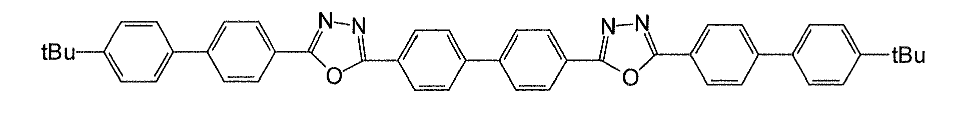

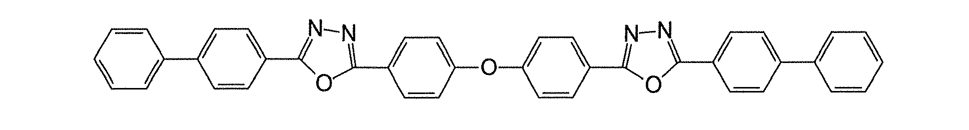

In addition, a nitrogen containing complex is preferable as the electron transporting material, and the nitrogen containing complex includes a metal complex cordinated by a single species of a nitrogen ring derivative, and the nitrogen containing ring is preferably quinoline, phenylpyridine, benzoquinoline or phenanthroline. Further, it is preferable that the metal complex is a quinolinol metal complex or a derivative thereof. Specific examples of a metal complex having a 8-quinolinol derivative as a ligand include tris(8-quinolinol) Al complex, tris(5,7,-dichloro-8-quinolinol) Al complex, tris(5,7-dibromo-8-quinolinol) Al complex, tris(2-methyl-8-quinolinol) Al complex, tris(8-quinilinol) Zn complex, tris(8-quinolinol) In complex, tris(8-quinolinol) Mg complex, tris(8-qunolinol) Cu complex, tris(8-quinolinol) Ca complex, tris(8-quinolinol) Sn complex, tris(8-quinolinol) Ga complex, tris(8-quinohnol) Pb complex and the like, and they are used alone or in combination of at least two selected from among them.

Those complexes have an excellent electron injection capability from a cathode due to small energy gap thereof and high durability about electron transportation; therefore provide a device having a long lifetime.

Specific examples of these metal complexes are as follows.

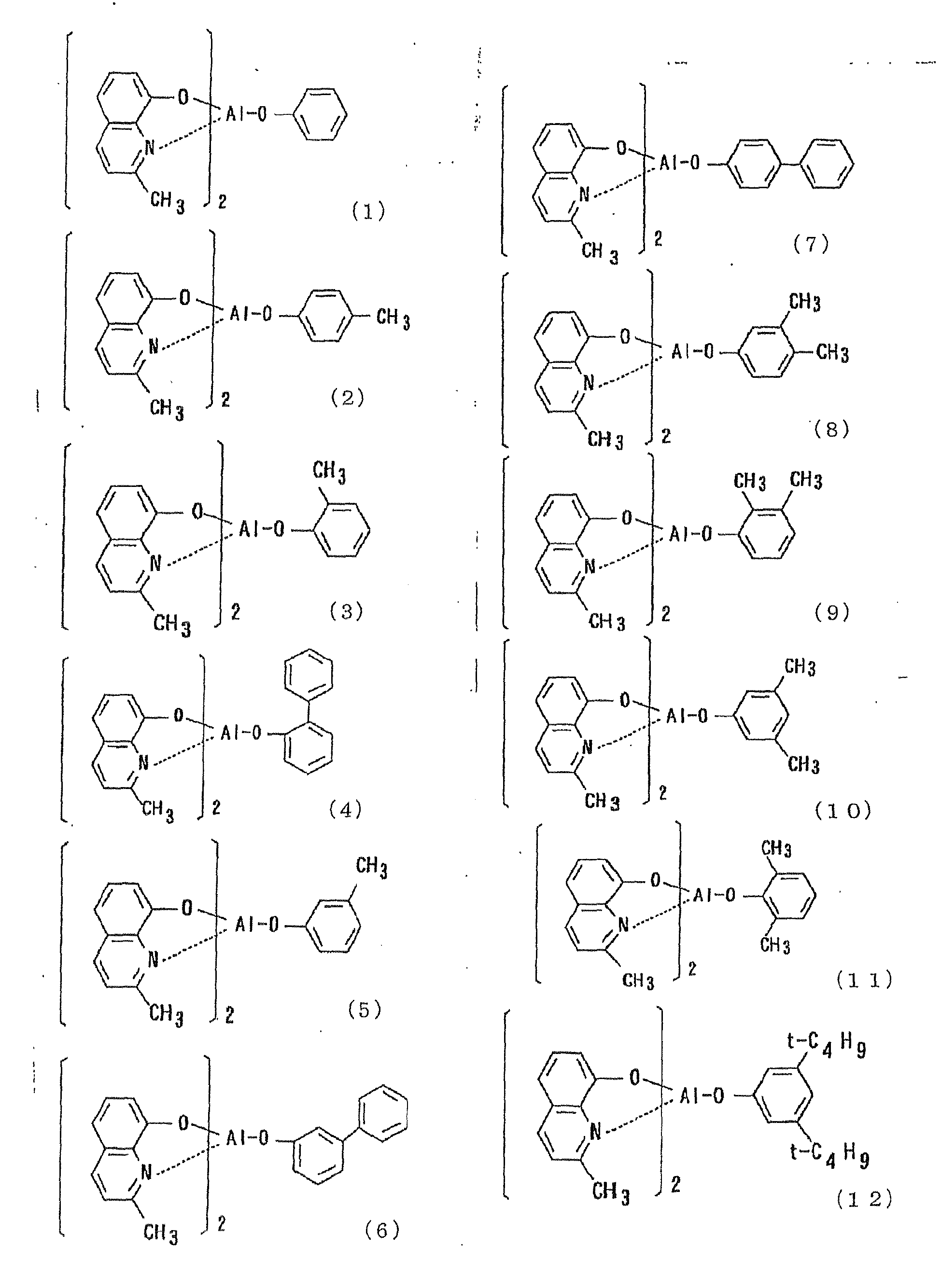

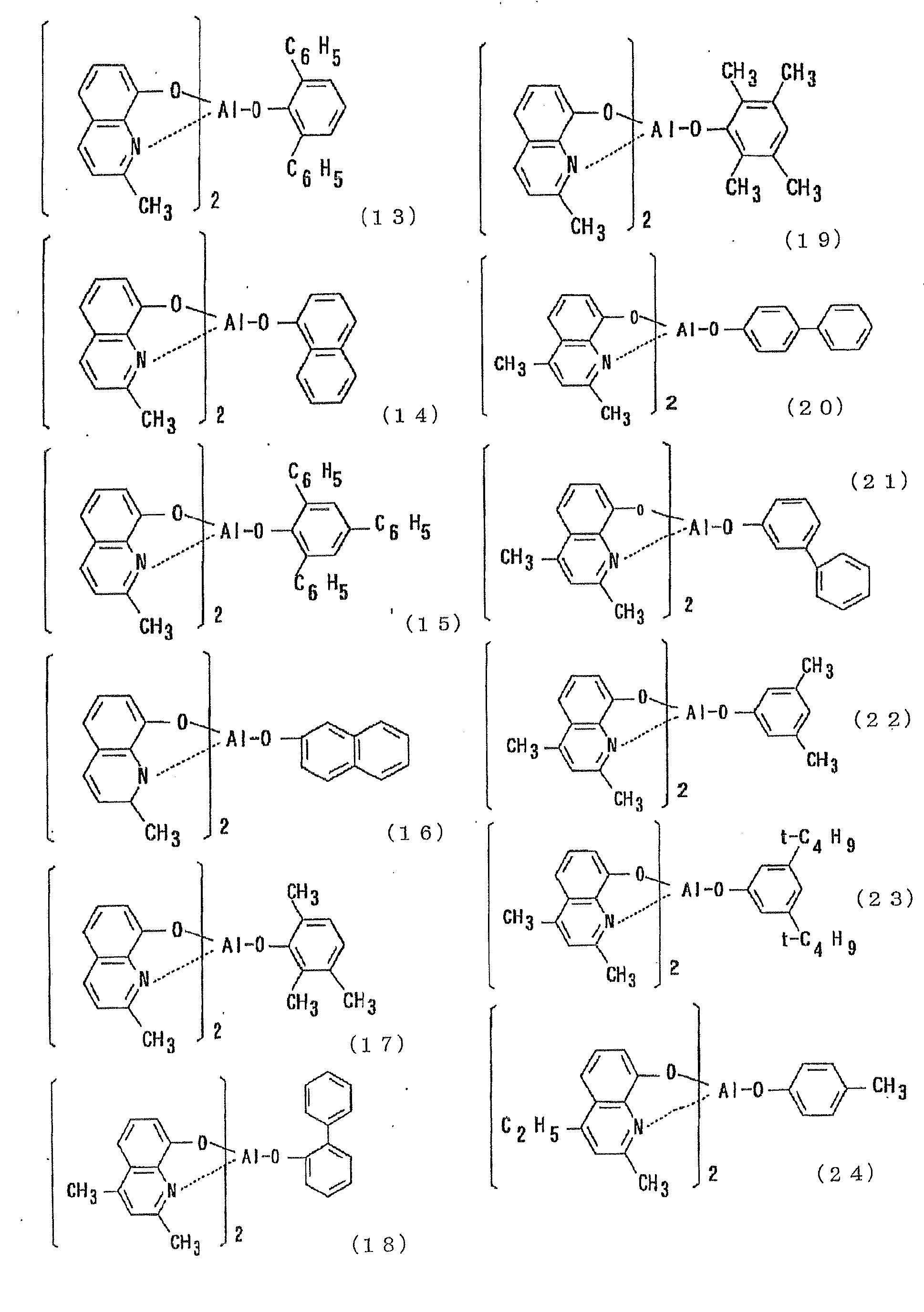

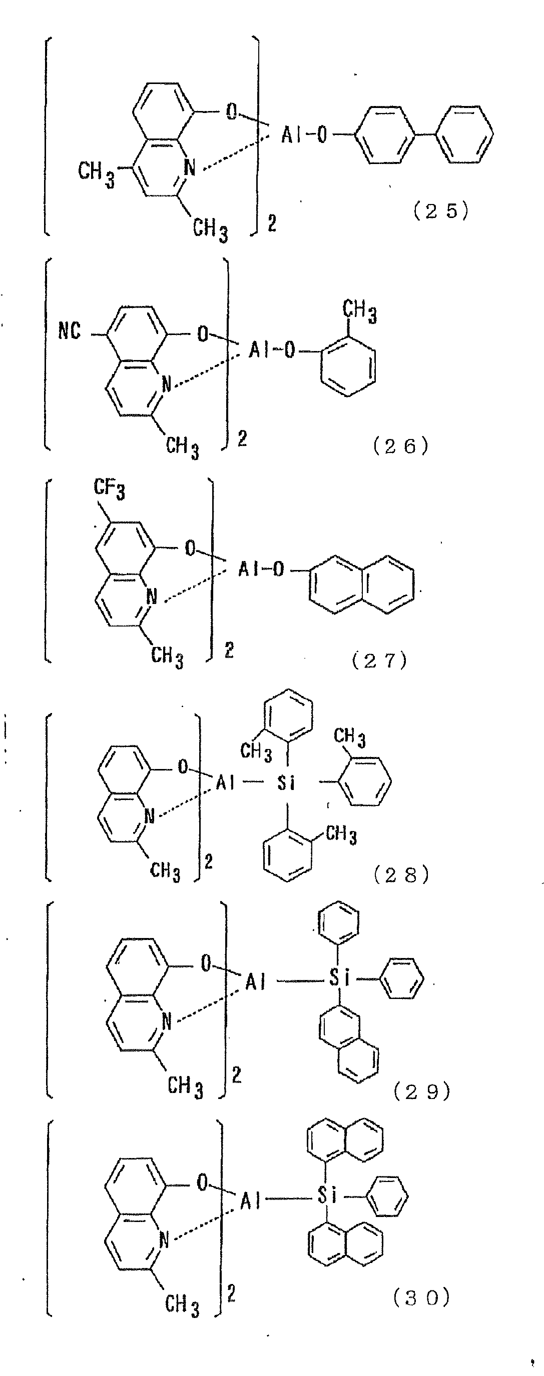

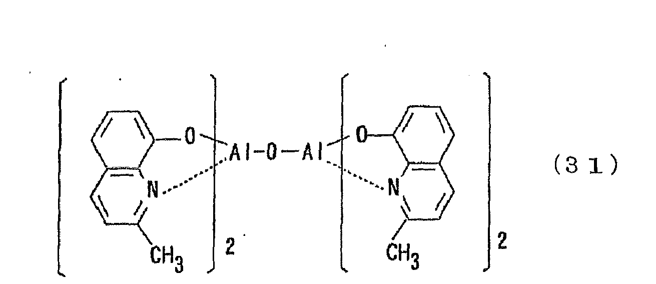

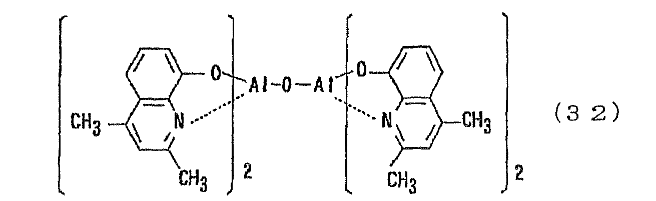

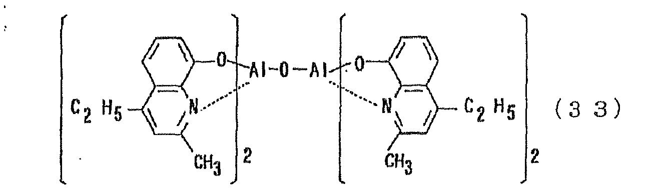

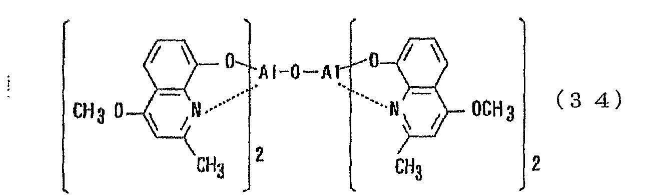

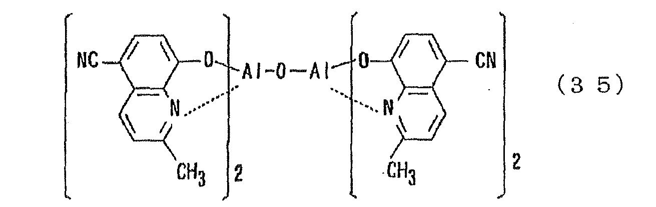

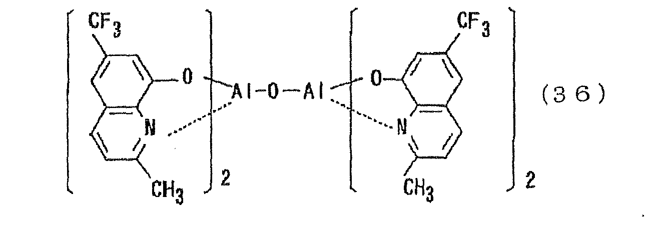

In addition, it is preferable that an insulating material or a semiconductor of an inorganic compound other then the electron transportable materials is used as a constituent component for the electron injecting layer. It is possible to effectively prevent an electron injecting layer from leak of the electric current and improve the electron injecting capability when the layer is constituted with a semiconductor or an inorganic compound.

It is preferable that at least one metal compound selected from the group consisting of alkali metal chalcogenides, alkaline earth metal chalcogenides, alkali metal halides and alkaline earth metal halides is used as the insulating material. It is preferable that the electron injecting layer is constituted with the above alkali metal chalcogenide since the electron injecting capability can be improved. Preferable examples of the alkali metal chalcogenide include Li₂O, LiO, Na₂S, Na₂Se and NaO. Preferable examples of the alkaline earth metal chalcogenide include CaO, BaO, SrO, BeO, BaS and CaSe. In addition, preferable examples of the alkali metal halide include LiF, NaF, KF, LiCl, KCl and NaCl. Further, preferable examples of the alkaline earth metal halide include fluorides such as CaF₂, Ba F₂, Sr F₂, Mg F₂ and Be F₂, and halides other than the fluorides.

Moreover, examples of the semiconductor constituting the electron transporting layer include oxides, nitrides and oxide nitrides containing at least one element selected from the group consisting of Ba, Ca, Sr, Yb, Al, Ga, In, Li, Na, Cd, Mg, Si, Ta, Sb and Zn, which can be used alone or in combination of two or more kind thereof. It is also preferable that the inorganic compound constituting the electron transporting layer is in the form of an insulating thin film of fine crystalline or amorphous. When the electron transporting layer is constituted with the above insulating thin film, a more uniform thin film can be formed so that defective pixels such as dark spots can be decreased. Examples of the inorganic compound include the alkali metal chalcogenides, the alkaline earth metal chalcogenides, the alkali metal halides and the alkaline earth metal halides which are described above.

In the organic EL device of the present invention, it is preferable that a reductive dopant is added in an interfacial zone between the cathode and the organic thin film layer.

Examples of the reductive dopant include at least one compound selected from alkali metals, alkali metallic complexes, alkali metal compounds, alkaline earth metals, alkaline earth metallic complexes, alkaline earth metal compounds, rare earth metals, rare earth metallic complexes and rare earth metal compounds, and also oxides, halides and the like of the above metals or complexes. Examples of the alkali metals include Li (the work function: 2.93 eV), Na (the work function: 2.36 eV), K (the work function: 2.28 eV), Rb (the work function: 2.16 eV), Cs (the work function: 1.95 eV) and the like, whose work function of 3.0 eV or smaller is particularly preferable. Among these, Li, K, Rb and Cs are more preferable.

Examples of the alkaline earth metals include Ca (the work function: 2.9eV), Sr (the work function: 2.0 to 2.5 eV) and Ba (the work function: 2.52 eV); whose work function of 3.0 eV or smaller is particularly preferable. The alkaline earth metals include Sc, Y, Ce, Tb, Yb and the like, whose work function of 3.0 eV or smaller is particularly preferable.

Since a preferable metal among the above metals has particularly high reduction power, it is possible to improve luminance of emitted light of the organic EL device and to provide it with a long lifetime through adding a small amount the metal into an electron injection zone.

Examples of the alkali metal compound include an alkali metal oxide such as Li₂O, Cs₂O and K₂O and an alkali metal halide such as LiF, NaF, CsF and KF, and an alkali metal oxide or an alkali fluoride such as LiF, Li₂O and NaF is preferable..

Examples of the alkaline earth metal compound include BaO, CaO, SrO, BaₓSr₁₋ₓO (0<x<1) and BaₓCa₁₋ₓO (0<x<1) obtained by mixing them, and the like, further, BaO, SrO and CaO are preferable..

Examples of the rare earth metal include YbF₃, ScF₃, ScO₃, Y2O₃, Ce₂O₃, GdF₃, TbF₃ and the like, and YbF₃, ScF₃ and TbF₃ are preferable.

There is no specific limitation if at least one selected from the group consisting of an alkali metal ion, an alkaline earth metal ion and a rare earth metal for the alkali metal complex, the alkaline earth metal complex and the rare earth metal complex, is contained therein.

In addition, as the ligand, quinolinol, benzoquinolinol, acrydinol, phenanthridinol, hydroxyphenyloxazole, hydroxyphenylthiazo0le, hyddroxydiaryloxazole, hydroxydiarylthiadiazole, hydroxyphenylpyridine, hydroxyphenylbenzoimidazole, hydroxybenzotriazole, hydroxyfluborane, bipyridyle, phenanthroline, phthalocyanine, porphyrin, cyclopentadiene, β-diketone, azomethines and derivatives thereof, but not limited thereto.

As an addition manner of the reductive dopant, it is preferable to form it in a layer shape or in an island shape at the interfacial zone.

As a forming process thereof, it is preferable that organic materials of a light emitting material or an electron injecting material forming an interfacial zone are deposited while depositing a reductive dopant by a resistive heating vapor deposition process and the reductive dopant is dispersed into the organic materials. The dispersion concentration is an organic material: a reductive dopant = 100 : 1 to 1 : 100, preferably 5 : 1 to 1 : 5 by mole ratio.

When forming the reductive dopant in a layer shape, a light emitting material or an electron injecting material is formed in a layer shape, followed by depositing the reductive dopant alone by a resistive heating vapor deposition process so as to form the layer having preferably a thickness of 0.1 to 15 nm.

When forming the reductive dopant in a island shape, a light emitting material or an electron injecting material of an organic layer at the interface is formed in a island shape, followed by depositing the reductive dopant singly by a resistive heating vapor deposition process so as to form the layer having preferably a thickness of 0.1 to 15 nm.

The ratio by mole between the main component and the reductive dopant of the organic EL devices of the present invention is the main component: the reductive dopant = 5 : 1 to 1 : 5 preferably 2 : 1 to 1 : 2. In the organic EL device, an electrode material for a cathode comprised a metal, an alloy, an electroconductive compound and a mixture thereof having a small work function can be used.

Specific examples of such electrode material include sodium, sodium-potassium alloy, magnesium, lithium, magnesium-silver alloy, aluminum/aluminum oxide, aluminum/lithium alloy, indium, rare earth metals and the like.

The cathode is produced by forming a thin film through deposition, sputtering and the like of these electrodes. When the light emitted from the light emitting layer is observed through the cathode, it is preferable that the cathode has a transmittance of the emitted light greater than 10 %. It is also preferable that the sheet resistivity of the cathode is several hundred Ω/□ or smaller. The thickness of the cathode is, in general, selected from the range of from 10 nm to 1 µm and preferably from the range of from 10 to 200 nm.

The organic EL device of the present invention tends to cause defects in pixels due to leak and short circuit since an electric field is applied to ultra-thin films. To prevent the formation of the defects, a layer of an insulating thin film may be inserted between the pair of electrodes. Examples of the material employed for the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, vanadium oxide and the like. In addition, mixtures and laminates of the above compounds can be employed.

The process for forming the layers in the organic EL device of the present invention is not particularly limited. A conventional process such as the vacuum vapor deposition process, the spin coating process and the like can be used. The organic thin film layer comprising the compound having a spiro bond represented by the aforementioned general formula (1) or (1') used in the organic EL device of the present invention can be formed in accordance with the vacuum vapor deposition process, the molecular beam epitaxy process (the MBE process) or, using a solution prepared by dissolving the compound into a solvent, in accordance with a conventional coating process such as the dipping process, the spin coating process, the casting process, the bar coating process and the roller coating process.

The thickness of each layer in the organic thin film layer in the organic EL device of the present invention is not particularly limited. In general, the range from several nm to 1 µm in thickness thereof is preferable, since an excessively thin layer tends to have defects such as pin holes, and an excessively thick layer requires a high applied voltage results in decreasing the efficiency.

The coordination metal compounds of the present invention have a favorable solubility to organic solvents due to a spiro atomic group or a carbazoyl group thereof. Accordingly, the compounds of the present invention having a high molecular weight and difficulty of thin film production by the vacuum vapor deposition can be easily formed to be the thin film by means of any application process such as the dipping process, the spin coating process, the casting process, the bar coating process, the roller coating process and the like. The material for luminescent coating formation of the present invention essentially consists of an organic solvent comprising the coordination metal compound. The material for luminescent coating formation is defined as a material for providing an organic compound layer relating to light emission, specifically a light emitting layer, hole injecting (transporting) layer, electron injecting (transporting) layer, and so on by means of forming a coated film in the organic EL device.

Examples of the organic solvent used for preparation of the material for luminescent coating formation include, halogen-based hydrocarbon solvent such as dichloro-methane, dichloroethane, chloroform, tetrachloromethane, tetrachloro ethane, trichloroethane, chlorobenzene, dichlorobenzene, chlorotoluene, etc.; ether-based solvent such as dibutyl ether, tetrahydrofuran, dioxane, anisole, etc.; alcohol-based solvent such as methanol, ethanol, propanol, butanol, pentanol, hexanol, cyclohexanol, methyl cellosolve, ethylcellosolve, ethylene glycol, etc.; hydrocarbon-based solvent such as benzene, toluene, xylene, ethyl benzene, hexane, octane, decane, etc.; ester-based solvent such as ethyl acetate, butyl acetate, amyl acetate and the like. Among those, halogen-based hydrocarbon solvent, hydrocarbon-based solvent and ether-based solvent are preferable. Further, the solvent may be used alone, or in combination of two or more kind thereof. Additionally, the employable solvent is not limited to the above examples. It is preferable that the organic device of the present invention is formed by using the material for luminescent coating formation.

### EXAMPLES

This invention will be described in further detail with reference to the examples, which do not limit the scope of this invention.

### Example 1 (Synthesis of Compound (A17))

The route for synthesis of Compound (A17) is shown as follows:

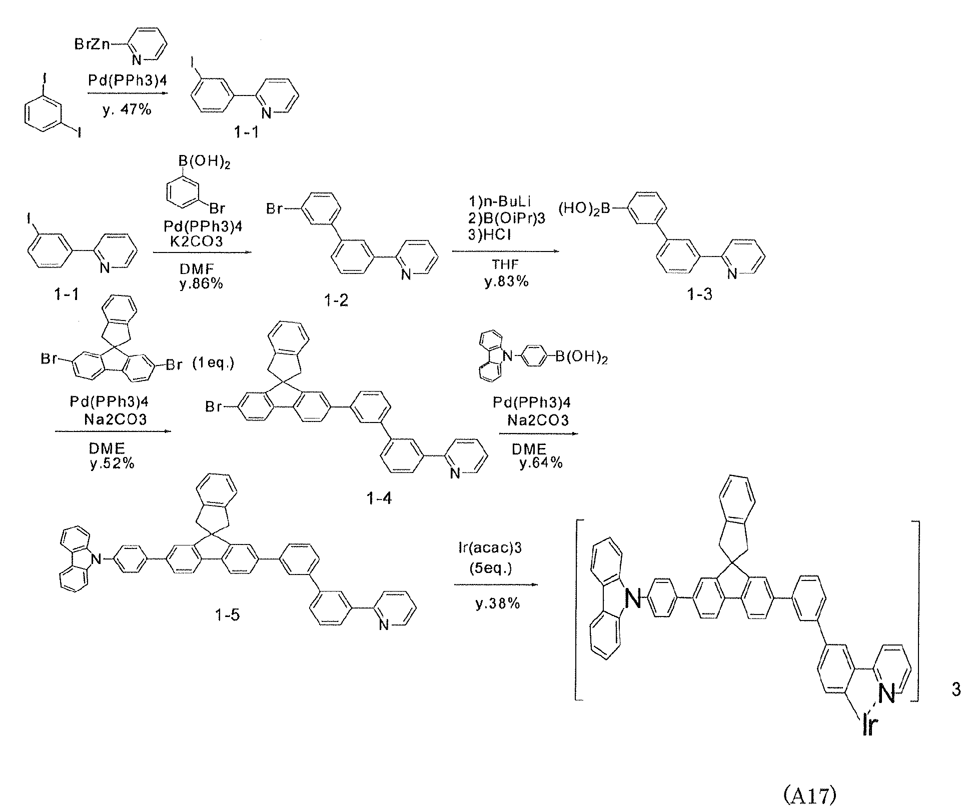

### (1) Synthesis of Intermediate Product 1-1

2-pyridylzincbromide (13.5 g, 60.6 mmol), 1,3-diiodo benzene (20 g, 60.6 mmol) and Pd(PPh₃)₄ (2.32 g, 2.0 mmol) were added in tetrahydrofuran anhydride (300 milliliter) under the argon gas atmosphere, and the resultant solution was stirred for 8 hours at room temperature.

The resultant reaction solution added by water was extracted with methyl acetate, and then the obtained was dried with the use of magnesium sulfate anhydride, followed by vacuum concentration in an evaporator. The residue obtained was refined with silica gel column chromatography (dissolution solvent: methylene chloride) and as a result, the objective compound was obtained. Produced Amount: 8.0g, Yield: 47 %

### (2) Synthesis of Intermediate Product 1-2

Into a three neck flask, 3-bromobenzene-1-boronic acid (3.59 g, 17.9 mmol), Intermediate Product 1-1 (6.04 g, 21.5 mmol) and Pd(PPh₃)₄ (0.62 g, 0.54 mmol) were placed and the atmosphere in the flask was replaced with argon gas. Dimethylformamide (50 milliliter) and an aqueous solution (27milliliter) of potassium carbonate (7.42 g, 53.7 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 1-2 was obtained. Produced Amount: 4.78g, Yield: 86 %

### (3) Synthesis of Intermediate Product 1-3

Into a 300 milliliter flask, of which atmosphere was already replaced with argon gas, Intermediate Product 1-2 (4.0 g, 12.9 mmol) and tetrahydrofuran anhydride (100 milliliter) were placed and further, after cooling the resultant solution down to -60 °C, a hexane solution (12.6 milliliter) of n-butyllithium 1.59 M was poured into the cooled solution. The resultant reaction solution was stirred at the temperature of -20 °C for 1 hour and then, the solution was cooled down to -60 °C, followed by adding tetrahydrofuran anhydride solution (40 milliliter) of triisopropyl boride (6.28 g, 33.4 mmol) therein, then the resultant solution was stirred for 1 hour. The temperature of the reaction solution was elevated little by little up to the room temperature, and the reaction solution was stood alone over a night. After adding 2N hydrochloric acid (100 milliliter) to the resultant solution, stirring the solution at room temperature for 1 hour, followed by separation of an organic layer. The organic layer was dried with the use of magnesium sulfate anhydride, followed by vacuum concentration in an evaporator and as a result, Intermediate Product 1-3 was obtained. Produced Amount: 29.4g, Yield: 83 %

### (4) Synthesis of Intermediate Product 1-4

Into a three neck flask, indan-2,9-fluorene-2',7'-dibromide (7.63g, 17.9mmol), Intermediate Product 1-13 (2.80 g, 17.9 mmol) and Pd(PPh₃)₄ (0.62 g, 0.54 mmol) were placed and the atmosphere in the flask was replaced with argon gas. Dimethoxyethane (50 milliliter) and an aqueous solution (27milliliter) of sodium carbonate (5.69g, 53.7 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 1-4 was obtained. Produced Amount: 5.37g, Yield: 52 %

### (5) Synthesis of Intermediate Product 1-5

Into a three neck flask, 4-(N-carbazolyl)-phenylboronic acid (2.47g, 8.60mmol), Intermediate Product 1-4 (3.82 g, 6.62 mmol) and Pd(PPh₃)₄ (0.36 g, 0.3 mmol) were placed and the atmosphere in the flask was replaced with argon gas. Dimethoxyethane (50 milliliter) and an aqueous solution (27milliliter) of sodium carbonate (1.97g, 18.6 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 1-5 was obtained. Produced Amount: 3.13g, Yield: 64 %

### (6) Synthesis of Compound (A17)

Into a flask, of which atmosphere was replaced with argon gas, Intermediate Product 1-5 (2.67g, 3.62mmol), iridium (III)acetylacetonate (Ir(acac)₃) (0.35g, 0.72mmol) and glycerol (50milliliter) were placed, and then it was refluxed under heating for 15 hours. The precipitated solid was filtrated and washed by methanol. The obtained solid thereafter was refined with silica gel column chromatography (dissolution solvent: methylene chloride) and as a result, Compound (A17) was obtained. It was confirmed in accordance with 90MHz ¹H-NMR and Field Desorption Mass Spectrometry (FD-MS) that the obtained was the objective compound. The result of the measurement in accordance with FD-MS is shown as the following:
Produced Amount: 0.66 g, Yield: 38 %, FD-MS: 2403 (M⁺, 100).

### Example 2 (Synthesis of Compound (A7))

The route for synthesis of Compound (A7) is shown as the following:

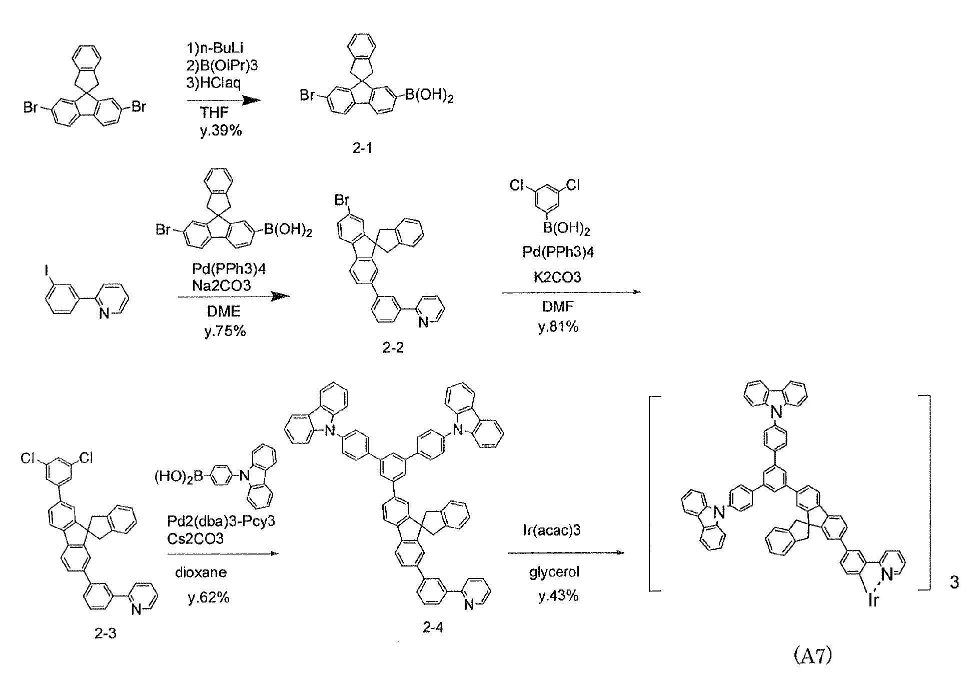

### (1) Synthesis of Intermediate Product 2-1

Into a flask, of which atmosphere was replaced with argon gas, spiro[indan-2,9'-fluorene-2,7'-dibromide](5.62 g, 13.2 mmol), and tetrahydrofuran anhydride (50 milliliter) were placed and the resultant solution was cooled down to -6 °C , followed by pouring a hexane solution (8.3 milliliter, 13.2 mmol) of n-butyllithium 1.59 M therein. The resultant reaction solution was stirred at the temperature of -20 °C for 1 hour and further, the solution was cooled down to -60 °C, and then, adding tetrahydrofuran anhydride solution (40 milliliter) of triisopropyl boride (4.97 g, 26.4 mmol), the resultant solution was stirred for 1 hour. The temperature of the reaction solution was elevated little by little up to the room temperature, and the reaction solution was stood alone over a night. After adding 2N hydrochloric acid (100 milliliter) to the resultant solution, stirring the solution at room temperature for 1 hour, followed by separation of an organic layer. The organic layer was dried with the use of magnesium sulfate anhydride, followed by vacuum concentration in an evaporator. The obtained solid thereafter was refined with silica gel column chromatography (dissolution solvent: methylene chloride) and as a result, Intermediate Compound 2-1 was obtained. Produced Amount: 2.01g, Yield: 39 %

### (2) Synthesis of Intermediate Product 2-2

Into a three neck flask, Intermediate Product 1-1 (1.41 g, 5.0 mmol), Intermediate Product 2-1 (1.96 g, 5.0 mmol) and Pd(PPh₃)₄ (0.35 g, 0.3 mmol) were placed and the atmosphere in the flask was replaced with argon gas.Dimethoxyethane (20 milliliter) and an aqueous solution (7.5 milliliter) of sodium carbonate (1.59g, 15 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 2-2 was obtained. Produced Amount: 1.88 g, Yield: 75 %

### (3) Synthesis of Intermediate Product 2-3

Into a three neck flask, Intermediate Product 2-2 (1.65 g, 3.3 mmol), 3,5-dichlorophenyl boronic acid (0.63 g, 3.3 mmol) and Pd(PPh₃)₄ (0.20 g, 0.17 mmol) were placed and the atmosphere in the flask was replaced with argon gas. Dimethylformamide (10 milliliter) and an aqueous solution (5 milliliter) of potassium carbonate (1.38 g, 10.0 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 2-3 was obtained. Produced Amount: 1.51 g, Yield: 81 %

### (4) Synthesis of Intermediate Product 2-4

In a three neck flask, Intermediate Product 2-4 (1.50 g, 2.65 mmol), 4-(N-carbazolyl)-phenylboronic acid (1.90g, 6.62mmol), Pd₂(dba)₃ (0.12 g, 0.13 mmol) and cesium carbonate (5.18 g, 15.9 mmol) were placed and the atmosphere in the flask was replaced with argon gas. Tricyclohexylphosphin (0.10 g, 0.36 mmol) and dimethylformamide (20 milliliter)and dimethlformamide (20 milliliter) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride) and as a result, Intermediate Product 2-4 was obtained. Produced Amount: 1.61 g, Yield: 82 %

### (5) Synthesis of Compound (A7)

Into a flask, of which atmosphere was replaced with argon gas, the intermediate 2-4 (1.47g, 1.5 mmol), Ir(acac)₃ (0.15 g, 0.3 mmol)and glycerol (30milliliter) were placed, and then it was refluxed under heating for 15 hours. The precipitated solid was filtrated and washed by methanol. The obtained solid thereafter was refined with silica gel column chromatography (dissolution solvent: methylene chloride) and as a result, Compound (A7) was obtained. It was confirmed in accordance with 90MHz ¹H-NMR and Field Desorption Mass Spectrometry (FD-MS) that the obtained was the objective compound. The result of the measurement in accordance with FD-MS is shown as the following:
Produced Amount: 0.23 g, Yield: 25 %, FD-MS: 3126 (M⁺ , 100).

### Example 3 (Synthesis of Compound (A45))

The route for synthesis of Compound (A45) is shown as the following:

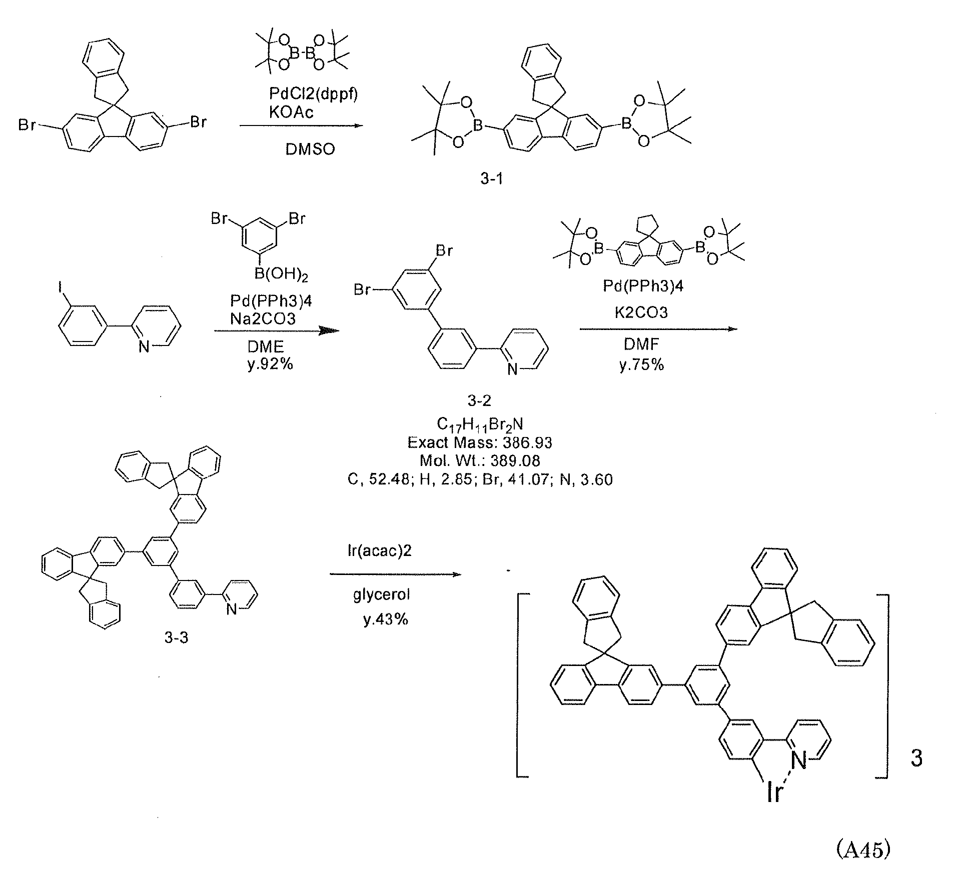

### (1) Synthesis of Intermediate Product 3-1

Under the argon gas atmosphere, spiro[indan-2,9'-fluorene-2,7'-dibromide](5.63 g, 13.2 mmol), pinacolate diborane (8.04 g, 31.7 mmol), PdCl₂(dppf) (0.65 g, 0.79 mmol), potassium acetate (7.73 g, 79.2 mmol), and dimethylsulfoxide (50 milliliter) were placed and then the resultant solution was stirred at 80°C for 8 hours. After water was added in the resultant reaction solution, the precipitated solid was filtrated, and then dried. The obtained solid thereafter was refined with silica gel column chromatography (dissolution solvent: methylene chloride) and as a result, the objective compound was obtained. Produced Amount: 4.18 g, Yield: 81 %

### (2) Synthesis of Intermediate Product 3-2

Into a three neck flask, Intermediate Product 1-2 (5 g, 17.8 mmol), 3,5-dibromophenyl boronic acid (4.98 g, 17.8 mmol) and Pd(PPh₃)₄ (1.0 g, 0.9 mmol) were placed and the atmosphere in the flask was replaced with argon gas. Dimethoxyethene (50 milliliter) and an aqueous solution (27 milliliter) of sodium carbonate (5.66 g, 53.4 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride).
Produced Amount: 6.37 g, Yield: 92 %

### (3) Synthesis of Intermediate Product 3-3

Into a three neck flask, Intermediate Product 3-2 (1.65 g, 4.23 mmol), Intermediate Product 3-1 (5.0 g, 10.6 mmol), tris(dibenzylideneaceton) dipalladium (0) (Pd(PPh₃)₄) (0.23 g, 0.2 mmol were placed and the atmosphere in the flask was replaced with argon gas. Dimethylformamide (50 milliliter) and an aqueous solution (13 milliliter) of potassium carbonate (2.49 g, 25.4 mmol) were added to the resultant solution and then, it was refluxed under heating for 8 hours. The resultant reaction solution was extracted by toluene, followed by vacuum concentration. The obtained solid thereafter was refined with silica gel column chromatography (dissolution solvent: methylene chloride), and as a result, Intermediate Product 3-3 was obtained. Produced Amount: 2.12 g, Yield: 75 %

### (4) Synthesis of Compound (A45)

Into a flask, of which atmosphere was replaced with argon gas, Intermediate Product 3-3 (2.0 g, 2.99 mmol), Ir(acac)₃ (0.29 g, 0.59 mmol), and glycerol (50 milliliter) were placed and then the resultant solution was refluxed under heating for 15 hours. The precipitated solid was filtrated and washed by methanol. The obtained solid thereafter was refined with silica gel column chromatography (dissolution solvent: methylene chloride) and as a result, Compound (A45) was obtained. It was confirmed in accordance with 90MHz ¹H-NMR and Field Desorption Mass Spectrometry (FD-MS) that the Compound (A45) obtained was the objective compound. The result of the measurement in accordance with FD-MS is shown as the follows:
Produced Amount: 0.56 g, Yield: 43 %, FD-MS:2478 (M⁺, 100).

### Example 4 (Fabrication of an organic EL device)

A glass substrate (manufactured by GEOMATEC Company) of 25 mmx75 mm×1.1 mm thickness having an ITO transparent electrode was cleaned by application of ultrasonic wave in isopropyl alcohol for 5 minutes and then by exposure to ozone generated by ultraviolet light for 30 minutes. On the substrate, by using a solution prepared by dissolving Compound (A17) synthesized in Example 1 in chloroform, a film for the use of the light emitting layer was formed in accordance with a spin coat process. The film thickness was 50 nm. On the film formed above, a film of 1,3,5-tris(2-N-phenylbenzimidazololyl) benzene having a thickness of 50 nm was formed. Thereafter, LiF as a reductive dopant was vapor deposited thereon and a LiF film was formed as the electron injecting layer (or the cathode). On the LiF film, metallic aluminum was vapor deposited to form a metal cathode and an organic EL device was prepared.

Voltage, current density, current efficiency and power efficiency of the fabricated organic EL device were measured by conducting a test of feeding electric current, and further, a sate of light emission about the light emitting surface after storing the device at the temperature of 100 °C for 50 hours was observed. The results are shown in Table 1.

### Example 5

An organic EL device was fabricated similarly as Example 4 except that Compound (A7) synthesized in Example 2 was used in place of Compound (A17).

Voltage, current density, current efficiency and power efficiency of the fabricated EL device were measured by conducting a test of feeding electric current, and further, a sate of light emission about the light emitting surface after storing the device at the temperature of 100 °C for 50 hours was observed. The results are shown in Table 1.

### Example 6

An organic EL device was fabricated similarly as Example 4 except that a mixture obtained by adding 12 % by mass of Compound (A45) synthesized in Example 3 into the following compound (CBP) was used in place of Compound (A17).

Voltage, current density, current efficiency and power efficiency of the fabricated EL device were measured by conducting a test of feeding electric current, and further, a sate of light emission about the light emitting surface after storing the device at the temperature of 100 °C for 50 hours was observed. The results are shown in Table 1.

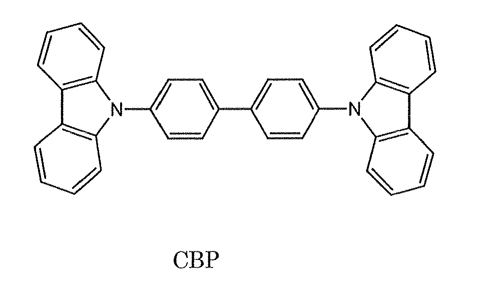

### Comparative Example 1

An organic EL device was fabricated similarly as Example 4 except that a mixture obtained by adding 12 % by mass of the following compound Ir(ppy)₃ into the above compound (CBP) was used as a light emitting layer in place of Compound (A17).

Voltage, current density, current efficiency and power efficiency of the fabricated EL device were measured by conducting a test of feeding electric current, and further, a sate of light emission about the light emitting surface after storing the device at the temperature of 100 °C for 50 hours was observed. The results are shown in Table 1.

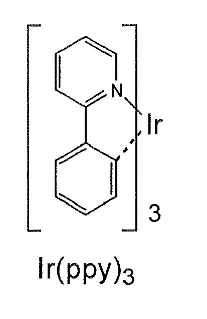

### Comparative Example 2

An organic EL device was fabricated similarly as Example 4 except that a mixture obtained by adding 12 % by mass of the following compound (H1) into aforementioned compound (CBP) was used in place of Compound (A17).

Voltage, current density, current efficiency and power efficiency of the fabricated EL device were measured by conducting a test of feeding electric current, and further, a sate of light emission about the light emitting surface after storing the device at the temperature of 100 °C for 50 hours was observed. The results are shown in Table 1.

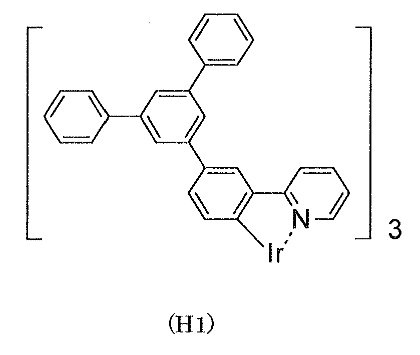

**Table 1**

| | Material in Emitting Layer | Applied Voltage | Current Density | Current Efficiency | Power Efficiency | Surface state of light emitting face after storing at the temperature of 100 °C for 50 hours |
|---|---|---|---|---|---|---|
| | | (V) | (mA/cm²) | (cd/A) | (lumen/W) | |
| Example 4 | (A17) | 4.9 | 0.24 | 51.7 | 33.1 | Emitting uniformly |
| Example 5 | (A7) | 5.1 | 0.26 | 44.2 | 27.2 | Emitting uniformly |
| Example 6 | (A45)/CBP | 5.8 | 0.26 | 41.9 | 22.7 | Emitting uniformly |
| Comparative Example 1 | Ir(Ppy)₃/CBP | 6 | 0.28 | 12.2 | 6.4 | Emitting nonuniformly |
| Comparative Example 2 | (H1)/CBP | 6 | 0.28 | 26.2 | 13.7 | Emitting nonuniformly |

As shown in Table 1, the organic EL devices of Examples 4 to 6 employed the coordination metal complexes of the present invention are activated even under a low driving voltage, and also exhibits an excellent luminance and excellent power efficiency in comparison with the organic El devices of Comparative Examples 1 and 2.

In addition, the organic EL devices of Examples 4 to 6 emit uniform light for a long time due to their resistance to elevated temperature. On the other hand, as shown in Comparative Example 2, the devices employed the compounds having no spiro bond exhibit lower efficiency of light emission due to the association between the molecules.

### Example 7

### (I) Synthesis of Complex 1

Complex (1) was synthesized as follows;

### (1) Synthesis of Compound 1

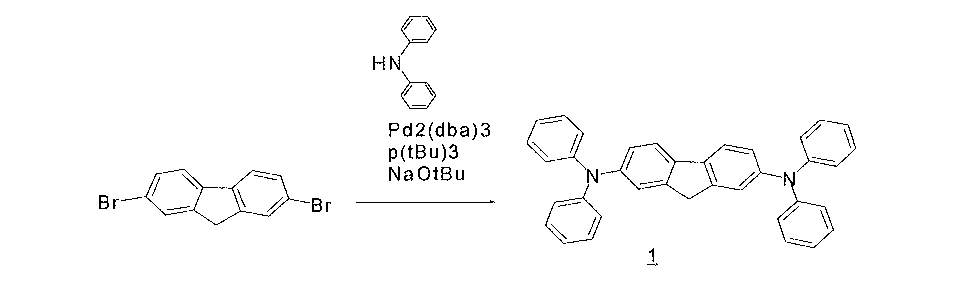

Under the atmosphere of argon gas, 2,7-dibromofluorene (5 g, 15.4 mmol), diphenylamine (10.4 g, 61.4 mmol), tris(dibenzilidenaceton)dipalladium (0) (0.71 g, 0.8 mmol) and sodium t-butoxide (4.84 g, 43.2 mmol) were suspended into toluene anhydride (50 milliliter), and then a toluene solution of 66% by mass containing tri-t-buthylphosphine (0.38 milliliter, 1.3 mmol) was added in the resultant suspension, followed by refluxing it under heating for 10 hours.The resultant reaction mixture was filtrated with silica gel, and the obtained was washed by toluene. Oil obtained by distilling the solvent from the filtrated solution was refined with silica gel column chromatography (dissolution solvent: methylene chloride) and as a result, Compound 1 was obtained.
Product Amount: 5.86 g, Yield: 76 %

### (2) Synthesis of Compound 3

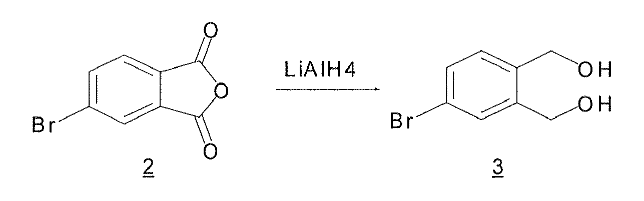

Lithium aluminum hydride (2.7 g, 70.5 mmol) was suspended in tetrahydrofuran anhydride (100 milliliter), and then a tetrahydrofuran anhydride solution (100 milliliter) of Compound 2 (8 g, 35.3 mmol) was dropped in the suspension at room temperature. After 2 hours stirring, ethylacetate (100 milliliter) and water (100 milliliter) were poured in the resultant reaction solution in this order. Subsequently, the resultant reaction solution was filtrated, and then an organic layer was separated by adding ethylacetate, followed by drying thereof with the use of magnesium sulfate anhydride. The solvent of the organic layer was distilled, and as a result, Compound 3 was obtained. Product Amount: 5.2 g, Yield: 63 %

### (3) Synthesis of Compound 4

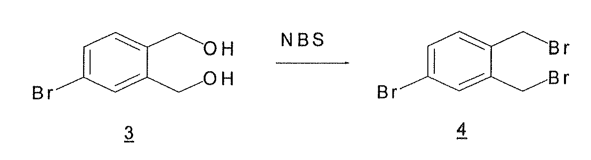

After dissolving Compound 3 (5.2 g, 23.9 mmol) in methylene chloride (50 milliliter), followed by adding N-bromosuccinimide (12.8 g, 71.7 mmol) at room temperature, and then the resultant solution was stirred for 6 hours. Water (200 milliliter) was poured in the resultant reaction solution, and the deposited solid was washed by ethanol, and as a result, Compound 4 was obtained. Product Amount: 6.9 g, Yield: 84 %

### (4) Synthesis of Compound 5

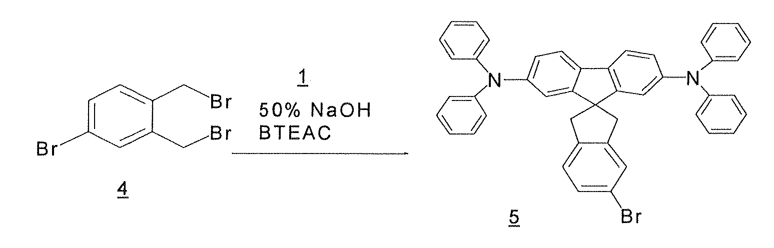

Under the atmosphere of argon gas, Compound 1 (5 g, 10 mmol), Compound 4 (3.4 g, 10 mmol), toluene (15 milliliter), dimethylsulfoxide (15 milliliter), benzyltriethylammonium chloride (0.05 g, 0.22 mmol) and an aqueous solution (4 milliliter) of sodium hydroxide (50 % by weight) were mixed and the resultant mixture was stirred at 80°C for 8 hours. After pouring water (100 milliliter) and toluene (100 milliliter) in the resultant reaction solution, an organic layer was separated. The layer was washed by saturated salt water, followed by drying thereof with the use of magnesium sulfate anhydride. The solvent of the organic layer was distilled and then the residue obtained was refined with silica gel column chromatography (hexane/methylene chloride) and as a result, Compound 5 was obtained. Product Amount: 3.9 g, Yield: 57 %.

### (5) Synthesis of Compound 6

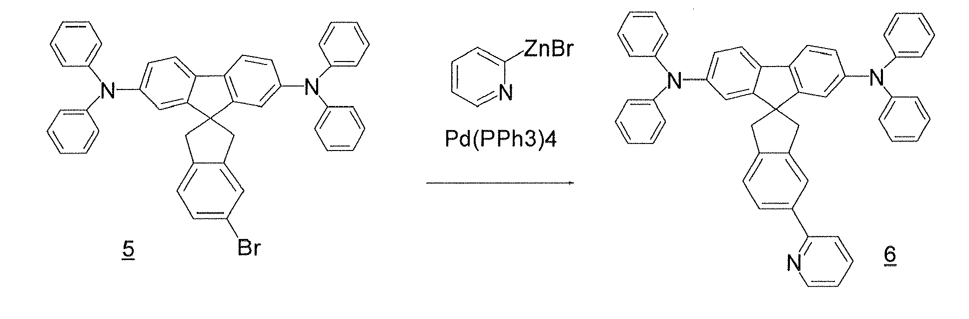

Under the atmosphere of argon gas, Compound 5 (3 g, 4.4 mmol),2-pyridylzincbromide/0.5Mtetrahydrofuran (11.4 milliliter, 5.7 mmol) and tetrakis(triphenylphosphino) palladium (0.15 g, 0.13 mmol) were poured in tetrahydrofuran anhydride, and then the resultant mixture was refluxed under heating for 8 hours. The resultant reaction solution added by water was extracted with methyl acetate, and then the extracted solution was dried with the use of magnesium sulfate anhydride, followed by vacuum concentration in an evaporator. The residue obtained was refined with silica gel column chromatography (dissolution solvent: methylene chloride), and as a result, Compound 6 was obtained. Product Amount: 1.9 g, Yield: 63 %.

### (6) Synthesis of Complex 1

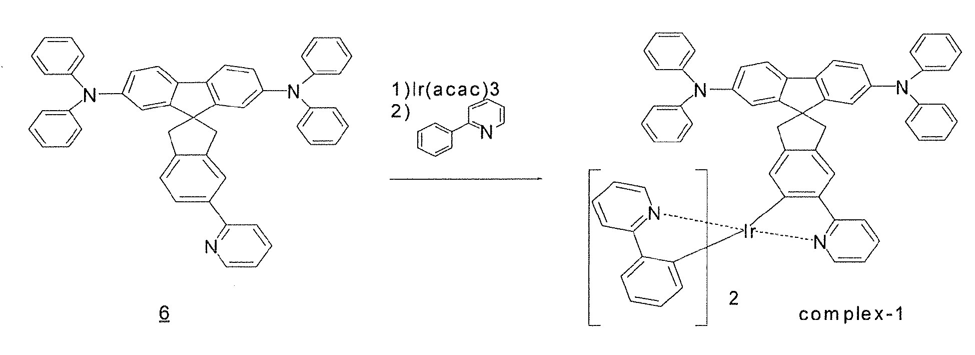

Into a flask, of which atmosphere was already replaced with argon gas, Compound (1.5 g, 2.2 mmol), Iridium(III) acetylacetnate (Ir(acac)₃) (1.08 g, 2.2 mmol) and glycerol (50 milliliter) were placed and the resultant was stirred at 250°C for 15 hours, and then after pouring 2-phenylpyridine (0.68 g, 4.4 mmol) in the reaction solution, the resultant solution was stirred at 250°C for 10 hours. The precipitated solid was filtrated and washed by methanol. The obtained solid was refined with silica gel column chromatography (dissolution solvent: methylene chloride) and as a result, Complex 1 was obtained.

It was confirmed in accordance with 90MHz ¹H-NMR and Field Desorption Mass Spectrometry (FD-MS) that the obtained was Complex 1 represented by the above formula.

### (II) Fabrication of an organic EL device

A glass substrate (manufactured by GEOMATEC Company) of 25 mm×75 mm×1.1 mm thickness having an ITO transparent electrode was cleaned by application of ultrasonic wave in isopropyl alcohol for 5 minutes and then by exposure to ozone generated by ultraviolet light for 30 minutes. On the substrate, a film of polyethylenedioxythiophene polystylene sulfonate (PEDOT/PSS) was formed in accordance with a spin coat process. The film thickness was 50 nm. Subsequently, a film was formed by using a chloroform solution of the aforementioned conventional compound (CBP) mixed with Complex 1 of 12% by mass.

The film thickness was 50 nm. On the film formed above, a film of 1,3,5-tris [2-N-phenylbenzimidazololyl?] benzene having a thickness of 50 nm was formed. Thereafter, LiF as a reductive dopant was vapor deposited and a LiF film was formed as the electron injecting layer (or the cathode). On the LiF film, metallic aluminum was vapor deposited to form a metal cathode and an organic EL device was prepared. Current efficiency of the fabricated organic EL device was measured at the condition of applying DC voltage as described in Table 1. The results are shown in Table 1.

### Example 8

An organic EL device was fabricated similarly as Example 7 except that Complex 2 was used in place of Complex 2 and then the same measurement as that of Example 7 was carried out. The results are shown in Table 1. In Example 8, Complex 2 was synthesized as follows.

### (1) Synthesis of Compound 7

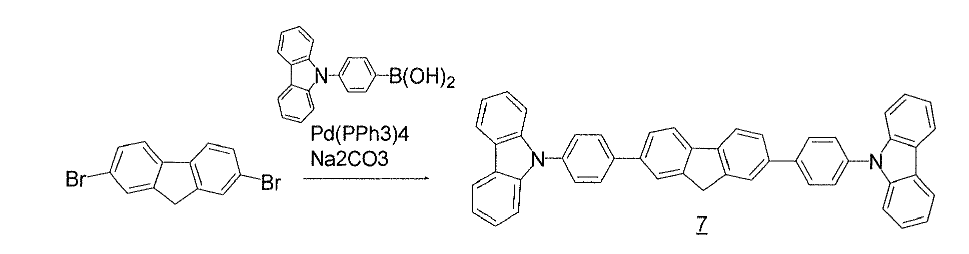

Under the atmosphere of argon gas, 2,7-dibromofluorene (5 g, 15.4 mmol), 4-(N-carbazolyl)-phenylboronic acid (11.1 g, 38.6 mmol),tetrakis(triphenylphosphino) palladium (1.07 g, 0.92 mmol), toluene (100 milliliter) and an aqueous solution (46 milliliter) of 2M sodium carbonate were mixed and then the resultant mixture was refluxed under heating for 10 hours. The precipitated solid after pouring water in the resultant reaction solution was filtrated and washed by water. The obtained solid was refined with silica gel column chromatography (dissolution solvent: methylene chloride) and as a result, Compound 7 was obtained.

### (2) Synthesis of Compound 8

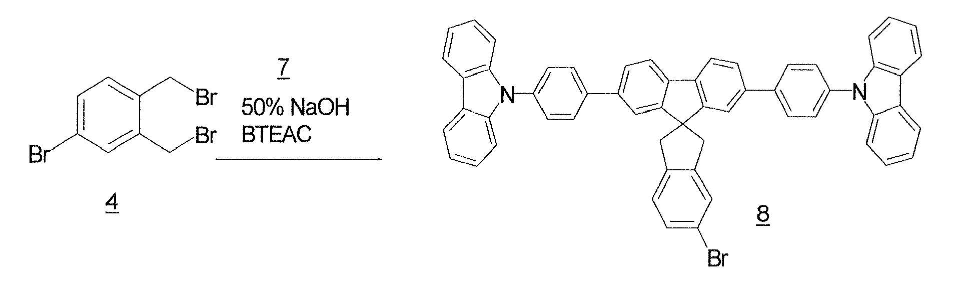

Compound 8 was obtained similarly as Synthesis of Compound 5 except that Compound 7 (6.5 g, 10mmol) was used in place of Compound 1. Product Amount: 4.1 g, Yield: 50 %

### (3) Synthesis of Compound 9

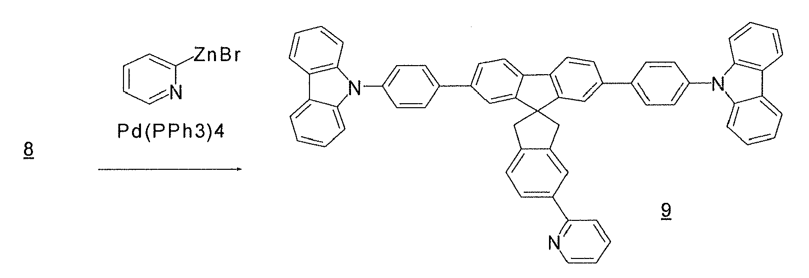

Compound 9 was obtained similarly as Synthesis of Compound 6 except that Compound 8 (3.7 g, 4.4 mmol) was used in place of Compound 5. Product Amount: 2.5 g, Yield: 68 %

### (4) Synthesis of Complex 2

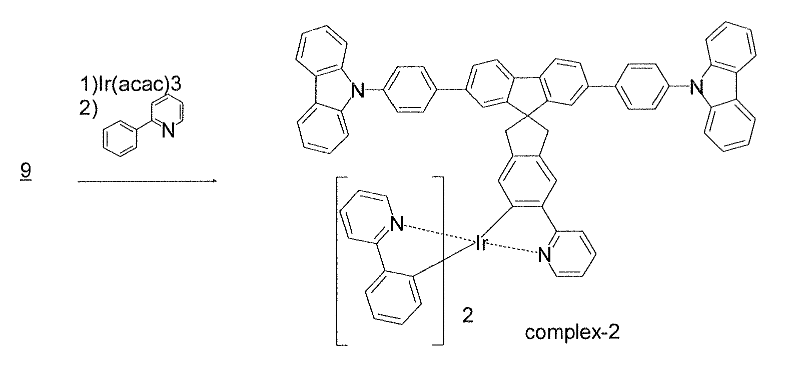

Complex 2 (complex-2) was obtained similarly as Synthesis of Complex 1 except that Compound 9 (1.8 g, 2.2 mmol) was used in place of Compound 6. Product Amount: 2.5 g, Yield: 68 %

It was confirmed in accordance with 90MHz ¹H-NMR and Field Desorption Mass Spectrometry (FD-MS) that the obtained was Complex 2 represented by the above formula.

### Comparative Example 3

An organic EL device was fabricated similarly as Example 7 except that a mixture obtained by adding 12 % by mass of Ir(ppy)₃ into CBP was used as a light emitting layer in place of Complex 1. The results were shown in Table 2. Table 2

| | Example 7 | Example 8 | Comparative Example 3 |
|---|---|---|---|
| Material in Emitting layer | complex-1/CBP | complex-2/CBP | Ir(ppy)₃/CBP |
| Applied Voltage(V) | 5.8 | 5.6 | 6.0 |
| Current Efficiency (cd/A) | 31.3 | 34.0 | 12.2 |

As shown in Table 2, they verify that the organic EL device of Examples 7 and 8 which employ Complex 1 or Complex 2 of the present invention exhibit an excellent luminance under a low driving voltage in comparison with the organic EL device of Comparative Example 3 employing a conventional material of Ir (ppy)₃.

### Example 9

### (I) Synthesis of Complex 3

### (1) Synthesis of Compound 10

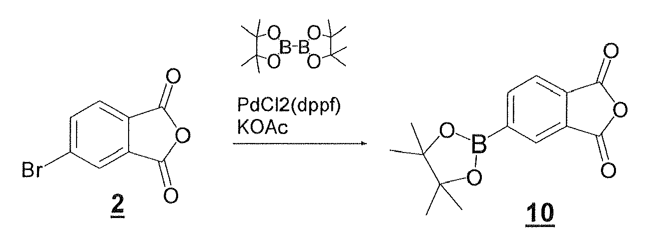

Under the atmosphere of argon gas, Compound 2 (5 g, 22 mmol), bis(pinacorate diborane (5.1 g, 20mmol), [1,1-bis(diphenylphosphine) ferrocene] dichloropalladium (II)/metylene chloride complex (0.49 g, 0.6 mmo;) and potassium acetate (5.9 g, 60 mmol) were dissolved in dimethylsulfoxide and then the resultant mixture was heated at 80°C for 10 hours. The solid was precipitated by pouring water (100 milliliter) in the resultant reaction solution and dried under vacuum. The obtained solid was refined with silica gel column chromatography (dissolution solvent: methylene chloride) and as a result, Compound 10 was obtained.
Product Amount: 5.0 g, Yield: 92 %

### (2) Synthesis of Compound 11

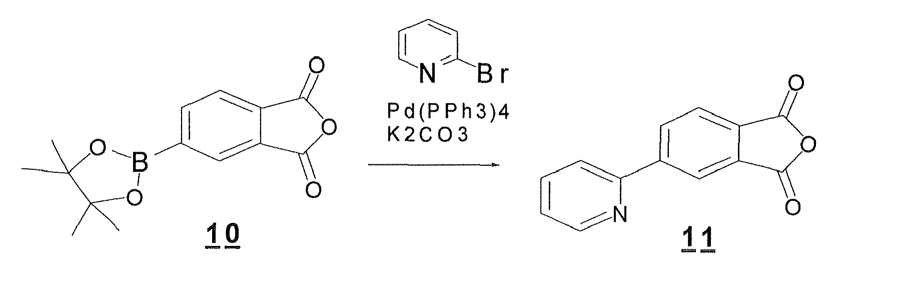

Under the atmosphere of argon gas, Compound 10 (5.0 g, 18.4 mmol)2-bromopyridine (3.49 g, 22 mmol), tetrakis(triphenylphosphino) palladium (0.63 g, 0.55 mmol) and an aqueous solution (28 milliliter) of 2M sodium carbonate were added in toluene (50 milliliter) and then the resultant was heated at 80°C for 10 hours. The solid was precipitated by pouring water (100 milliliter) in the resultant reaction solution and dried under vacuum. The obtained solid was refined with silica gel column chromatography (dissolution solvent: methylene chloride) and as a result, Compound 11 was obtained.
Product Amount: 3.4 g, Yield: 83 %

### (3) Synthesis of Compound 12

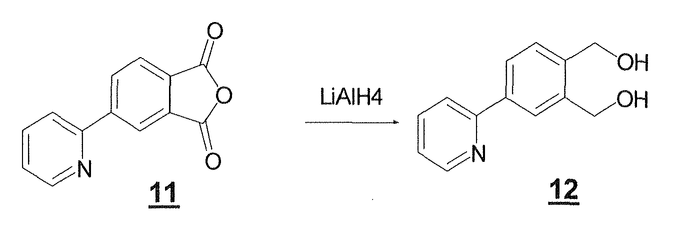

Under the atmosphere of argon gas, lithium aluminium hydride (1.2 g, 30.5 mmol) was suspended in tetrahydrofuran anhydride (100 milliliter), and then Compound 11 (3.5 g, 3 mmol) was dropped in a tetrahydrofran anhydride solution (100 milliliter) at room temperature. After 2 hours stirring thereof, ethylacetate (100 milliliter) and water were poured in the resultant reaction solution in this order.

Subsequently, the resultant reaction solution was filtrated, and then an organic layer was separated by adding ethylacetate, followed by drying thereof with the use of magnesium sulfate anhydride. The solvent of the organic layer was distilled, and as a result, Compound 12 was obtained.
Product Amount: 3.1 g, Yield: 95 %).

### (4) Synthesis of Compound 13

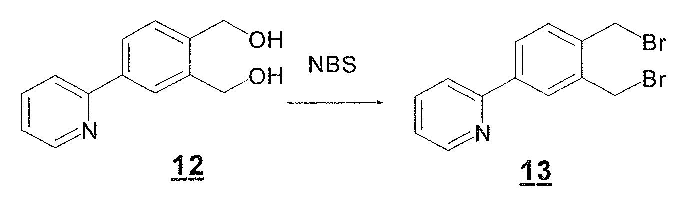

Into a solution of methylene chloride (50 milliliter) dissolved with Compound 12 (3.1 g, 14.5 mmol), N-bromosuccinimide (5.2 g, 29 mmol) was added, and then resultant was stirred at room temperature for 6 hours. The precipitated solid by adding water (200 milliliter) in the resultant reaction solution was washed by ethanol, and as result, Compound 13 was obtained.
Product Amount: 4.5 g, Yield: 91 %.

### (5) Synthesis of Compound 14

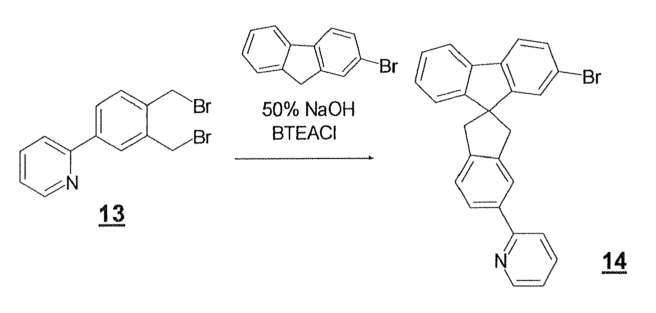

Under the atmosphere of argon gas, 2-bromofluorene (2.45 g, 10 mmol), Compound 13 (3.4 g, 10 mmol), toluene (15 milliliter), dimethylsulfoxide (15 milliliter), benzyltriethylammonium chloride (0.05 g, 0.22 mmol) and an aqueous solution (4 milliliter) of sodium hydroxide (50 % by weight) were mixed and the resultant mixture was stirred at 80°C for 8 hours. After pouring water (100 milliliter) and toluene (100 milliliter) in the resultant reaction solution, an organic layer was separated. The layer was washed by saturated salt water, followed by drying thereof with the use of magnesium sulfate anhydride.

The solvent of the organic layer was distilled and then the residue obtained was refined with silica gel column chromatography (hexane/methylene chloride) and as a result, Compound 14 was obtained.
Product Amount: 2.3 g, Yield: 54 %.

### (6) Synthesis of Compound 15

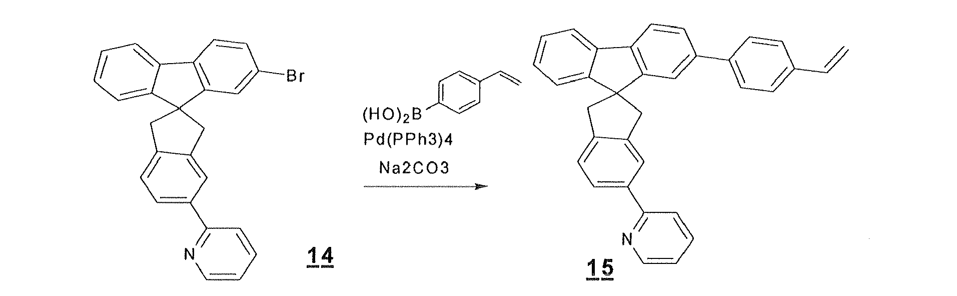

Under the atmosphere of argon gas, Compound 14 (2.3 g, 5.4 mmol)4-vinylphnyl boronic acid (0.8 g, 5.4 mmol) and tetrakis(triphenylphosphino) palladium (0.19 g, 0.16 mmol) were added in dimethoxyethane (10 milliliter) and an aqueous solution (8 milliliter) of 2M sodium carbonate and then the resultant was stirred at 60°C for 10 hours.

After pouring water (100 milliliter) and toluene (100 milliliter) in the resultant reaction solution, an organic layer was extracted, followed by drying the organic layer with the use of magnesium sulfate anhydride. The solvent of the organic layer extracted was condensated under vacuum and then the residue obtained was refined with silica gel column chromatography (hexane/methylene chloride) and as a result, Compound 15 was obtained.
Product Amount: 1.1 g, Yield: 46 %.

### (7) Synthesis of Compound 16

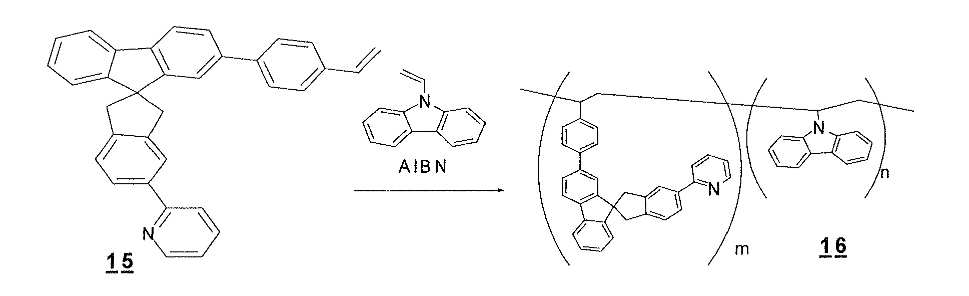

N-vinylcarbazole (0.81 g, 4.2 mmol), Compound 15 (0.1 g, 0.22 mmol) and 2,2-azobis(isobutylonitrile) (0.01 g, 0.061 mmol) were added in butylacetate (10 milliliter), and then the resultant was stirred at 80°C for 10 hours. The solid was precipitated by adding acetone in the resultant reaction solution and the solid was filtrated. Further, the solid was dissolved in methylene chloride, and then the solid was precipitated by adding methanol therein, followed by washing the solid with methanol, and as result, Compound 16 was obtained. Product Amount: 0.83 g.

By means of NMR analysis, "M : n = 5 : 95" in Compound 16 was proved. In addition, the molecular weight thereof was 18,000 as reduced to polystyrene.

### (7) Synthesis of Complex 3

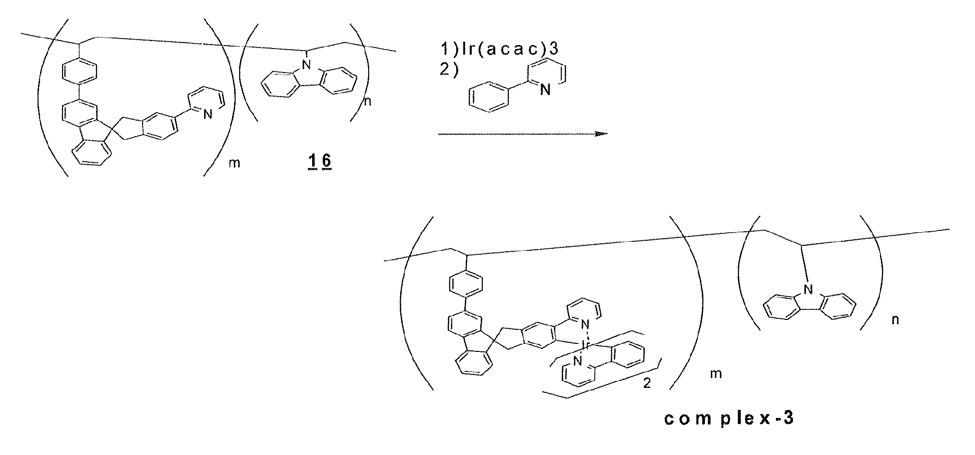

Into a flask, of which atmosphere was already replaced by argon gas, Compound 6 (0.8 g), Ir (acac)₃ (0.1g, 0.2 mmol) and glycerol (50 milliliter) were poured, and then the resultant was stirred at 250 °C for 15 hours. Further, 2-phenylpyridine (0.068 g, 0.44 mmol) was added in the resultant reaction solution, and then the resultant was stirred at 250°C for 10 hours. The solid was precipitated by adding methanol in the resultant reaction solution and then the solid was filtrated, followed by washing the solid with methanol, and as result, Complex 3 (complex-3) was obtained. Product Amount: 0.8 g

By means of elementary analysis of CHN and Ir, it was identified as Complex 3 represented by the aforementioned formula.

### (II) Fabrication of an organic EL device

A glass substrate (manufactured by GEOMATEC Company) of 25 mm×75 mm×1.1 mm thickness having an ITO transparent electrode was cleaned by application of ultrasonic wave in isopropyl alcohol for 5 minutes and then by exposure to ozone generated by ultraviolet light for 30 minutes. On the substrate, a film of polyethylenedioxythiophene polystylene sulfonate (PEDOT/PSS) was formed in accordance with a spin coating process. The film thickness was 50 nm.

Subsequently, a film was formed by using a chloroform solution of Complex 3. The film thickness was 50 nm. On the film formed above, a film of 1,3,5-tris(2-N-phenylbenzimidazololyl) benzene having a thickness of 50 nm was formed. Thereafter, LiF as a reductive dopant was vapor deposited and a LiF film was formed as the electron injecting layer (or the cathode). On the LiF film, metallic aluminum was vapor deposited to form a metal cathode and an organic EL device was fabricated.

Current Efficiency of the fabricated organic EL device was measured at the condition of applying DC voltage as described in Table 2 and further a sate of light emission about the light emitting surface after storing the device at the elevated temperature (110 °C, after 50 hours) was observed. The results are shown in Table 3. Table 3

| | Example 9 | Comparative Example 4 |
|---|---|---|
| Material in Emitting layer | complex-3 | complex-5 |
| Applied Voltage(V) | 8.4 | 10.2 |
| Current Efficiency (cd/A) | 14.1 | 2.3 |
| Surface state of light emitting face after storing at the temperature of 100 °C for 50 hours | Good | Found many dark spots |

As shown in Table 3, it verifies that the organic EL device of Examples 9 which employed Complex 3 as a material for the organic EL device of the present invention is activated under a low driving voltage and exhibits an excellent luminance and excellent resistance to elevated temperature in comparison with the organic EL device of Comparative Example 4. In addition, as evidenced by Comparative Example 4, a metal compound having an ester part is poor at thermal stability, therefore, many dark spots were generated in a device used such compound.

### Example 10

An organic device was fabricated similarly as Example 9 except that Complex 4 was used in place of Complex 3. Current efficiency of the fabricated organic EL device was measured at the condition of applying DC voltage as described in Table 4 and further a sate of light emission about the light emitting surface after storing the device at the elevated temperature (110 °C, after 50 hours) was observed. The results are shown in Table 4. In Example 10, Complex 4 was synthesized as follows.

### (1) Synthesis of Compound 17

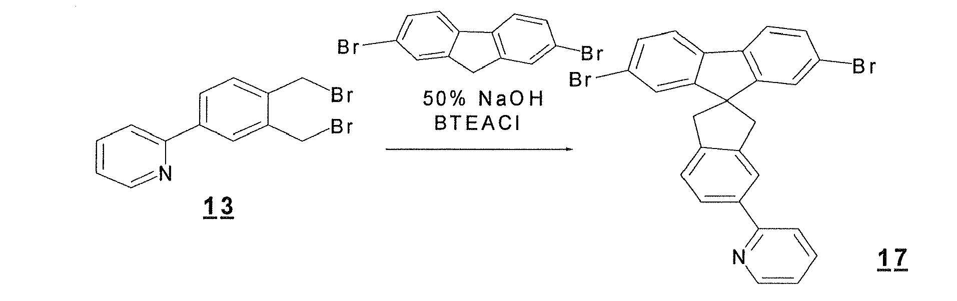

Under the atmosphere of' argon gas, 2,7-dibromofluorene (3.24 g, 10 mmol), Compound 13 (3.4 g, 10 mmol), toluene (15 milliliter), dimethylsulfoxide (15 milliliter), benzyltriethylammonium chloride (0.05 g, 0.22 mmol) and an aqueous solution (4 milliliter) of sodium hydroxide (50 % by weight) were mixed and the resultant mixture was stirred at 80°C for 8 hours.

After pouring water (100 milliliter) and toluene (100 milliliter) in the resultant reaction solution, an organic layer was separated from it. The layer was washed by saturated salt water, followed by drying thereof with the use of magnesium sulfate anhydride.

The solvent of the organic layer was distilled and then the residue obtained was refined with silica gel column chromatography (hexane/methylene chloride) and as a result, Compound 14 was obtained.

Product Amount: 2.2 g, Yield: 43 %.

### (2) Synthesis of Copolymer 18

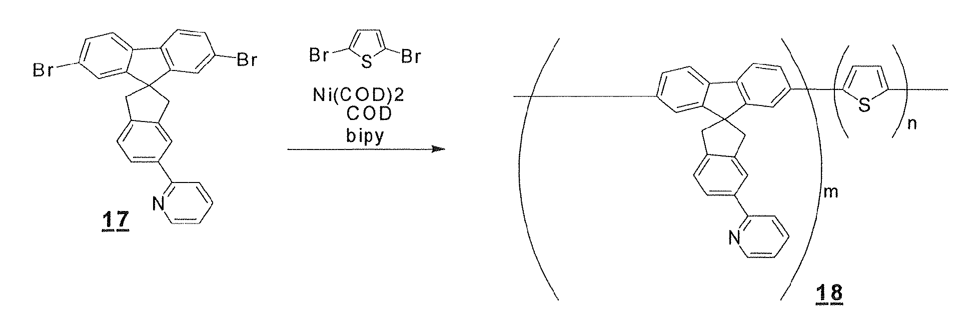

Under the atmosphere of argon gas, Compound 17 (0.15 g, 0.3 mmol) and 2,5-dibromothiophene (1.38 g, 5.7 mmol) were added in dimethylformamide (10 milliliter) and then the polymerization of thereof carried out by using bis(1,5-cyclooctadiene) nickel (0) as a catalyst in accordance with a conventional method. The solid was precipitated by adding water in the resultant reaction solution and the solid was washed with methanol. The obtained solid was dried under vacuum, and as result, Compound 18 was obtained. Product Amount: 0.51 g

By means of NMR analysis, "M : n = 5 : 95" in Compound 18 was proved. In addition, the molecular weight thereof was 18,000 as reduced to polystyrene.

### (3) Synthesis of Complex 4

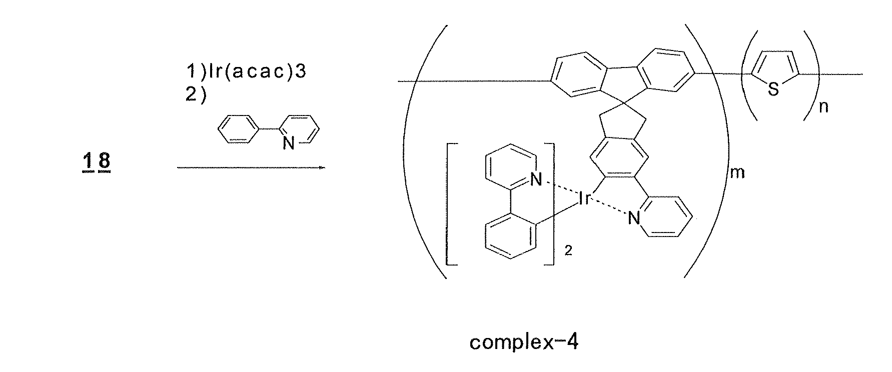

Under the atmosphere of argon gas, Compound 18 (0.51 g) and Ir(acac)₃ (0.13 g, 027 mmol) were added in metacresol, and then the resultant was stirred at 250°C for 12 hours. Subsequently, phenylpyridine (0.08 g, 0.58 mmol) was added, in the resultant solution, followed by stirring at 250°C for 12 hours. After the reaction was over, reprecipitation was carried out by adding acetone therein, and then the copolymer was recovered by filtration. A DMF solution of the copolymer was poured in acetone so as to cause reprecipitation, and then the precipitate was filtrated. The recovered precipitate was dried under vacuum and then Complex 4 (complex-4) was obtained.
Product Amount: 0.52 g

By means of elementary analysis of CHN and Ir, it was identified as Complex 4 represented by the aforementioned formula.

### Comparative Example 4

An organic device was fabricated similarly as Example 9 except that Complex 5 was used in place of Complex 3, and the same measurement with Example 9 carried out on the organic device. The results are shown in Table 3.
The molecular weight of Complex 5 was 17,000 as reduced to polystyrene, and it was proved as m : n = 5 : 95 in the formula below.

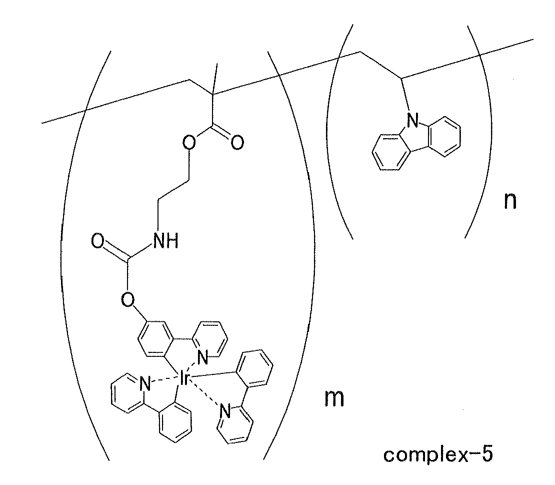

### Comparative Example 5

An organic device was fabricated similarly as Example 9 except that Complex 6 (complex-6) was used in place of Complex 3, and the same measurement with Example 9 carried out on the organic device. The results are shown in Table 4. The molecular weight of Complex 5 was 18,000 as reduced to polystyrene, and it was proved as m : n = 5 : 95 in the formula below.

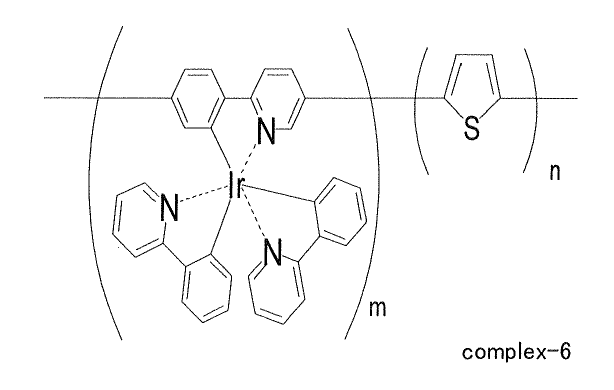

**Table 4**

| | Example 10 | Comparative Example 5 |
|---|---|---|
| Material in Emitting layer | complex-4 | complex-6 |
| Applied Voltage(V) | 6.3 | 8.7 |
| Current Efficiency (cd/A) | 25.6 | 15.8 |

As shown in Table 4, it verifies that the organic EL device of Example 10 which employs Complex 4 as a material for the organic EL device of the present invention is activated under a low driving voltage and also exhibits an enhanced current efficiency and excellent resistance to elevated temperature in comparison with the organic EL device of Comparative Example 5.

### INDUSTRIAL APPLICABILITY

As explained above in details, since the coordination metal compound and the material for an organic EL device of the present invention have at least one ligand containing a spiro bond of large steric hindrance, they are able to control association between the molecules, therefore the organic EL device employing the compound or the material as an light emitting layer exhibits an enhanced efficiency of light emission and has great storage stability at elevated temperature. Further, since the coordination metal compound and the material for an organic EL device of the present invention exhibits excellent solubility in an organic solvent, and can be applied, as the material for luminescent coating formation, to a wet film forming process such as a spin coating process, it is possible to provide an organic EL device at a lower cost. Therefore, the EL device employing the coordination metal compound and the material for an organic EL device of the present invention is distinctly useful as a practicable organic device.

## Claims

1. A coordination metal compound comprising a metal cordinated with at least one ligand having a spiro bond.

2. The coordination metal compound according to Claim 1, wherein the coordination metal compound is represented by the general formula (1):
(L₁)x-M-(P-M)y-(L₂)z (1)
wherein M represents a metal atom of iridium (Ir), platinum (Pt), osmium (Os), rhodium (Rh), rhenium (Re), palladium (Pd), ruthenium (Ru), tungsten (W), gold (Au) or silver (Ag); and L₁ represents a ligand cordinating to the metal atom M and also having a spiro bond,
L₂ represents a ligand cordinating to the metal atom M,
P represents a ligand interconnecting to the metal atom M when y is 1 or greater,
**x** represents an integer of from 1 to the valence of a metal atom M, y represents an integer of from 0 to 4 and z represents an integer of from 0 to 4, further, plural M each represents the same with or different from each other when y is 1 or greater.

3. The coordination metal compound according to claim 2, wherein L₁ represents a ligand represented by the general formula (2):
A-(C)p-(B)q-(C)p-D- (2)
wherein A represents a group expressed by any of the general formulae (3) to (12): 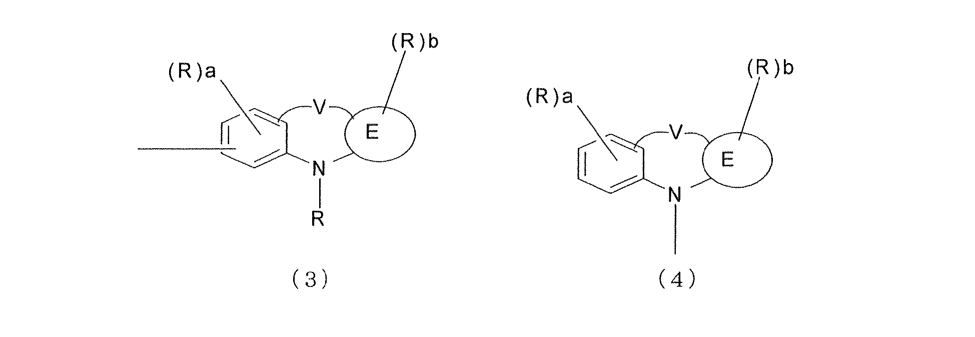 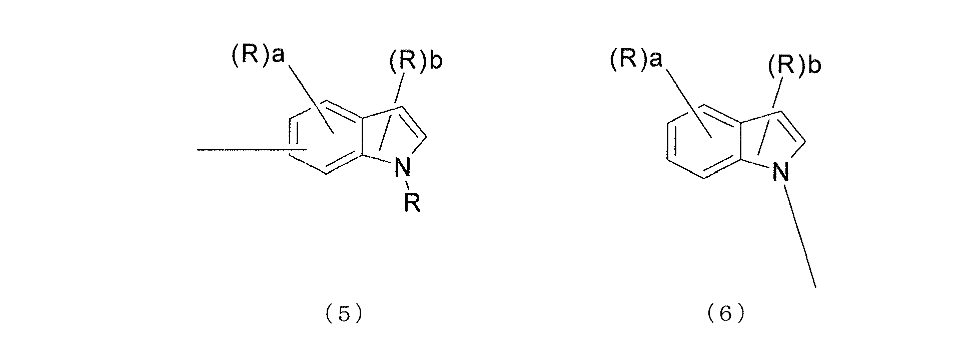 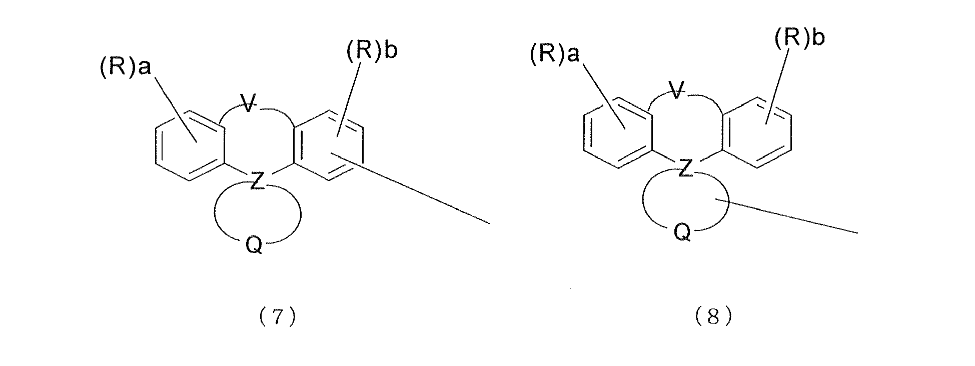 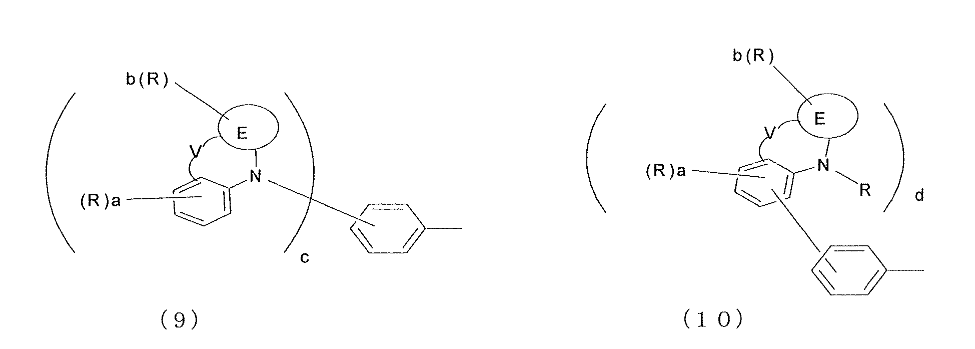 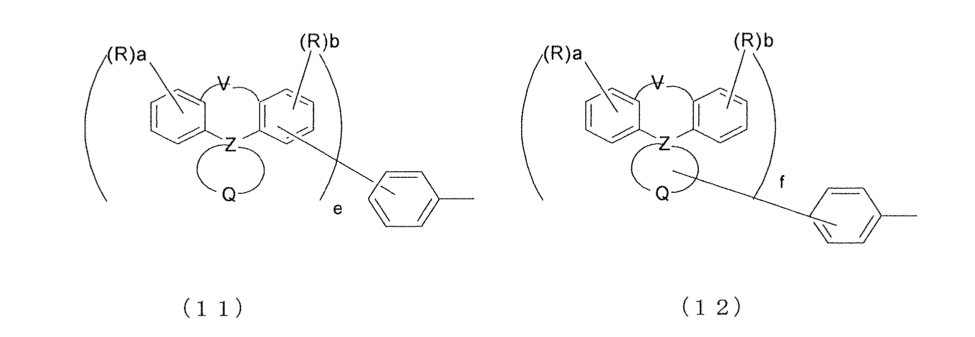 wherein R each independently represents a substituted or unsubstituted aromatic group having 6 to 50 ring carbon atoms, a substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group or a hydroxyl group; R may be bonded with each other to form a ring structure;
V each independently represents a single bond, -CR₀R₀'-, -Si R₀R₀'-, -O-, -CO- or -NR₀ (R₀ and R₀' each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms;
E each independently represents a ring structure shown by a circle enclosing the symbol E, and a substituted or unsubstituted cycloalkane, of which a carbon atom may be substituted by a nitrogen atom, moiety having 3 to 6 ring carbon atoms, a substituted or unsubstituted aromatic hydrocarbon moiety having 4 to 6 ring carbon atoms, or a substituted or unsubstituted aromatic heterocyclic moiety having 4 to 6 ring atoms;
Q each independently represents an atomic group forming a ring structure,
Z each independently represents -CR₀R₀'-, -SiR₀R₀'- or -GeR₀R₀'-; Ge means a germanium atom, while R₀ and R₀' represent the same as aforementioned;
a and b each independently represents an integer of from 0 to 4, and c, d, e and f each independently represents an integer of from 2 to 4;
C each independently represents a substituted or unsubstituted alkylene group having 1 to 50 carbon atoms, or a substituted or unsubstituted aromatic hydrocarbon group having 6 to 50 ring carbon atoms and plural C, if any, may be the same with or different from each other;
p represents an integer of form 0 to 20;
B represents a group represented by the general formulae (13) to (15), and may be composed of each group singly or in combination thereof, and q represents an integer of from 0 to 20; 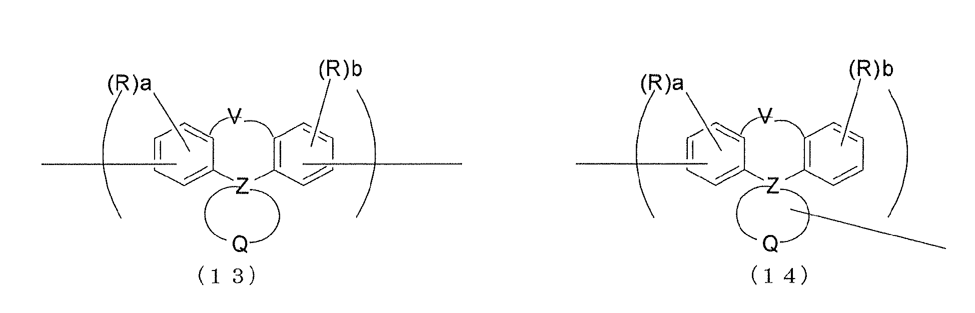 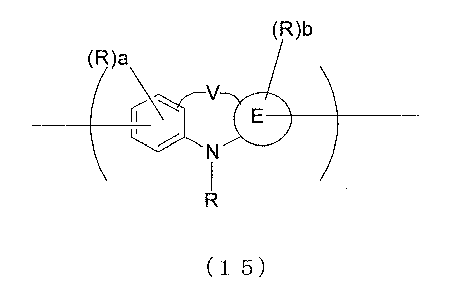 wherein **R, V, E, Z, Q, a** and **b** each independently represents the same as aforementioned;
**D** represents a site coordinating to a metal atom;
however, at least one of **A** or **B** in the general formula (2) comprises at least one of the structure having a spiro bond.

4. The coordination metal compound according to claim 2, wherein, L¹ in the general formula (2) represents a ligand expressed by the general formula (16): 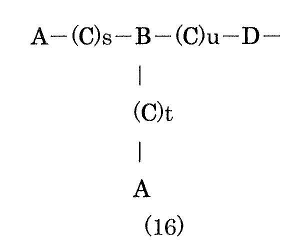 wherein A represents a group represented by any of the general formula (3) to (12); and plural A, if any, may be the same with or different from each other, 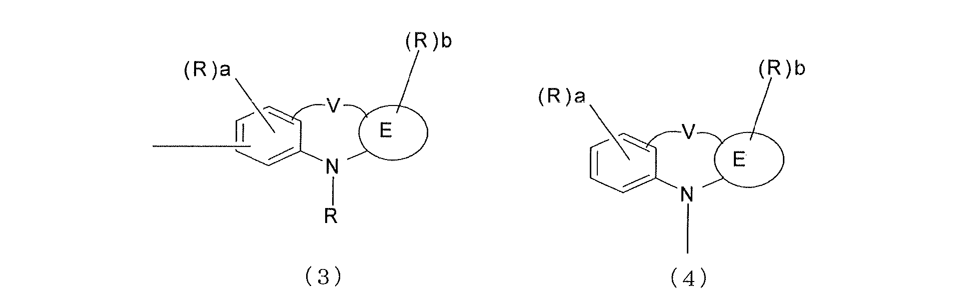 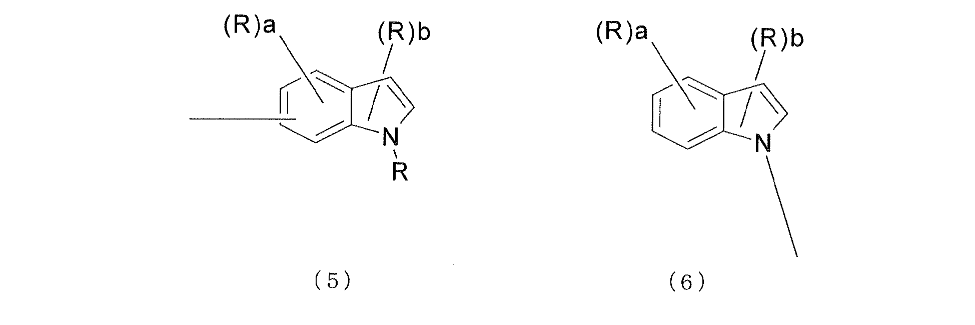 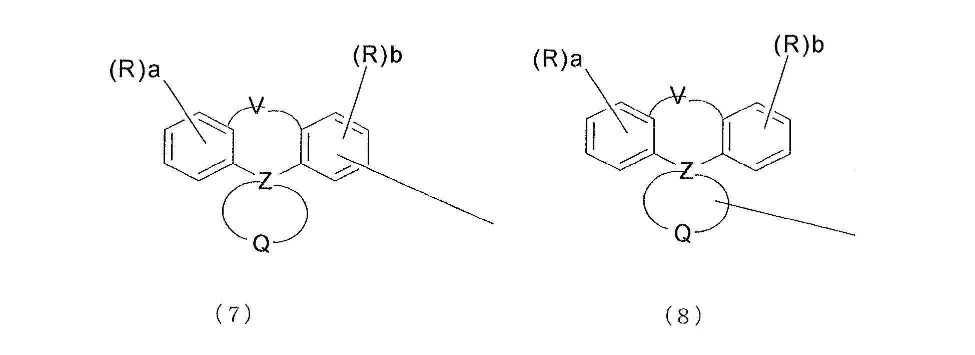 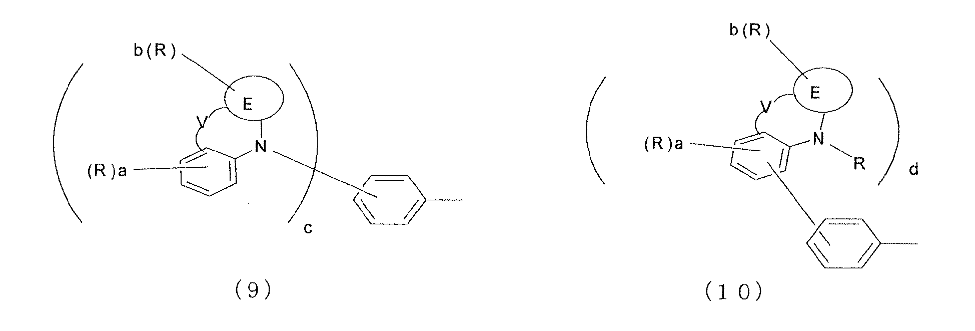 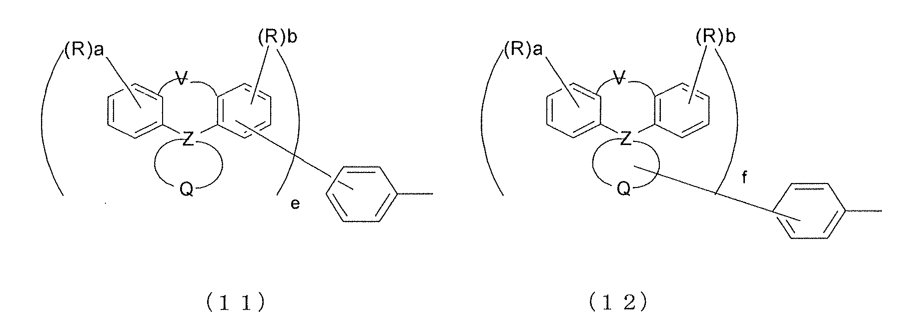 wherein **R** each independently represents a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms, a substituted or unsubstituted alkoxy group having 1 to 50 carbon atoms, a substituted or unsubstituted aralkyl group having 7 to 50 ring carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group, a nitro group, a hydroxyl group and the like; R may be bonded with each other to form a ring structure,
V each independently represents a single bond, -CR₀R₀'-, -SiR₀R₀'-, -O-, -CO- or -NR₀ (R₀ and R₀' each independently represents a hydrogen atom, a substituted or unsubstituted aromatic group having 6 to 50 ring carbon atoms, a substituted or unsubstituted aromatic heterocyclic group having 5 to 50 ring carbon atoms, or a substituted or unsubstituted alkyl group having 1 to 50 carbon atoms),
**E** each independently represents a ring structure shown by a circle enclosing the symbol **E,** and a substituted or unsubstituted cycloalkane, of which a carbon atom may be substituted by a nitrogen atom, moiety having 3 to 6 ring carbon atoms, a substituted or unsubstituted aromatic hydrocarbon moiety having 4 to 6 ring carbon atoms, or a substituted or unsubstituted aromatic heterocyclic moiety having 4 to 6 ring atoms;
**Q** each independently represents an atomic group forming a ring structure,
**Z** each independently represents -CR₀R₀'-, -SiR₀R₀'-, or -GeR₀R₀'- wherein Ge means a germanium atom, while both R₀ and R₀' represent the same as aforementioned;
a and b each independently represents an integer of from 0 to 4, and c, d, e and f each independently represents an integer of from 2 to 4;
C each independently represents a substituted or unsubstituted alkylene group having 1 to 50 carbon atoms, or a substituted or unsubstituted aromatic hydrocarbon group having 6 to 50 ring carbon atoms and plural C, if any, may be the same with or different from each other;
s, t and u each independently represents an integer of from 0 to 20;
B represents a group represented by any one of the general formulae (17) to (19), below and may be used alone or in combination thereof; 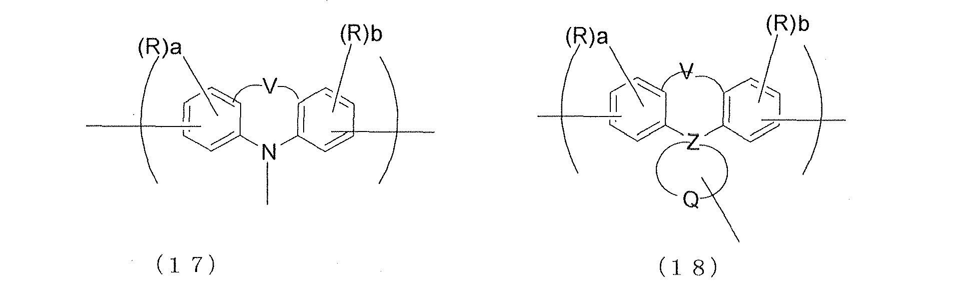 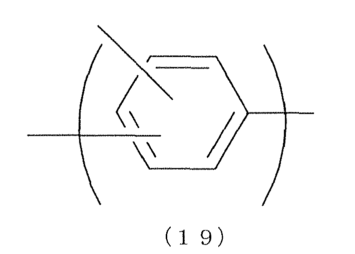 wherein **R, V, Z, Q, a** and b each independently represents the same as the aforementioned;
D represents a site coordinating to a metal atom;
however, at least one of **A** or **B** in the general formula (16) comprises at least one of the structure having a spiro bond.

5. The coordination metal compound according to Claim 3, wherein said D coordinating to a metal atom in the general formula (2) represents a group formed by removing a hydrogen atom from the molecule represented by the general formula (20): 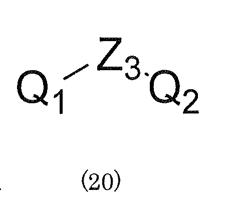 wherein, Q₁ and Q₂ each independently represents a substituted or unsubstituted aromatic hydrocarbon group having 6 to 50 ring carbon atoms, a substituted or unsubstituted aromatic heterocyclic group having 5 to 50 ring atoms or a derivative thereof; at least one of Q₁ and Q₂ represents a benzene ring or a derivative thereof; one of Q₁ and Q₂ forms a carbon atom-a metal atom bond with the aforementioned metal atom and the other one forms a coordination bond; Z₃ represents a single bond, -CR₀R₀'-, -SiR₀R₀'-, -O-, -CO- or -NR₀, wherein, R₀ and R₀' each independently represents the same as the aforementioned.

6. The coordination metal compound according to Claim 4, wherein the D coordinating to a metal atom represents a group formed by removing a hydrogen atom from the molecule represented by the general formula (20): 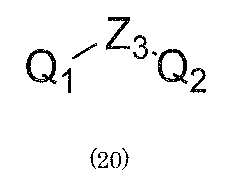 wherein Q₁ and Q₂ each independently represents a substituted or unsubstituted aromatic hydrocarbon group having 6 to 50 ring carbon atoms, a substituted or unsubstituted aromatic heterocyclic group having 5 to 50 ring atoms or a derivative thereof; at least one of Q₁ and Q₂ represents a benzene ring or a derivative thereof; one of Q₁ and Q₂ forms a carbon atom-a metal atom bond with the aforementioned metal atom and the other one forms a coordination bond; Z₃ represents a single bond, -CR₀R₀'-, -SiR₀R₀'-, -O-, -CO- or -NR₀, wherein, R₀ and R₀' each independently represents the same as the aforementioned.

7. The coordination metal compound according to Claim 3, wherein A in the general formula (2) represents a group selected from among the general formulae (5), (6) and (22) to (4-1), and also **B** in the general formula (2) represents a group selected from among the general formulae (42) to (44): 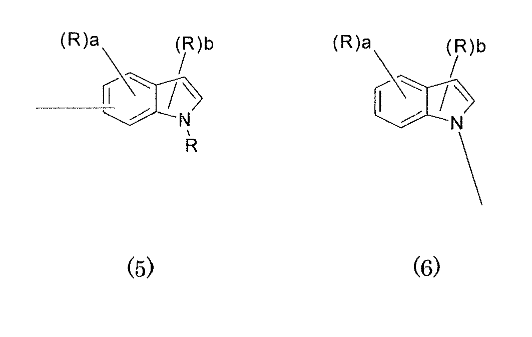 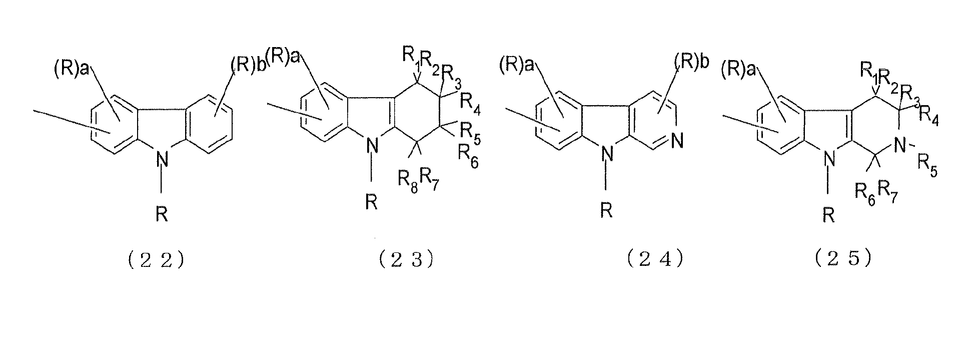 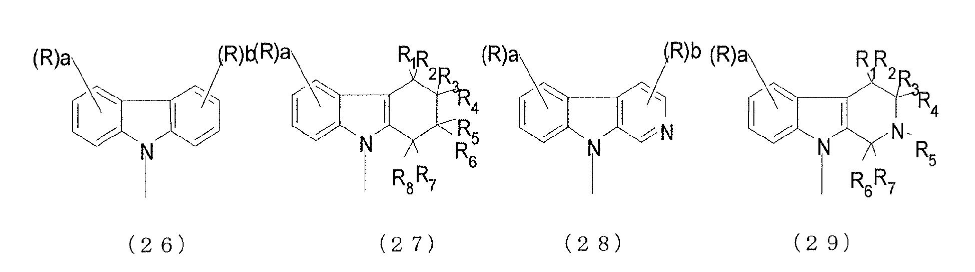 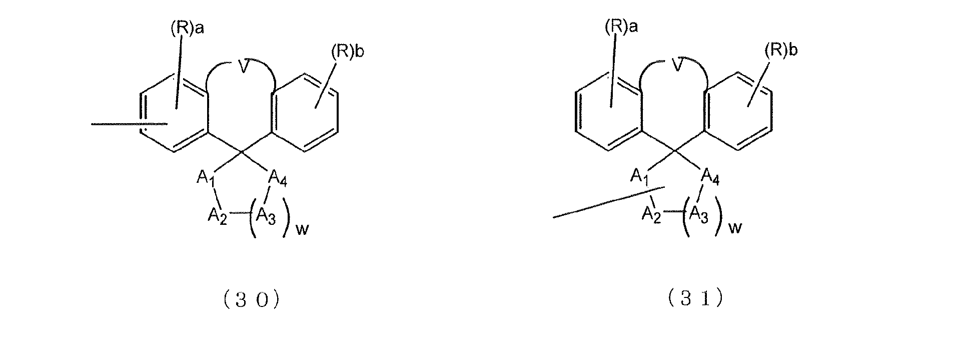 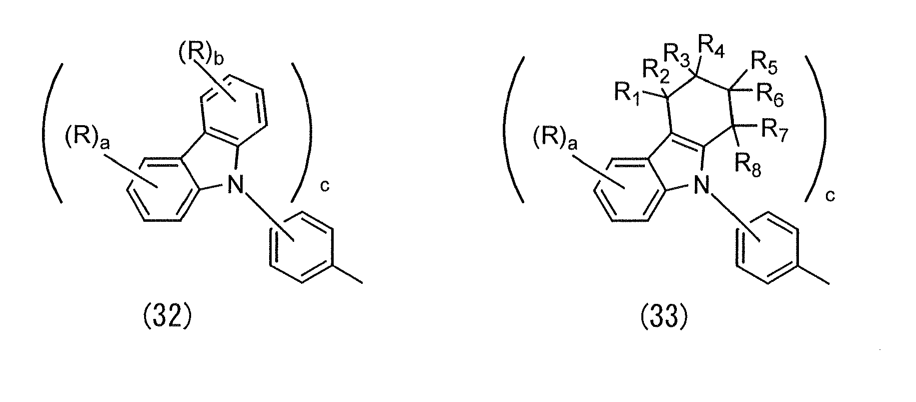 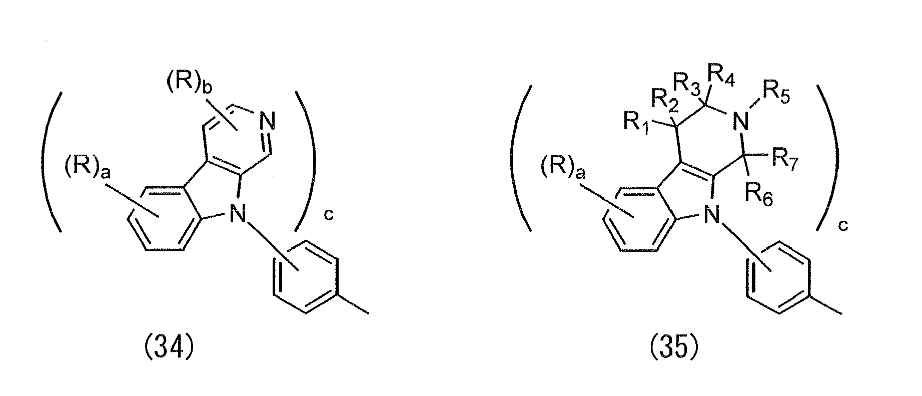 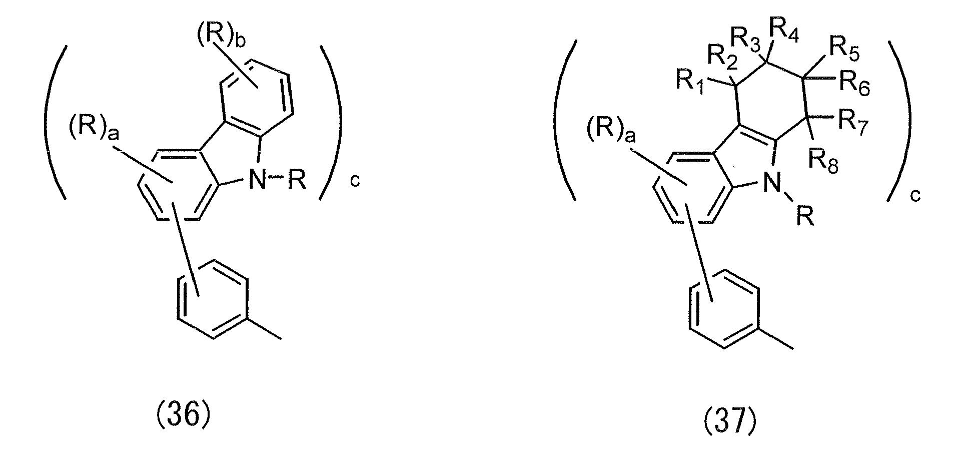 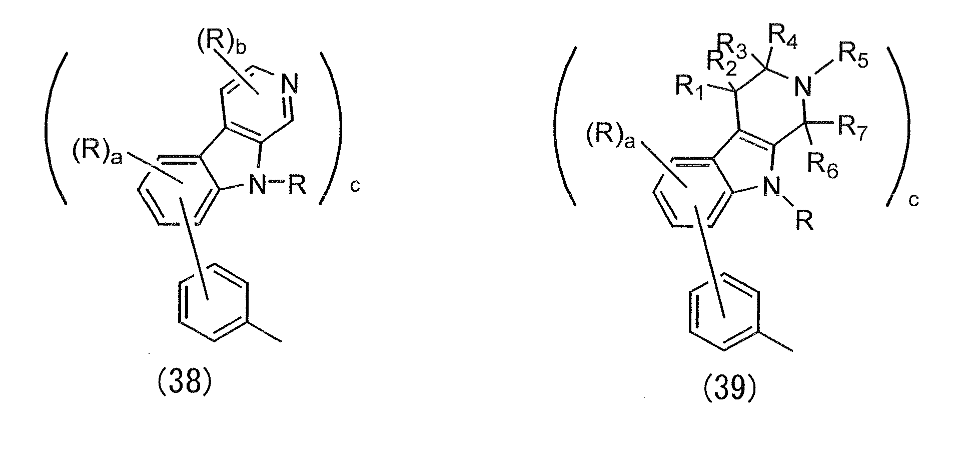 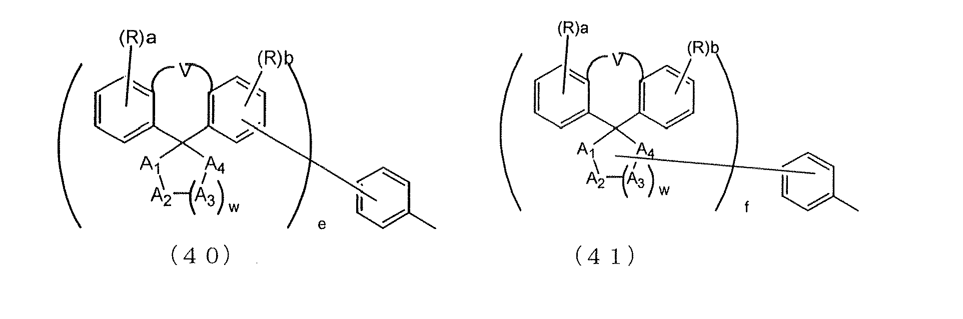 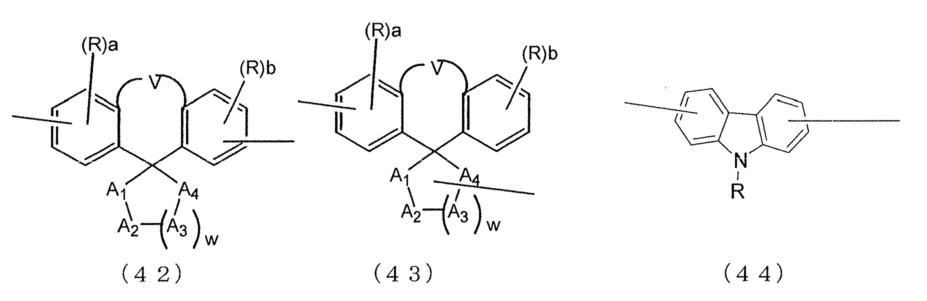 wherein, **R, V, a, b, c, e** and **f** each independently represents the same with the aforementioned, and also R₁ to R₁₀ each independently represents the same with aforementioned **R;** A₁ to A₄ each independently represents **-CR'R"- -SiR'R"-,** -O-, **-NR'-** and -CO-; wherein **R'** and **R"** each independently represents the same with aforementioned **R,** and also may be the same with or different from each other, further, at least two neighboring groups among A₁ to A₄ each independently are expresseed by **-CR'R"-,** and the neighboring **R's,** the neighboring **R"s** or both **R'** and **R"** may bond saturatedly or unsaturatedly forming a ring structure having 4 to 50 carbon atoms as a result, w represents an integer of from 1 to 10.

8. The coordination metal compound according to Claim 4, wherein A in the general formula (16) represents a group selected from among the general formulae (22) to (41), and also **B** in the general formula (16) represents a group selected from the general formula (45) or (46): 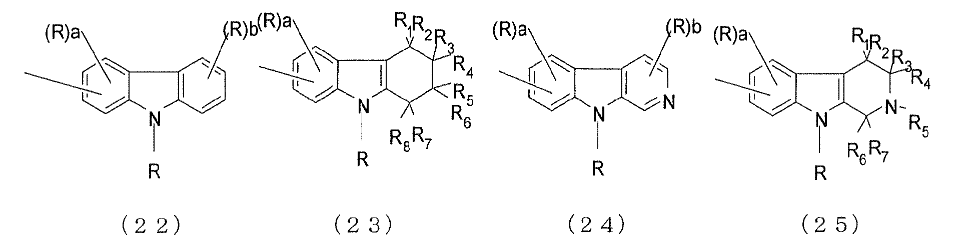 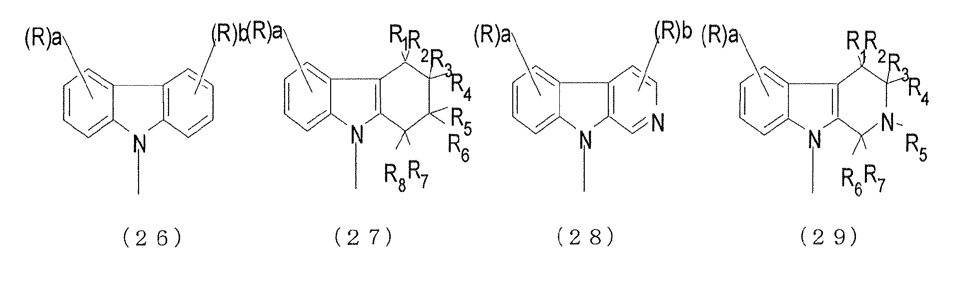 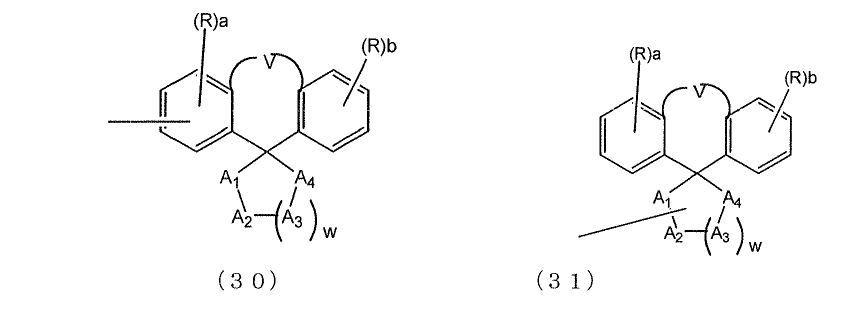 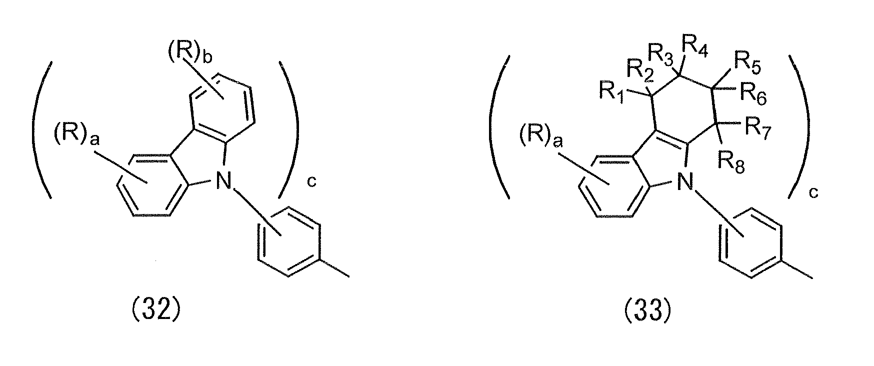 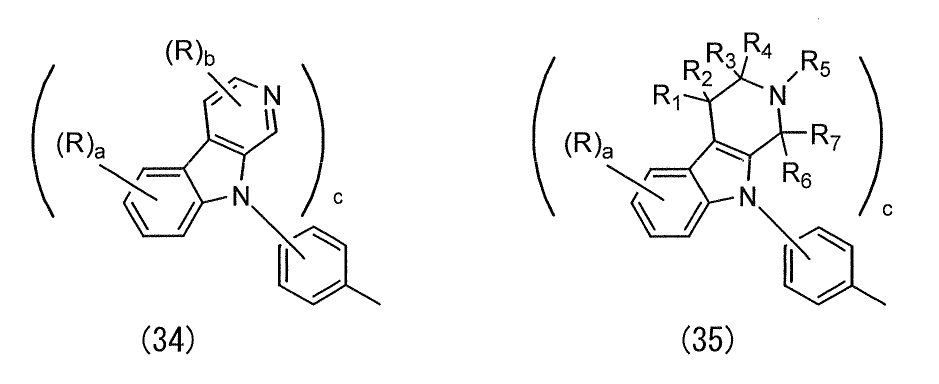 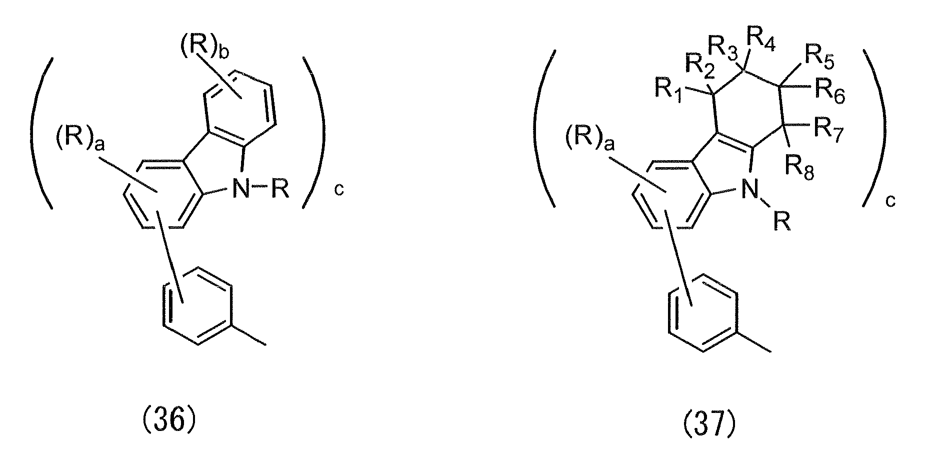 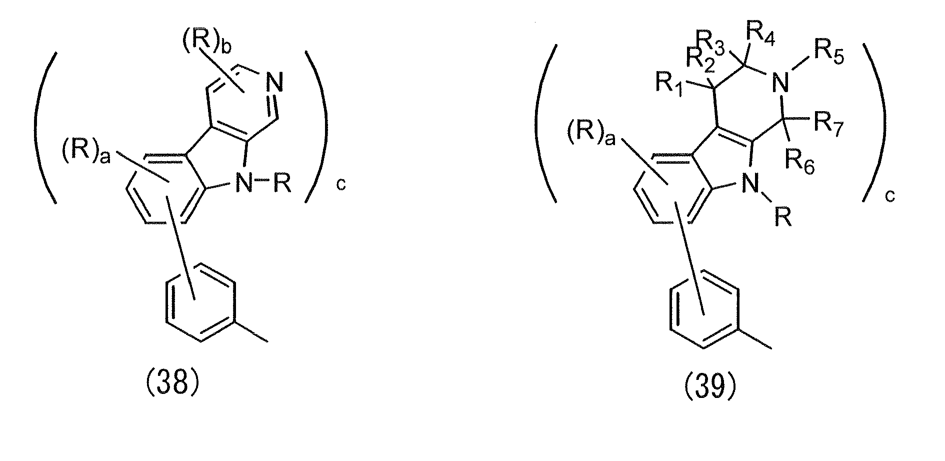 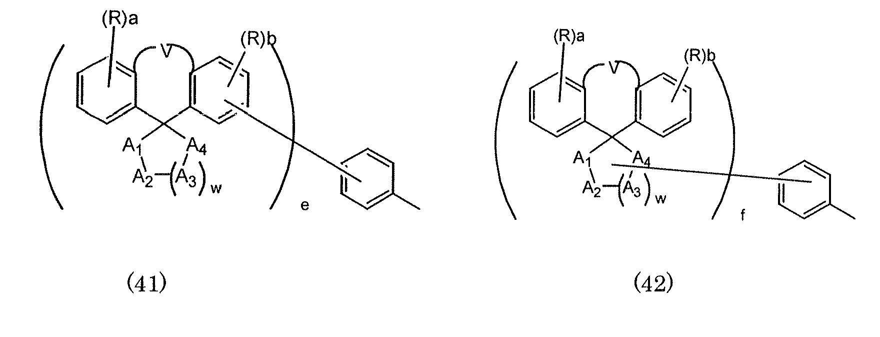 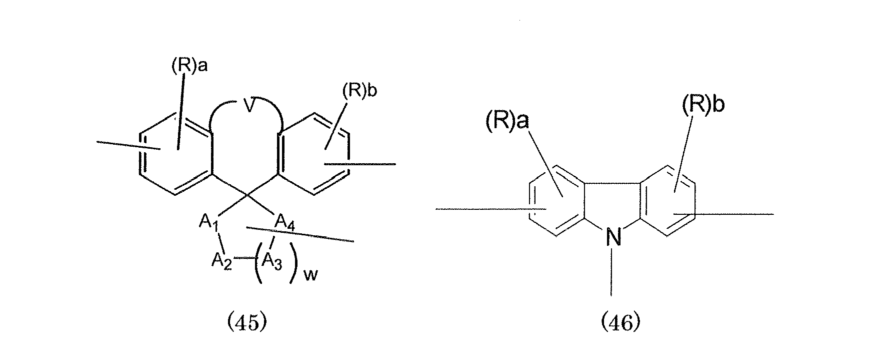 wherein, wherein **R, V, a, b, c, e** and **f** each independently represents the same with the aforementioned, and also R₁ to R₁₀ each independently represents the same with aforementioned **R,** A₁ to A₄ each independently represents **-CR'R"-, -SiR'R"-, -O-,** -NR'- and -CO-; wherein **R'** and **R"** each independently represents the same with aforementioned **R,** and also may be the same with or different from each other, further, at least two neighboring groups among A₁ to A₄ each independently are expressed by **-CR'R"-,** and the neighboring **R's,** the neighboring **R"s** or both R' and R" may bond saturatedly or unsaturatedly forming a ring structure having 4 to 50 carbon atoms as a result, w represents an integer of from 1 to 10.

9. The coordination metal compound according to Claim 2, wherein L₂ in the general formula (1) represents at least one kind selected from the group consisting of a halogen atom, an acetylaceton derivative, an 8-quinolinol derivative and a phenylpyridine derivative.

10. The coordination metal compound according to Claim 3, wherein said D in the general formula (2) represents a phenylpyridine group and said **M** in the general formula (1) represents an iridium atom.

11. The coordination metal compound according to Claim 4, wherein said **D** in the general formula (16) represents a phenylpyridine group and said **M** in the general formula (1) represents an iridium atom.

12. A material for an organic electroluminescence device comprising at least one compound having structure represented by the general formula (1'): 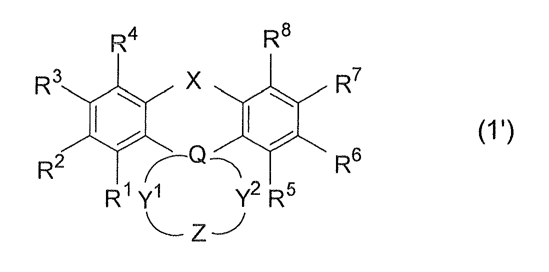 wherein **X,** Y¹ and Y² each independently represents a single bond, **-CR'R"-,-Si R'R"-,-CO-** or **-NR'-; Q** represents a carbon atom, a silicon atom or a germanium atom; **Z** represents a divalent group comprising a heavy metal complex; **R'** and **R"** each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms,
R¹ to R⁸ each independently represents a hydrogen atom or a group selected from among a substituted or unsubstituted alkyl group having 1 to 50 carbon atoms, a substituted or unsubstituted alkenyl group having 1 to 50 carbon atoms, a substituted or unsubstituted alkynyl group having 1 to 50 carbon atoms, a substituted or unsubstituted alkoxy group having 1 to 50 carbon atoms, a substituted or unsubstituted alkylthio group having 1 to 50 carbon atoms, a substituted or unsubstituted amino group having 1 to 50 carbon atoms, a substituted or unsubstituted alkylamino group having 1 to 50 carbon atoms, a substituted or unsubstituted dialkylamino group having 1 to 50 carbon atoms or a substituted or unsubstituted heterocyclic group having 1 to 50 carbon atoms, and an aryl group having 6 to 50 ring carbon atoms, an aryloxy group having 6 to 50 ring carbon atoms, an arylthio group having 6 to 50 ring carbon atoms, an arylamono group having 6 to 50 ring carbon atoms, a diarylamino group having 6 to 50 ring carbon atoms or an alkylarylamino group having 6 to 50 ring carbon atoms; and two neighboring substituent among R¹ to R⁸ may bond each other to form a ring structure.

13. A material for an organic electroluminescence device comprising at least one compound having structure represented by the general formula (4'):
(E¹)-(C¹)ₚ₁-(C²)ₚ₂-(Phos)-(C³)ₚ₃-(C⁴)ₚ₄-(E²) (4')
wherein (Phos) represents a divalent group formed by removing two from among R¹ to R⁸, E ¹ to E² each independently represents a hydrogen atom, or a group selected from among a substituted or unsubstituted aromatic group having 6 to 50 ring carbon atoms, a substituted or unsubstituted aromatic heterocyclic group having 5 to 50 ring atoms, a substituted or unsubstituted alkyl group having 1 to 50 carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 5 to 50 ring atoms, a substituted or unsubstituted arylthio group having 5 to 50 ring atoms, a substituted or unsubstituted alkoxycarbonyl group having 1 to 50 carbon atoms, a carboxyl group, a halogen atom, a cyano group and a hydroxy group, C¹ to C⁴ each independently represents a group selected from a substituted or unsubstituted alkylene group having 1 to 50 carbon atoms and a substituted or unsubstituted divalent aryl group having 6 to 50 carbon atoms; and p1 to p4 each independently represents an integer of from 0 to 20.

14. A material for an organic electroluminescence device comprising a polymer obtained by polymerization or co-polymerization of a compound represented by the general formula (1') according to Claim (12), of which at least one of among R¹ to R⁸ represents a polymerizable group or an aromatic group having 6 to 50 ring carbon atoms with a polymerizable group.

15. A material for an organic electroluminescence device comprising a polymer or a copolymer comprising a unit structure of a divalent group formed by removing two selected from among R¹ to R⁸ in the general formula (1') according to Claim 12.

16. The material for an organic electroluminescence device according to any one of Claims 12 to 15, wherein Z in the general formula (1') represents a divalent group formed by removing a hydrogen atom from the structure having a metal complex represented by the general formula (2'): 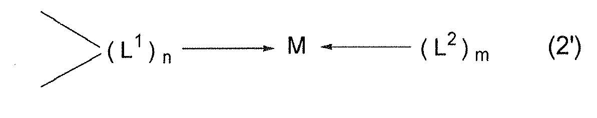 wherein M represents a metal atom selected from the group consisting of Pt, Os, Rh, Re, Pd, Ru, W, Au and Ag; L¹ represents a metal coordination part represented by the general formula (3'): 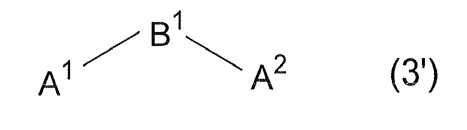 which bonds to Y¹ and Y² in the general formula (1');
A ¹ and A² in the general formula (3') each independently represents a substituted or unsubstituted aromatic group having 6 to 50 ring carbon atoms and a substituted or unsubstituted aromatic heterocyclic group having 5 to 50 ring atoms, further at least one of two is a phenyl group or a substituted phenyl group, B¹ in the general formula (3') represents a single bond, -CR'R"-, -SiR'R"-, -CO- or NR'- wherein R' and R" each independently represents a hydrogen atom, a substituted or unsubstituted aromatic group having 6 to 50 ring carbon atoms, a substituted or unsubstituted aromatic heterocyclic group having 5 to 50 ring atoms, or a substituted or unsubstituted alkyl group having 1 to 50 carbon atoms;
[L¹ →M] in the general formula (2') means that L¹ cordinates to a metal atom M and it is selected from the following: 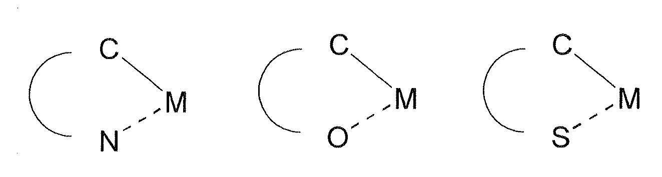 wherein a carbon atom of L¹ bonds to a metal atom and a atom selected from the group consisting of N, O and S cordinates to the metal atom M;
L² in the general formula (2') represents a ligand cordinating to a metal atom and may be the same with or different from L¹,
[M ←L²] means that L² cordinates to a metal atom **M** and is selected from a σ -bond of halogen atom or the following: 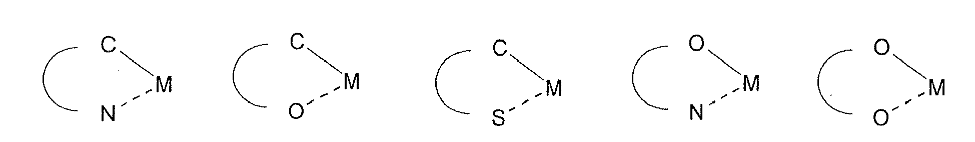 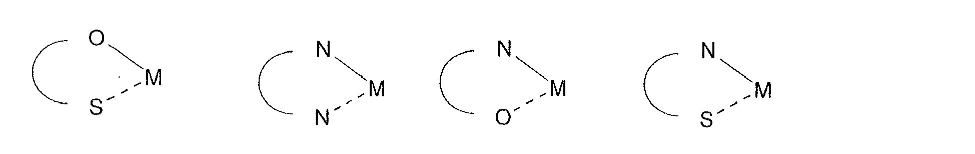 wherein an atom selected from a carbon atom of L², O and N bonds to a metal atom **M;** and an atom selected from the group consisting of N, O and S cordinates to a metal atom **M;**
n in the general formula (2') represents an integer of from 1 to **x** (**x:** valence of a metal atom) and **m** in the general formula (2') represents an integer of from 0 to **(x** minus **n).**

17. The material for an organic electroluminescence device according to Claim 16, wherein, L² in the general formula (2') represents at least one kind selected from the group consisting of a halogen atom, an acetylaceton derivative, an 8-quinolinol derivative and a phenylpyridine derivative: 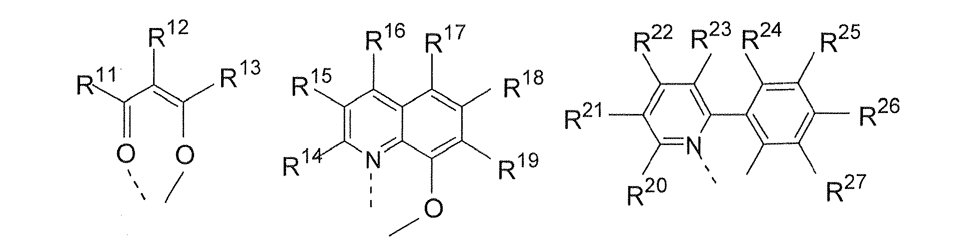 wherein R¹¹ to R²⁷ each independently represents a hydrogen atom, a cyano group, a nitro group, a halogen atom, a substituted or unsubstituted alkyl group, alkoxy group, alkylsilyl group or acryl group having 1 to 20 carbon atoms, a substituted or unsubstituted amino group and a substituted or unsubstituted aryl group having ring6 to 30 carbon atoms.

18. The material for an organic electroluminescence device according to Claim 16, wherein said M in the general formula (2') represents iridium (Ir) atom.

19. An organic electroluminescence device comprising at least one of organic thin film layers including a light emitting layer sandwiched between a pair of electrodes consisting of an anode and a cathode, wherein a least one of the organic thin film layers comprises a coordination metal compound according to any one of Claims 1 to 11.

20. The organic electroluminescence device according to Claim 19 wherein the light emitting layer comprises a coordination metal compound according to any one of Claims 1 to 11.

21. An organic electroluminescence device comprising at least one of organic thin film layers including a light emitting layer sandwiched between a pair of electrodes consisting of an anode and a cathode, wherein at least one of the organic thin film layers comprises the material of the coordination metal compound according to any one of Claims 12 to 18.

22. The organic electroluminescence device according to Claim 21 wherein the light emitting layer comprises the material for an organic electroluminescence device.

23. The material for luminescent coating formation which comprises an organic solvent solution containing a coordination metal compound according to any one of Claims 1 to 11.

24. A material for luminescent coating formation which comprises an organic solvent solution containing a coordination metal compound according to any one of Claims 12 to 18.

25. An organic electroluminescence device comprising at least one of organic thin film layers including a light emitting layer sandwiched between a pair of electrodes consisting of an anode and a cathode, wherein at least one of the organic thin film layers is formed by using the material for luminescent coating formation according to Claim 23.

26. An organic electroluminescence device comprising at least one of organic thin film layers including a light emitting layer sandwiched between a pair of electrodes consisting of an anode and a cathode, wherein a least one of the organic thin film layers is formed by using the material for luminescent coating formation according to Claim 24.
